# EUROPEAN PATENT APPLICATION

(11) **EP 4 395 360 A1**
(43) Date of publication of application: **03.07.2024**
(21) Application number: 22861201.6
(22) Date of filing: 17.08.2022
(51) Int. Cl.: H04N 25/70, H04N 25/13, H01L 27/146

(54) **IMAGING DEVICE AND ELECTRONIC APPARATUS**

(30) Priority: 23.08.2021 JP 2021135544; 29.03.2022 JP 2022053019
(71) Applicant: Sony Semiconductor Solutions Corporation, Atsugi-shi, Kanagawa 243-0014 (JP)
(72) Inventor: SAITO, Hiroshi, Atsugi-shi, Kanagawa 243-0014 (JP); IKEHARA, Shigehiro, Atsugi-shi, Kanagawa 243-0014 (JP); ISHII, Yoshiyuki, Atsugi-shi, Kanagawa 243-0014 (JP); KITAMURA, Isaya, Atsugi-shi, Kanagawa 243-0014 (JP); WADA, Koji, Atsugi-shi, Kanagawa 243-0014 (JP); KOBAYASHI, Yuuki, Atsugi-shi, Kanagawa 243-0014 (JP); FUKASAWA, Masanaga, Atsugi-shi, Kanagawa 243-0014 (JP); KAWASHIMA, Atsushi, Atsugi-shi, Kanagawa 243-0014 (JP); FUKUSHIMA, Kohei, Atsugi-shi, Kanagawa 243-0014 (JP); NEGORO, Yoichi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/031037
(87) International publication number: WO 2023/026913

(57) **Abstract**

[Object]

More improvement of sensitivity is achieved by reducing crosstalk between pixels without deteriorating a light collection property.

[Solving Means]

Provided is an imaging device including multiple pixels each including a photoelectric conversion unit and planarly arranged in a matrix shape, a color filter provided on the photoelectric conversion unit for each of the pixels, and a wall-shaped structure portion that is formed between the adjoining color filters with an external shape of the wall-shaped structure portion defined by a first wall portion and is configured to separate the color filters from each other. [Selected Drawing] FIG. 2

## Description

### [Technical Field]

The present disclosure relates to an imaging device and an electronic apparatus.

### [Background Art]

A CCD (Charge Coupled Device) image sensor or a CMOS (Complementary Metal Oxide Semiconductor) image sensor is known as an imaging device included in a digital camera or a video camera.

For these types of image sensors, it has been studied to form a void between respective color filters provided for pixels with one-to-one correspondence so as to reduce crosstalk between the pixels. For example, PTL 1 identified below discloses an image sensor which has a void formed by closing, with a low coverage film, openings above a trench provided between respective color filters.

### [Citation List]

### [Patent Literature]

[PTL 1]
U.S. Patent Application Publication No. 2019/0157329

### [Summary]

### [Technical Problem]

However, in a case where the void has a larger width to achieve more reduction of crosstalk between pixels in the image sensor disclosed in PTL 1 disclosed above, the trench has a larger width and thus needs to be closed by a film having a larger thickness. In such a case, each distance between on-chip lenses and photoelectric conversion elements increases, and therefore a light collection property of the image sensor deteriorates.

Accordingly, the present disclosure proposes an imaging device and an electronic apparatus each of which is novel and improved, and capable of achieving more improvement of sensitivity by reducing crosstalk between pixels without deteriorating a light collection property.

### [Solution to Problem]

Provided according to the present disclosure is an imaging device including multiple pixels each including a photoelectric conversion unit, and planarly arranged in a matrix shape, a color filter provided on the photoelectric conversion unit for each of the pixels, and a wall-shaped structure portion that is formed between the adjoining color filters with an external shape of the wall-shaped structure portion defined by a first wall portion, and is configured to separate the color filters from each other.

In addition, provided according to the present disclosure is an electronic apparatus including an imaging device. The imaging device includes multiple pixels each including a photoelectric conversion unit, and planarly arranged in a matrix shape, a color filter provided on the photoelectric conversion unit for each of the pixels, and a wall-shaped structure portion that is formed between the adjoining color filters with an external shape of the wall-shaped structure portion defined by a first wall portion, and is configured to separate the color filters from each other.

### [Brief Description of Drawings]

[FIG. 1]

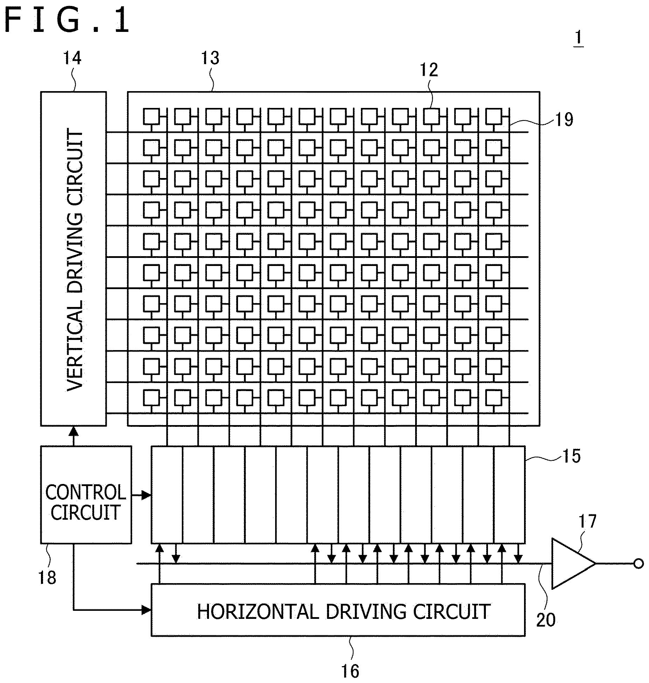

   FIG. 1 is a schematic diagram depicting a general configuration of an imaging device according to a first embodiment of the present disclosure.
[FIG. 2]

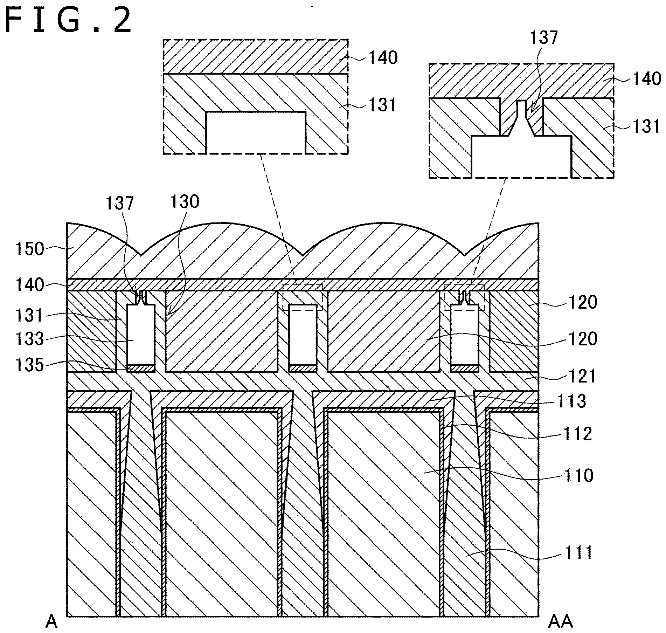

   FIG. 2 is a vertical cross-sectional diagram depicting one example of a cross-sectional configuration of a pixel unit.
[FIG. 3]

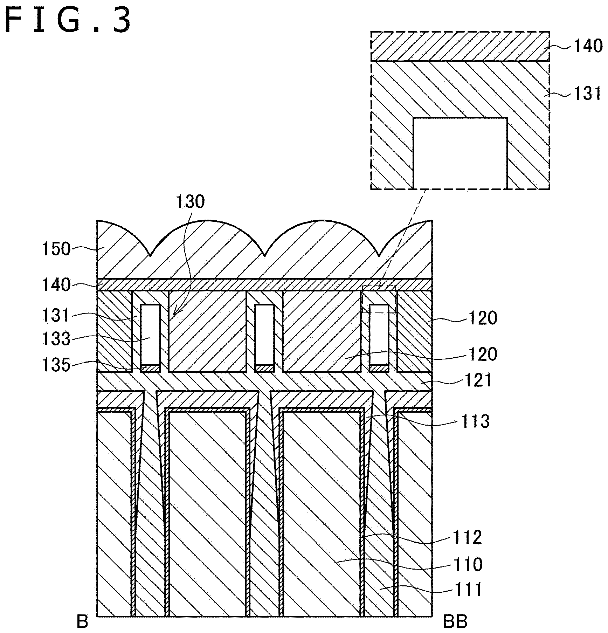

   FIG. 3 is a vertical cross-sectional diagram depicting one example of the cross-sectional configuration of the pixel unit.
[FIG. 4]

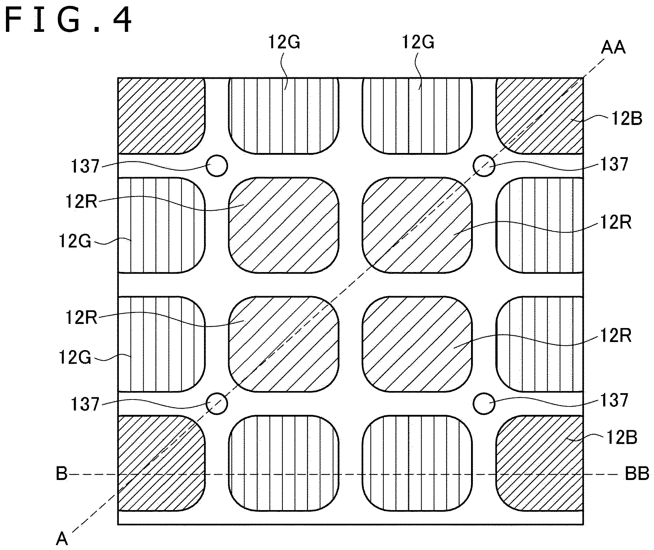

   FIG. 4 is a plan diagram depicting a planar configuration of the pixel unit.
[FIG. 5]

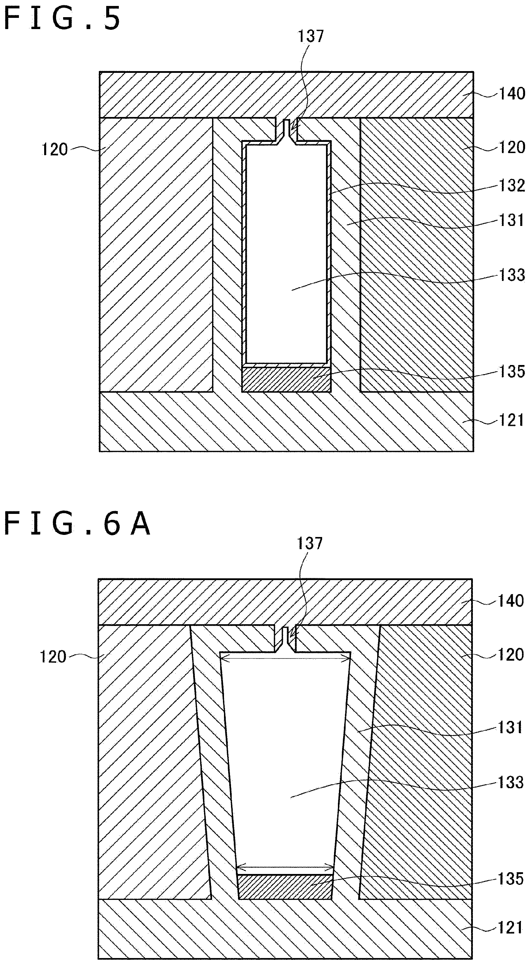

   FIG. 5 is a vertical cross-sectional diagram depicting a first modification of a wall-shaped structure portion.
[FIG. 6A]
   FIG. 6A is a vertical cross-sectional diagram depicting a second modification of the wall-shaped structure portion.
[FIG. 6B]

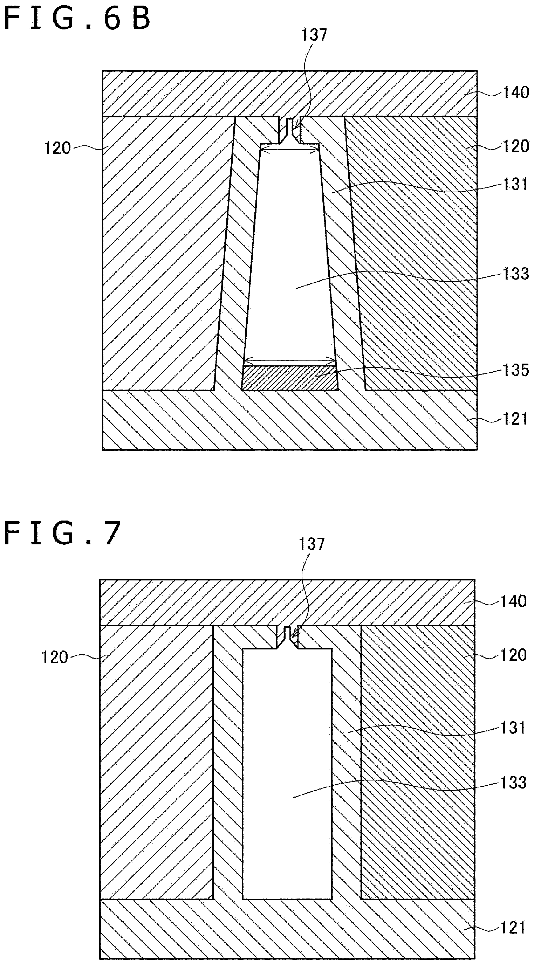

   FIG. 6B is a vertical cross-sectional diagram depicting the second modification of the wall-shaped structure portion.
[FIG. 7]
   FIG. 7 is a vertical cross-sectional diagram depicting a third modification of the wall-shaped structure portion.
[FIG. 8]

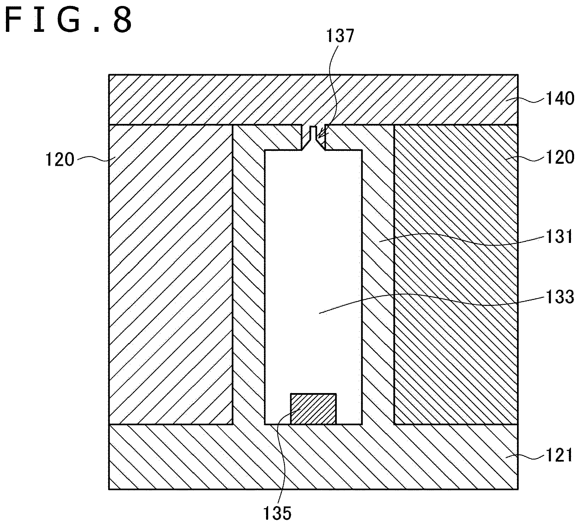

   FIG. 8 is a vertical cross-sectional diagram depicting a fourth modification of the wall-shaped structure portion.
[FIG. 9]

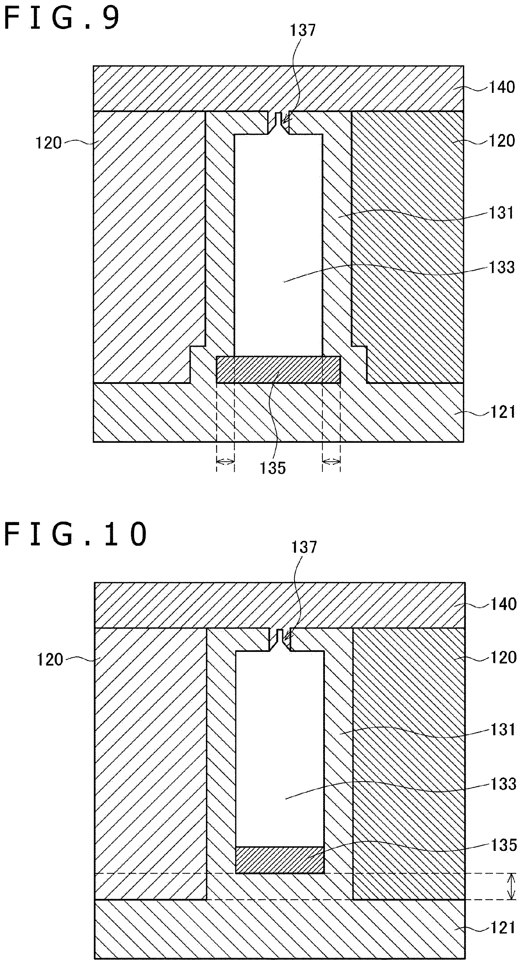

   FIG. 9 is a vertical cross-sectional diagram depicting the fourth modification of the wall-shaped structure portion.
[FIG. 10]
   FIG. 10 is a vertical cross-sectional diagram depicting a fifth modification of the wall-shaped structure portion.
[FIG. 11]

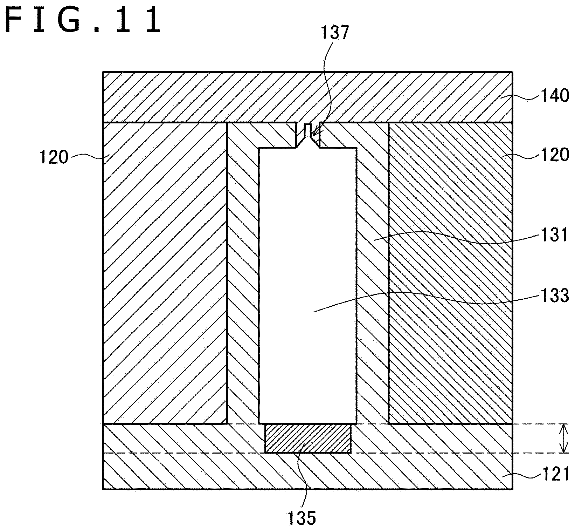

   FIG. 11 is a vertical cross-sectional diagram depicting the fifth modification of the wall-shaped structure portion.
[FIG. 12]

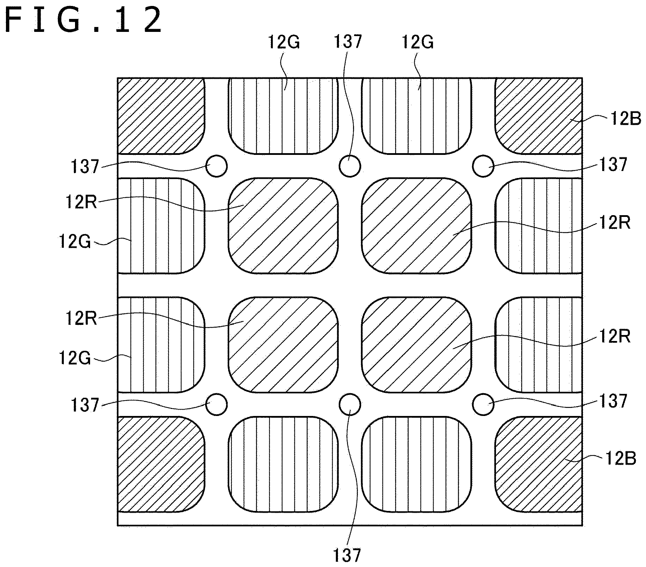

   FIG. 12 is a plan diagram depicting a first modification of arrangement of openings.
[FIG. 13]

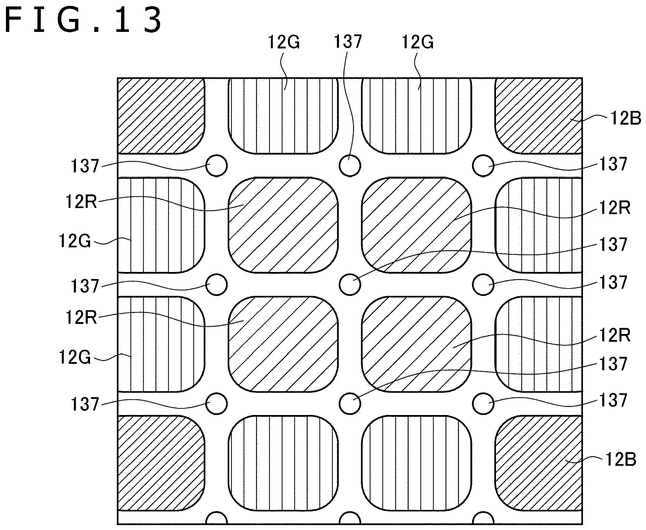

   FIG. 13 is a plan diagram depicting a second modification of the arrangement of the openings.
[FIG. 14]

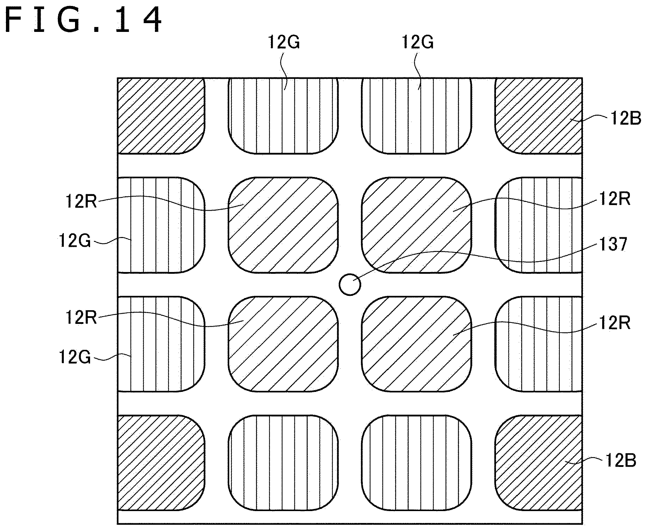

   FIG. 14 is a plan diagram depicting a third modification of the arrangement of the openings.
[FIG. 15]

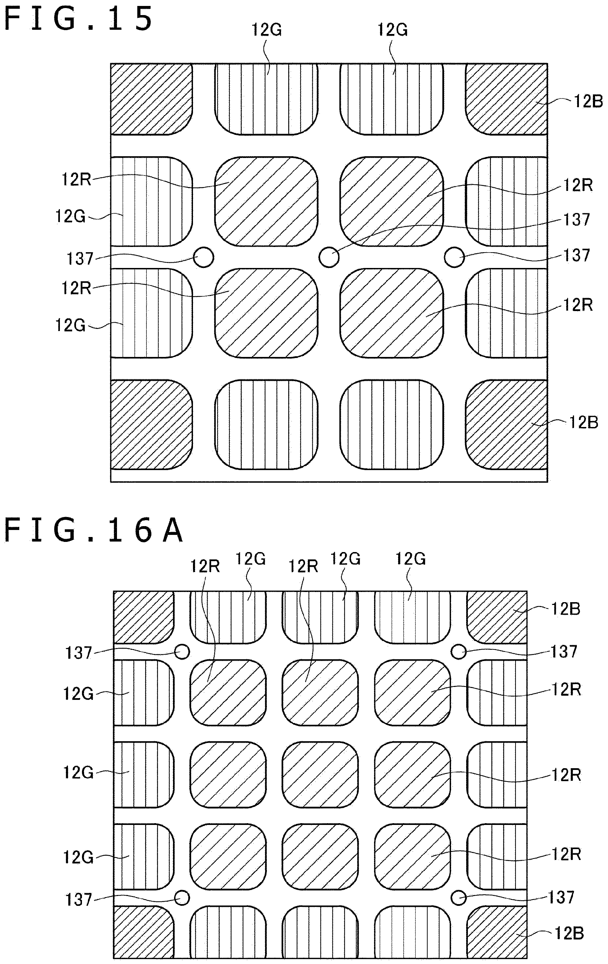

   FIG. 15 is a plan diagram depicting a fourth modification of the arrangement of the openings.
[FIG. 16A]
   FIG. 16A is a plan diagram depicting a first modification of the pixel unit.
[FIG. 16B]

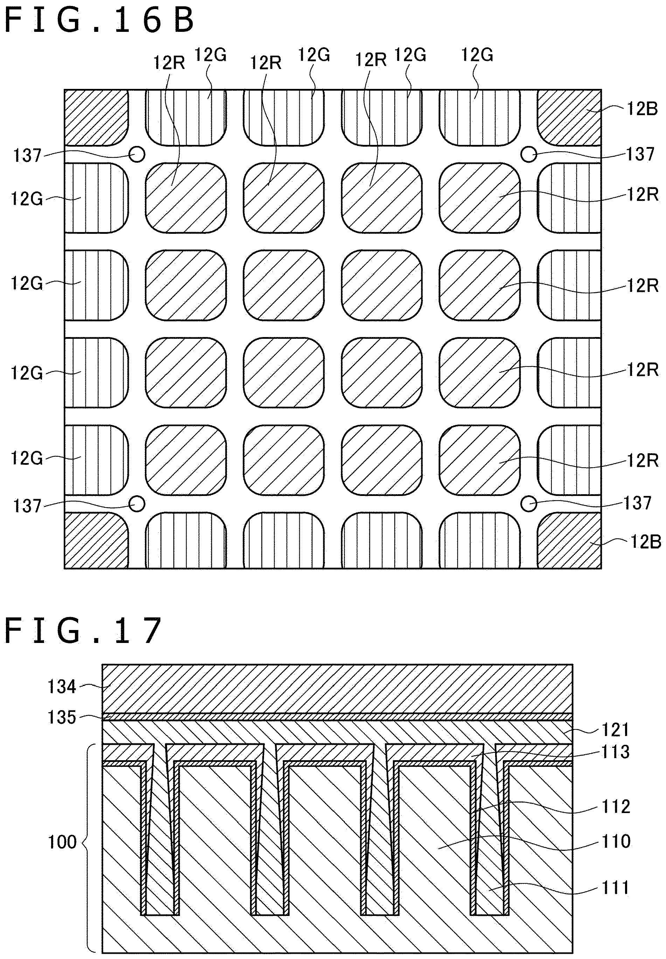

   FIG. 16B is a plan diagram depicting a second modification of the pixel unit.
[FIG. 17]
   FIG. 17 is a vertical cross-sectional diagram explaining one step of a manufacturing method of the pixel unit.
[FIG. 18]

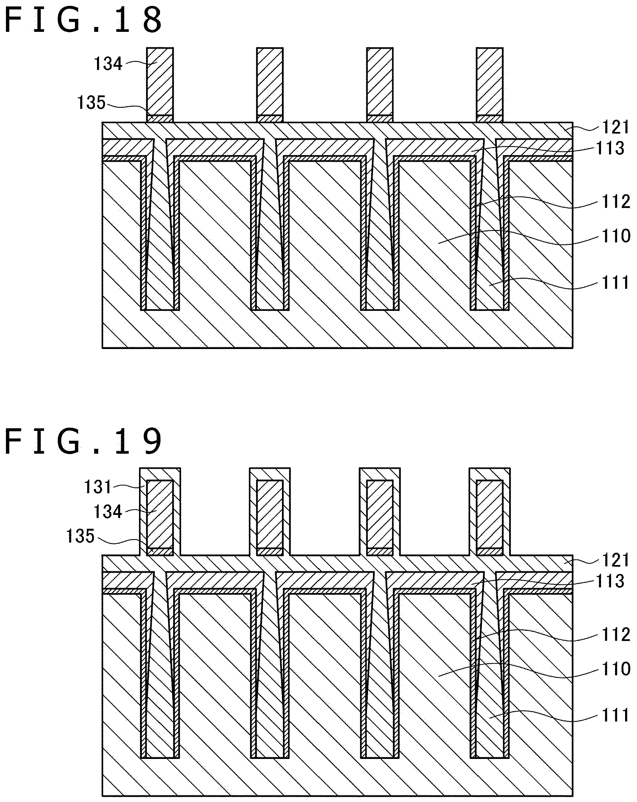

   FIG. 18 is a vertical cross-sectional diagram explaining one step of the manufacturing method of the pixel unit.
[FIG. 19]
   FIG. 19 is a vertical cross-sectional diagram explaining one step of the manufacturing method of the pixel unit.
[FIG. 20]

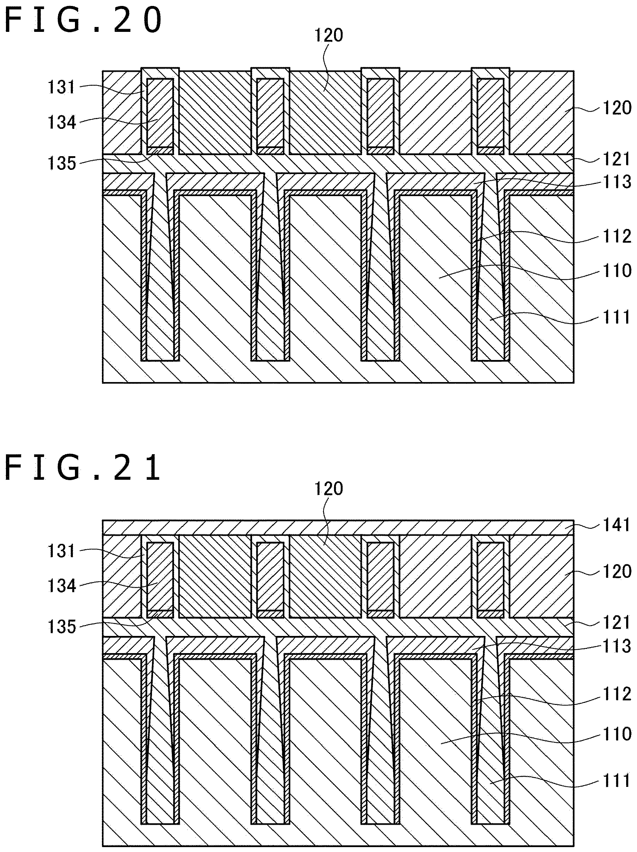

   FIG. 20 is a vertical cross-sectional diagram explaining one step of the manufacturing method of the pixel unit.
[FIG. 21]
   FIG. 21 is a vertical cross-sectional diagram explaining one step of the manufacturing method of the pixel unit.
[FIG. 22]

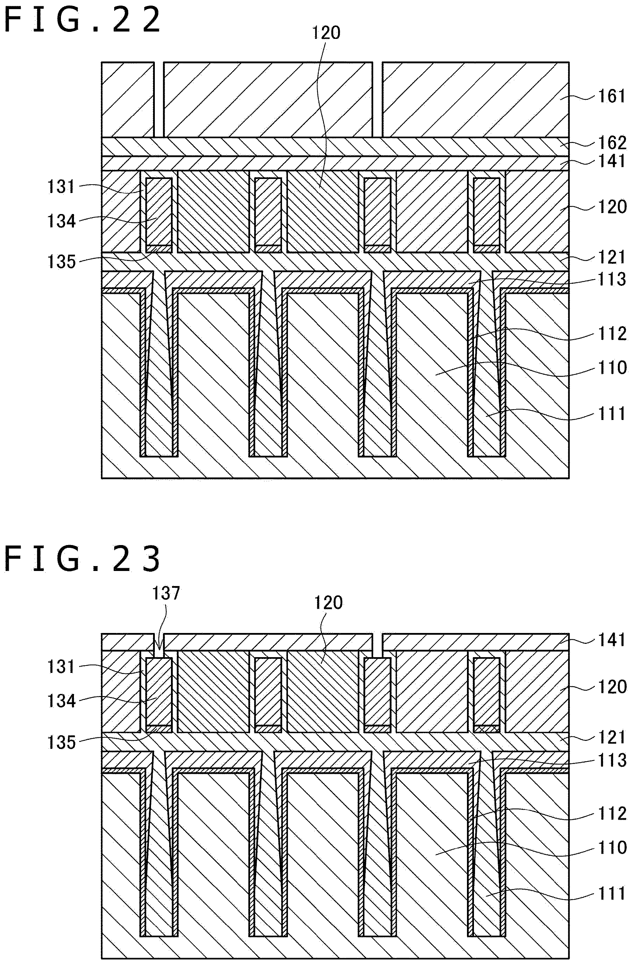

   FIG. 22 is a vertical cross-sectional diagram explaining one step of the manufacturing method of the pixel unit.
[FIG. 23]
   FIG. 23 is a vertical cross-sectional diagram explaining one step of the manufacturing method of the pixel unit.
[FIG. 24]

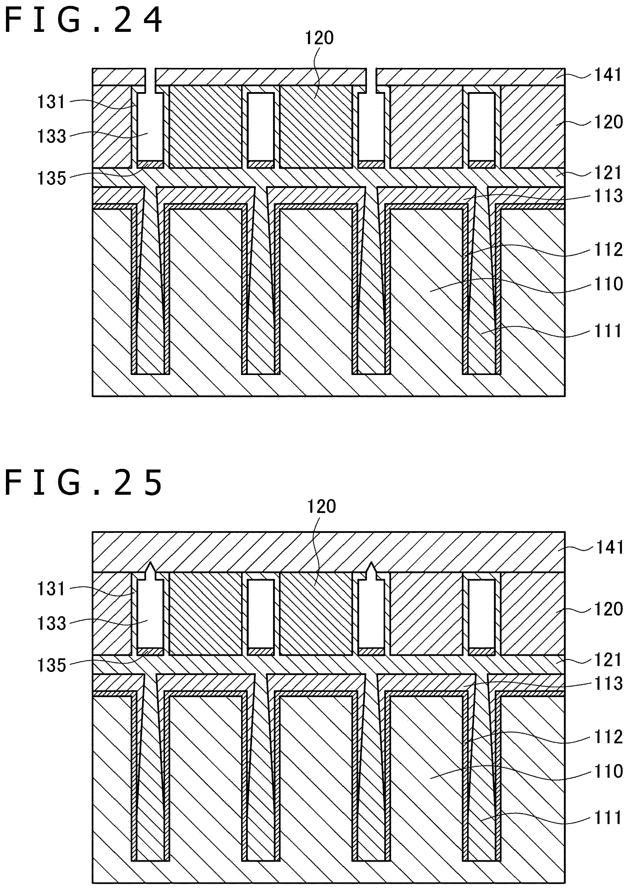

   FIG. 24 is a vertical cross-sectional diagram explaining one step of the manufacturing method of the pixel unit.
[FIG. 25]
   FIG. 25 is a vertical cross-sectional diagram explaining one step of the manufacturing method of the pixel unit.
[FIG. 26]

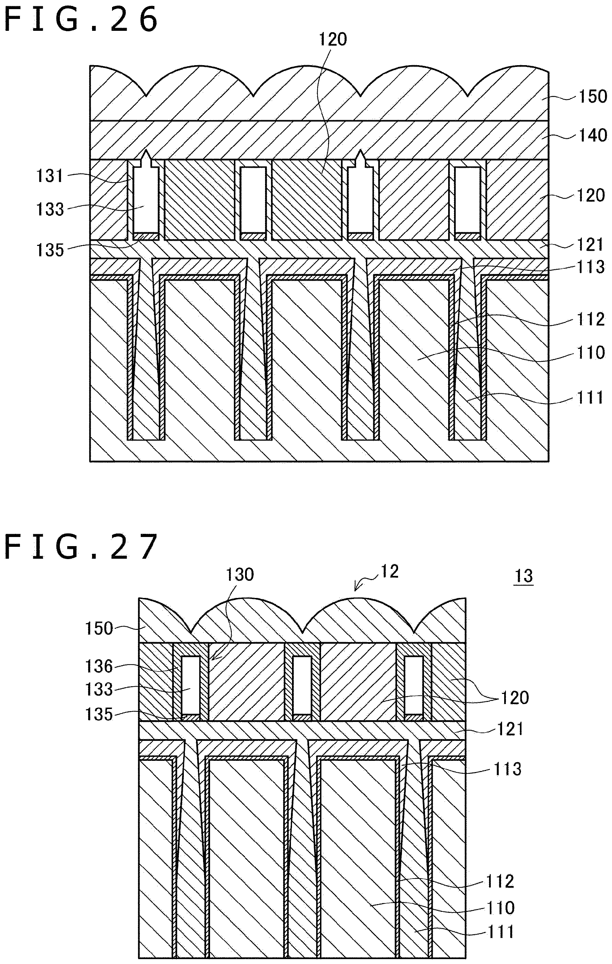

   FIG. 26 is a vertical cross-sectional diagram explaining one step of the manufacturing method of the pixel unit.
[FIG. 27]
   FIG. 27 is a vertical cross-sectional diagram depicting one example of a cross-sectional configuration of the pixel unit according to a second embodiment.
[FIG. 28A]

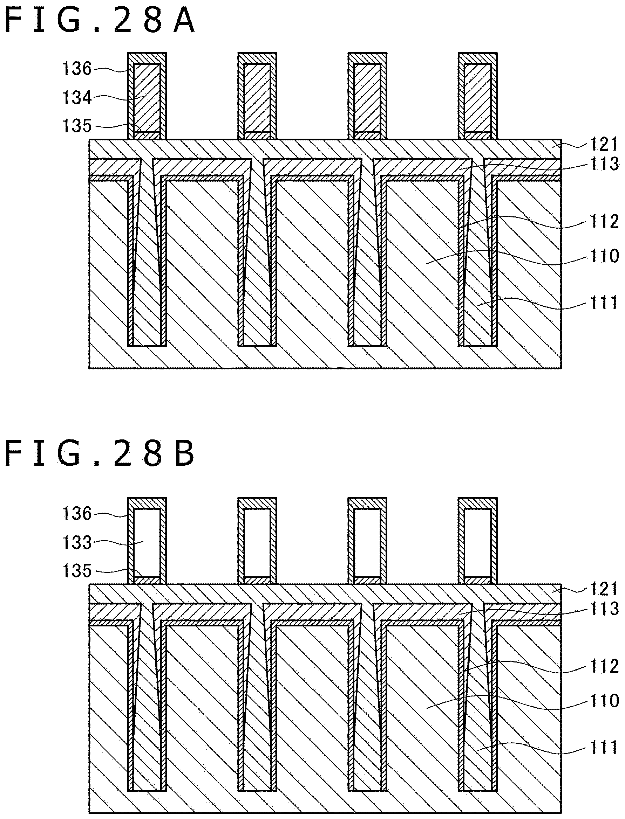

   FIG. 28A is a vertical cross-sectional diagram explaining one step of a manufacturing method of a pixel unit according to the second embodiment.
[FIG. 28B]
   FIG. 28B is a vertical cross-sectional diagram explaining one step of the manufacturing method of the pixel unit according to the second embodiment.
[FIG. 28C]

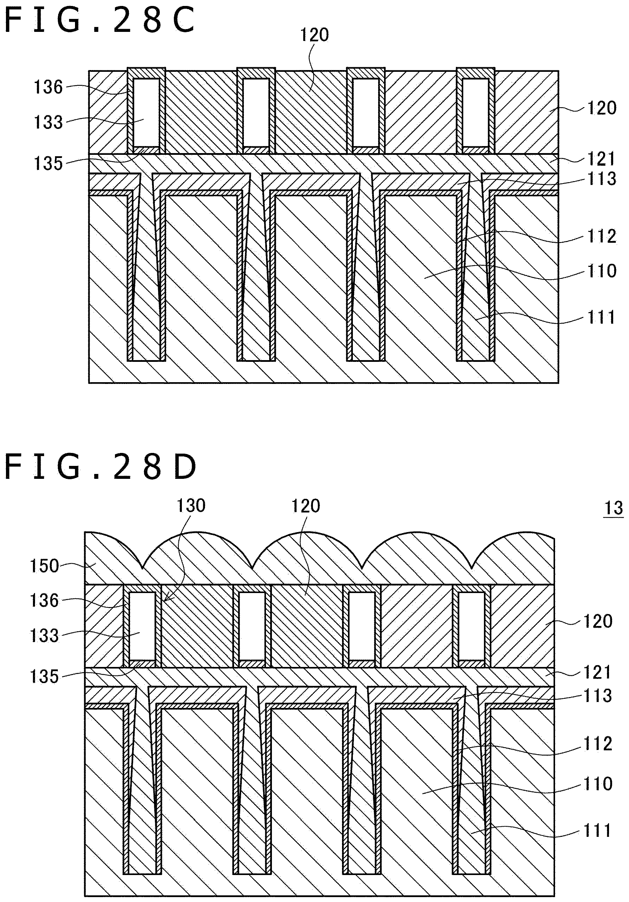

   FIG. 28C is a vertical cross-sectional diagram explaining one step of the manufacturing method of the pixel unit according to the second embodiment of the present disclosure.
[FIG. 28D]
   FIG. 28D is a vertical cross-sectional diagram explaining one step of the manufacturing method of the pixel unit according to the second embodiment.
[FIG. 29A]

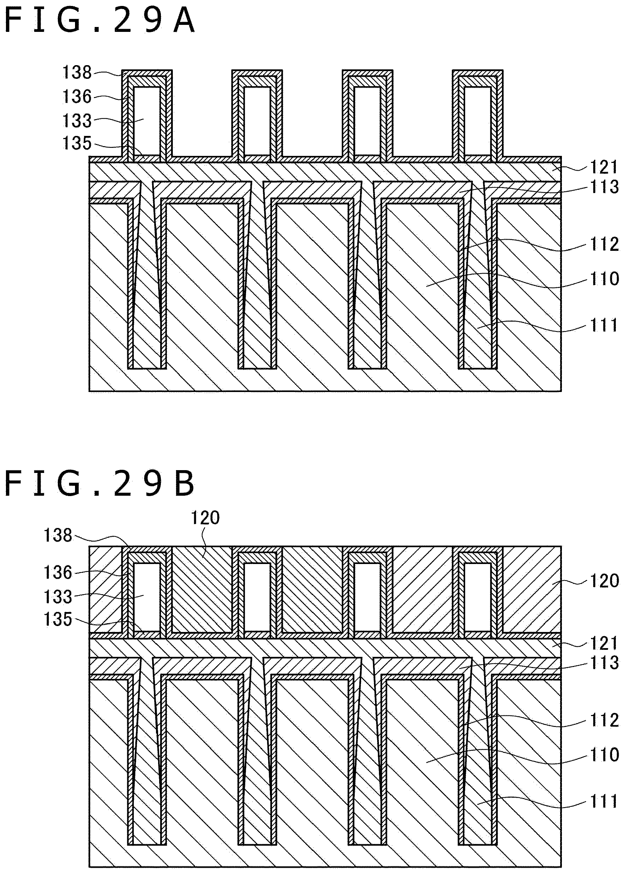

   FIG. 29A is a vertical cross-sectional diagram explaining one step of a manufacturing method of a pixel unit according to a first modification of the second embodiment.
[FIG. 29B]
   FIG. 29B is a vertical cross-sectional diagram explaining one step of the manufacturing method of the pixel unit according to the first modification of the second embodiment.
[FIG. 29C]

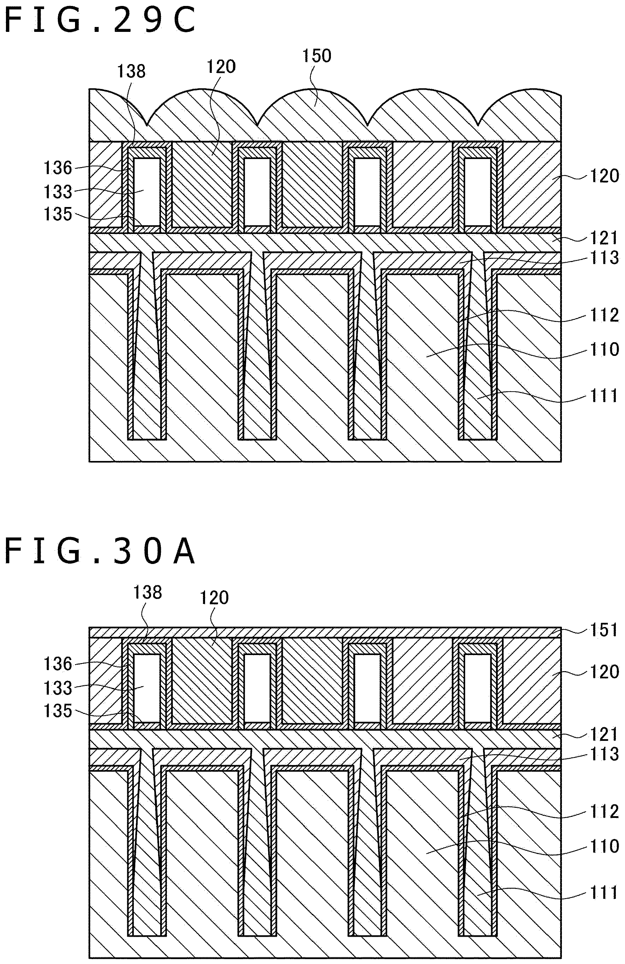

   FIG. 29C is a vertical cross-sectional diagram explaining one step of the manufacturing method of the pixel unit according to the first modification of the second embodiment.
[FIG. 30A]
   FIG. 30A is a vertical cross-sectional diagram explaining one step of a manufacturing method of a pixel unit according to a second modification of the second embodiment.
[FIG. 30B]

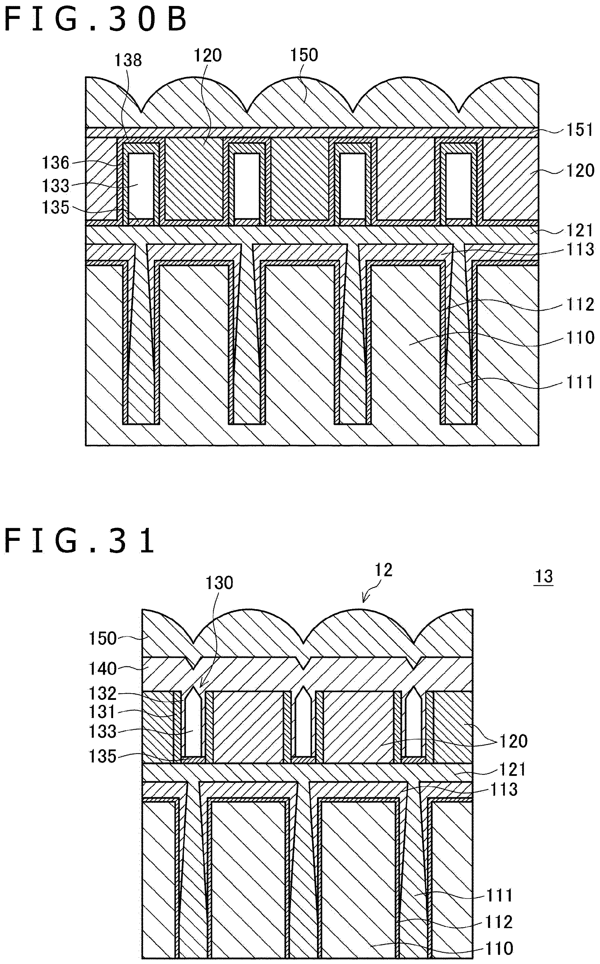

   FIG. 30B is a vertical cross-sectional diagram explaining one step of the manufacturing method of the pixel unit according to the second modification of the second embodiment.
[FIG. 31]
   FIG. 31 is a vertical cross-sectional diagram depicting one example of a cross-sectional configuration of a pixel unit according to a third embodiment.
[FIG. 32]

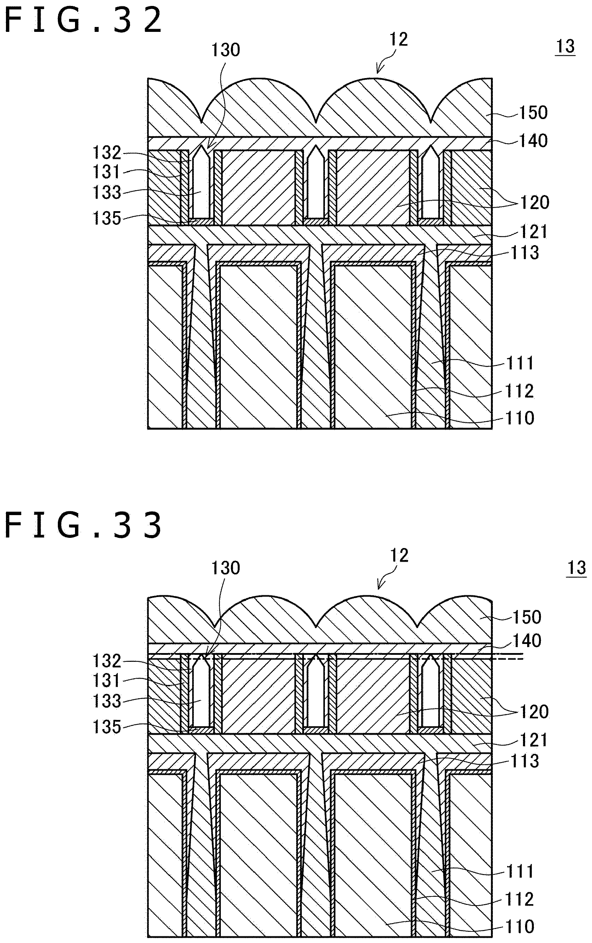

   FIG. 32 is a vertical cross-sectional diagram explaining a modification of the pixel unit according to the third embodiment.
[FIG. 33]
   FIG. 33 is a vertical cross-sectional diagram explaining a modification of the pixel unit according to the third embodiment.
[FIG. 34]

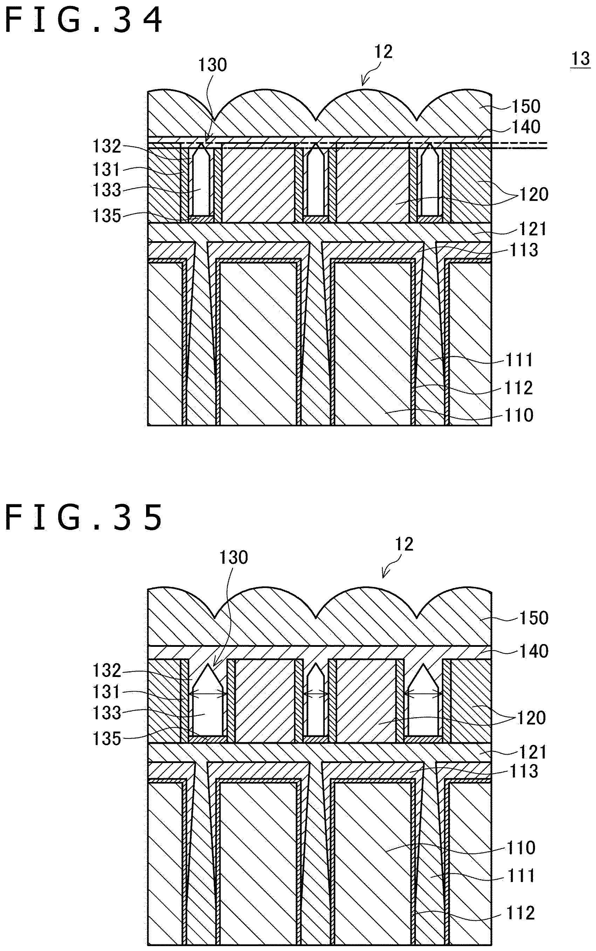

   FIG. 34 is a vertical cross-sectional diagram explaining a modification of the pixel unit according to the third embodiment.
[FIG. 35]
   FIG. 35 is a vertical cross-sectional diagram explaining a modification of the pixel unit according to the third embodiment.
[FIG. 36A]

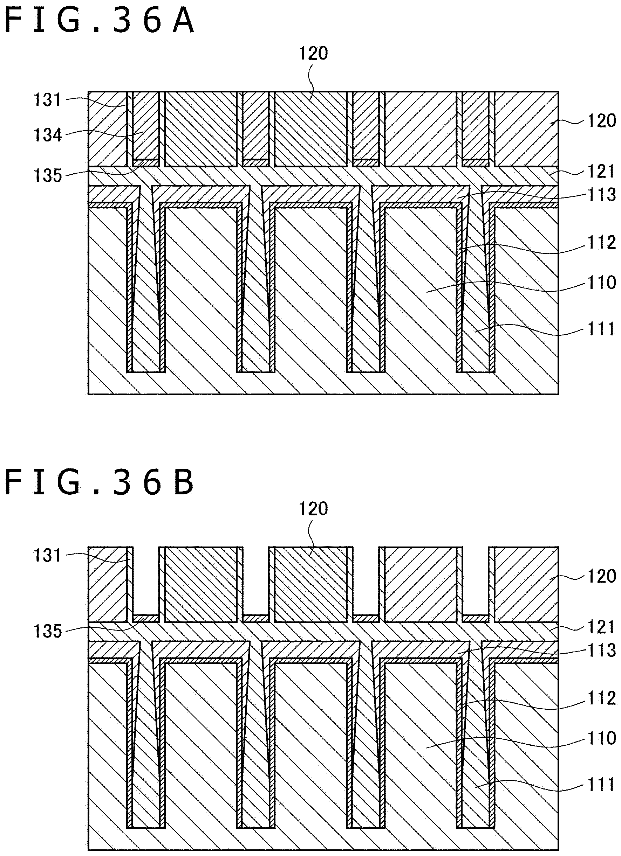

   FIG. 36A is a vertical cross-sectional diagram explaining one step of a manufacturing method of the pixel unit according to the third embodiment.
[FIG. 36B]
   FIG. 36B is a vertical cross-sectional diagram explaining one step of the manufacturing method of the pixel unit according to the third embodiment.
[FIG. 36C]

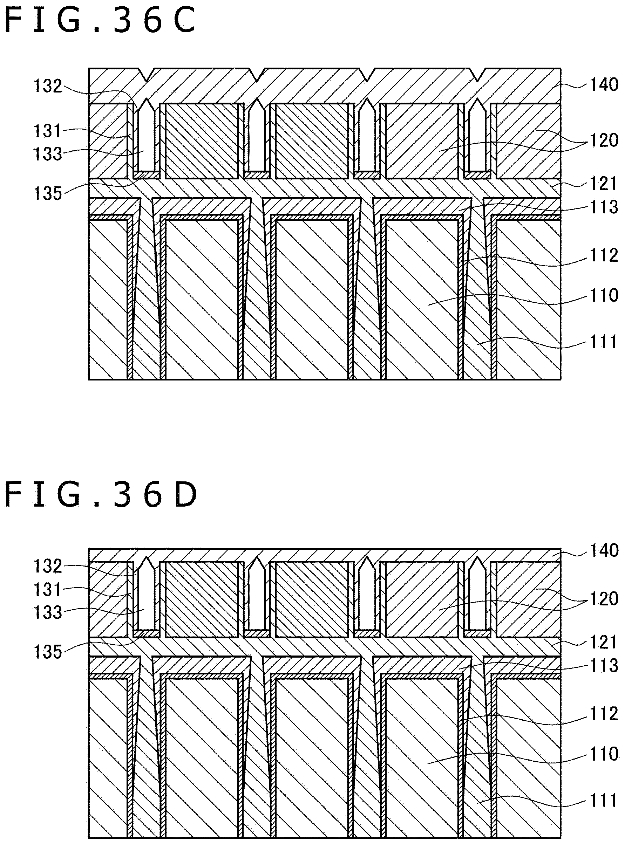

   FIG. 36C is a vertical cross-sectional diagram explaining one step of the manufacturing method of the pixel unit according to the third embodiment.
[FIG. 36D]
   FIG. 36D is a vertical cross-sectional diagram explaining one step of the manufacturing method of the pixel unit according to the third embodiment.
[FIG. 36E]

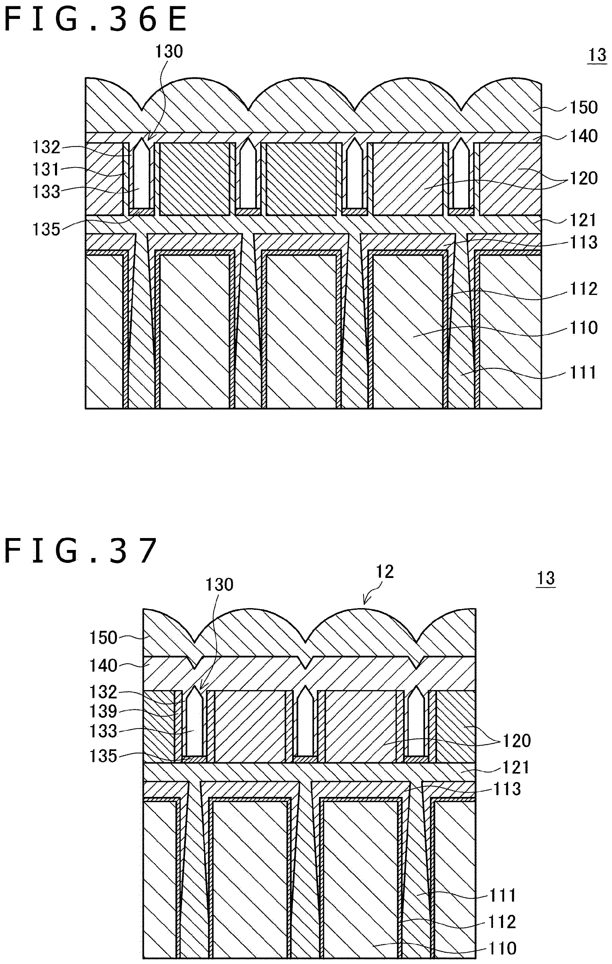

   FIG. 36E is a vertical cross-sectional diagram explaining one step of the manufacturing method of the pixel unit according to the third embodiment.
[FIG. 37]
   FIG. 37 is a vertical cross-sectional diagram depicting one example of a cross-sectional configuration of a pixel unit according to a fourth embodiment.
[FIG. 38]

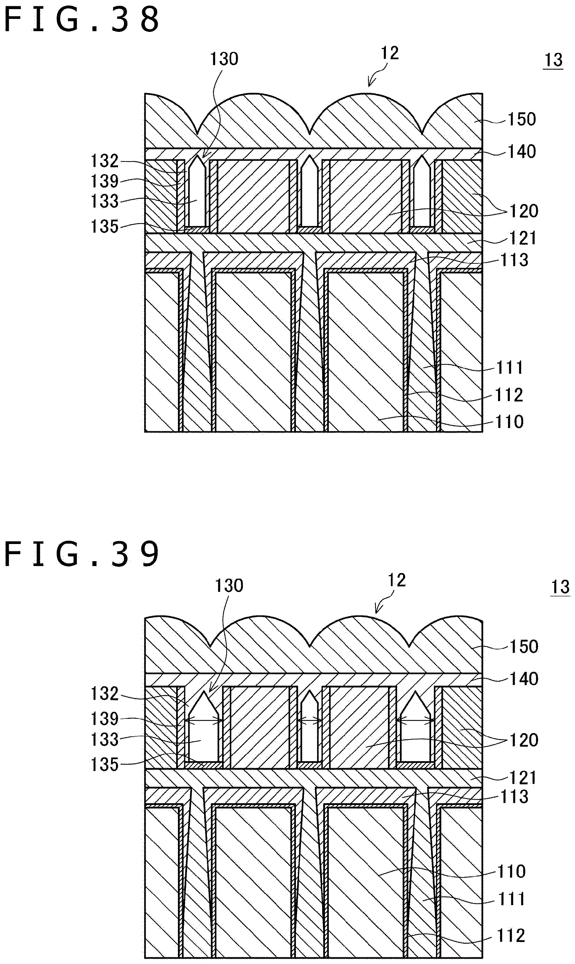

   FIG. 38 is a vertical cross-sectional diagram explaining a modification of the pixel unit according to the fourth embodiment.
[FIG. 39]
   FIG. 39 is a vertical cross-sectional diagram explaining a modification of the pixel unit according to the fourth embodiment.
[FIG. 40]

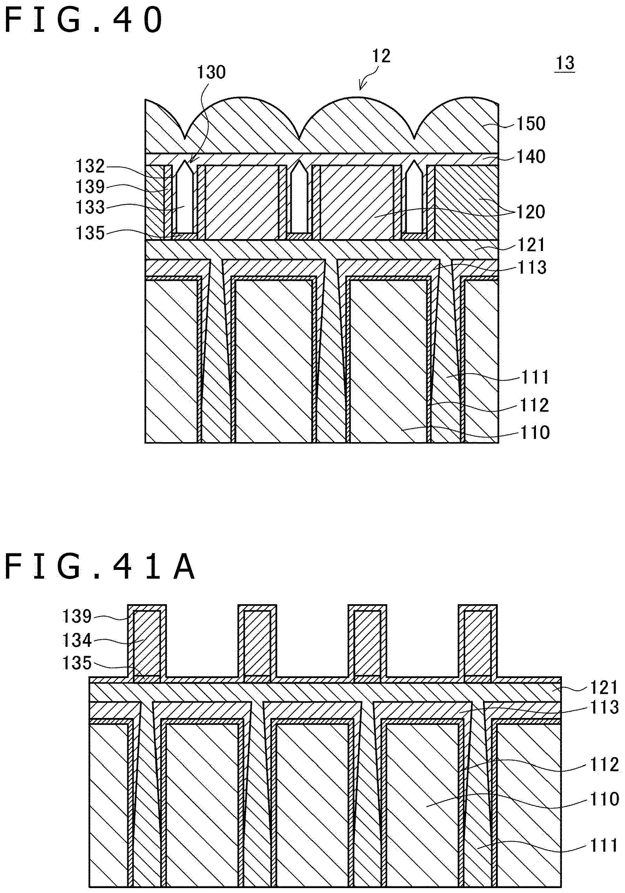

   FIG. 40 is a vertical cross-sectional diagram explaining a modification of the pixel unit according to the fourth embodiment.
[FIG. 41A]
   FIG. 41A is a vertical cross-sectional diagram explaining one step of a manufacturing method of the pixel unit according to the fourth embodiment.
[FIG. 41B]

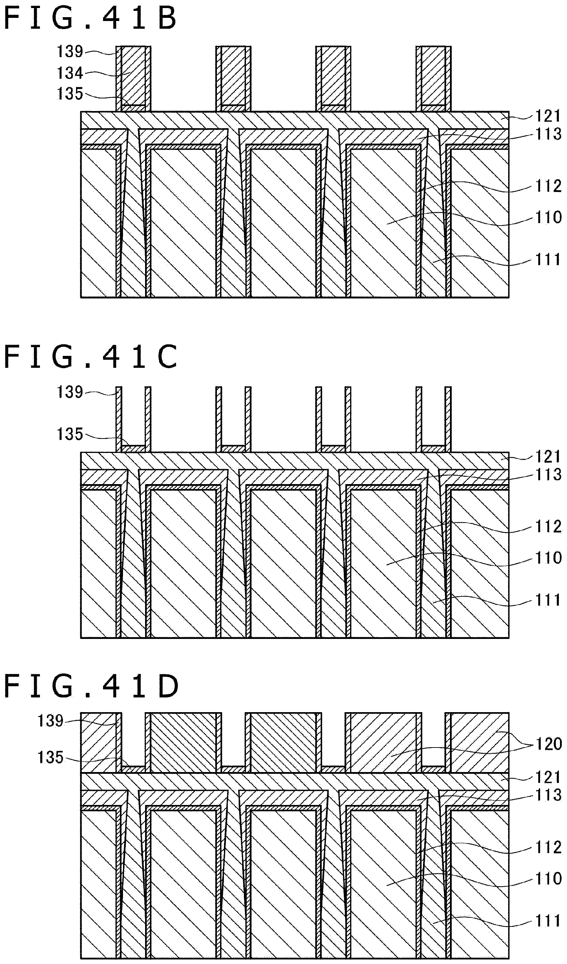

   FIG. 41B is a vertical cross-sectional diagram explaining one step of the manufacturing method of the pixel unit according to the fourth embodiment.
[FIG. 41C]
   FIG. 41C is a vertical cross-sectional diagram explaining one step of the manufacturing method of the pixel unit according to the fourth embodiment.
[FIG. 41D]
   FIG. 41D is a vertical cross-sectional diagram explaining one step of the manufacturing method of the pixel unit according to the fourth embodiment.
[FIG. 41E]

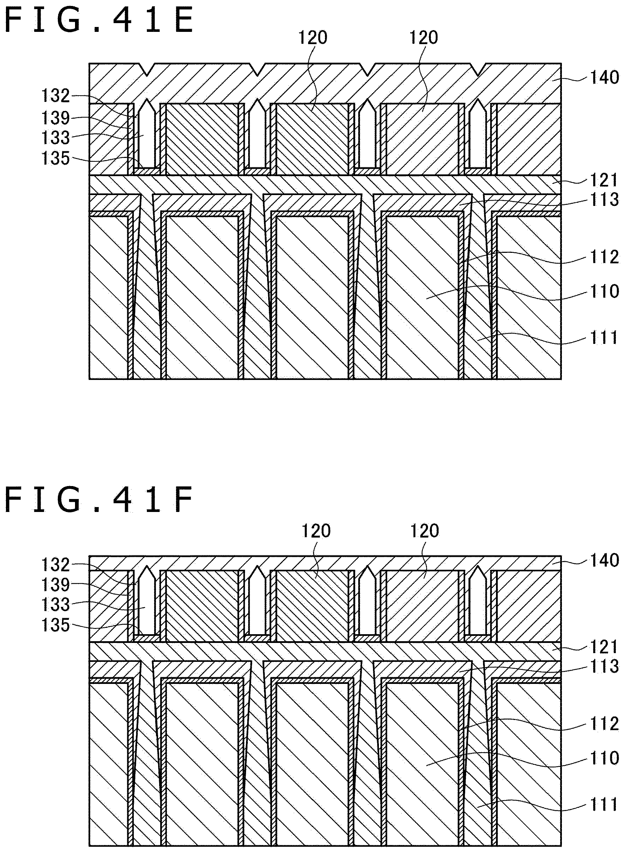

   FIG. 41E is a vertical cross-sectional diagram explaining one step of the manufacturing method of the pixel unit according to the fourth embodiment.
[FIG. 41F]
   FIG. 41F is a vertical cross-sectional diagram explaining one step of the manufacturing method of the pixel unit according to the fourth embodiment.
[FIG. 41G]

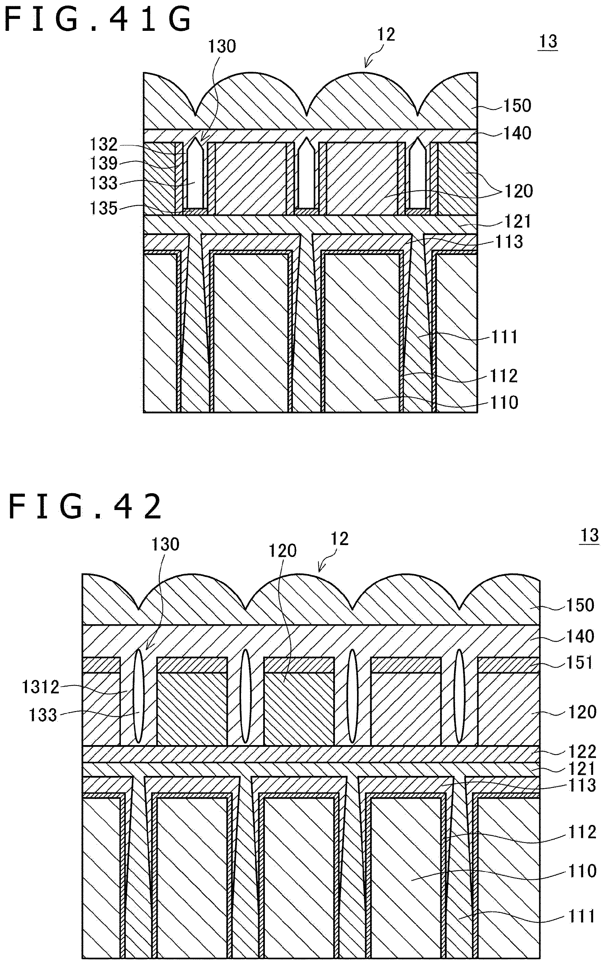

   FIG. 41G is a vertical cross-sectional diagram explaining one step of the manufacturing method of the pixel unit according to the fourth embodiment.
[FIG. 42]
   FIG. 42 is a vertical cross-sectional diagram depicting one example of a cross-sectional configuration of a pixel unit according to a fifth embodiment.
[FIG. 43]

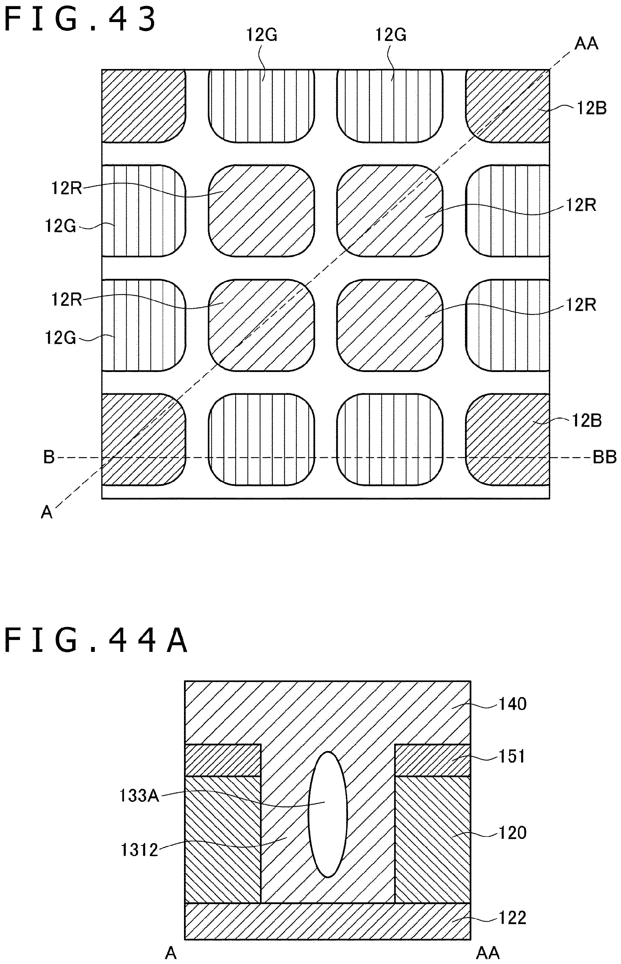

   FIG. 43 is a plan diagram depicting a planar configuration of the pixel unit according to the fifth embodiment.
[FIG. 44A]
   FIG. 44A is a vertical cross-sectional diagram depicting a cross-sectional configuration taken along a cutting plane A-AA in FIG. 43.
[FIG. 44B]

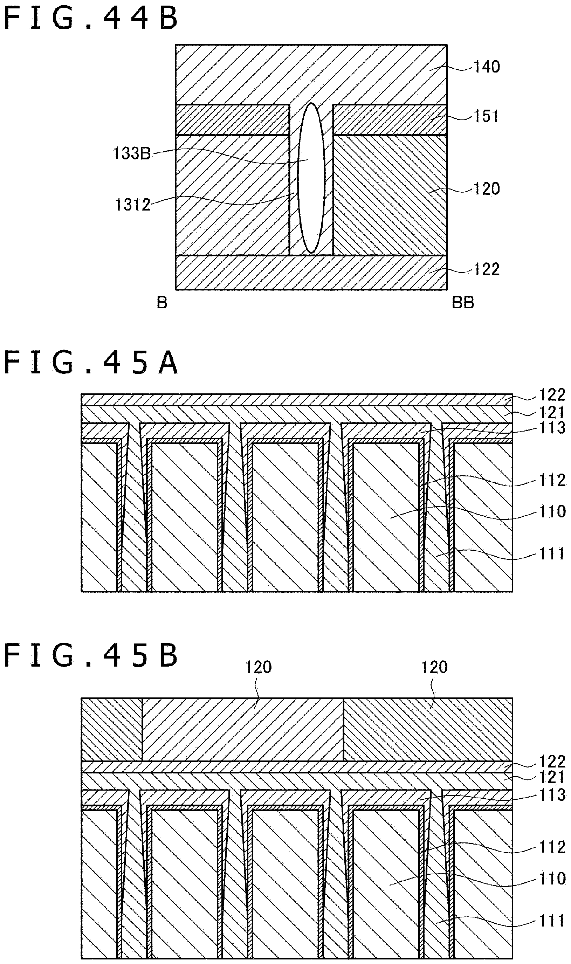

   FIG. 44B is a vertical cross-sectional diagram depicting a cross-sectional configuration taken along a cutting plane B-BB in FIG. 43.
[FIG. 45A]
   FIG. 45A is a vertical cross-sectional diagram explaining one step of a manufacturing method of the pixel unit according to the fifth embodiment.
[FIG. 45B]
   FIG. 45B is a vertical cross-sectional diagram explaining one step of the manufacturing method of the pixel unit according to the fifth embodiment.
[FIG. 45C]

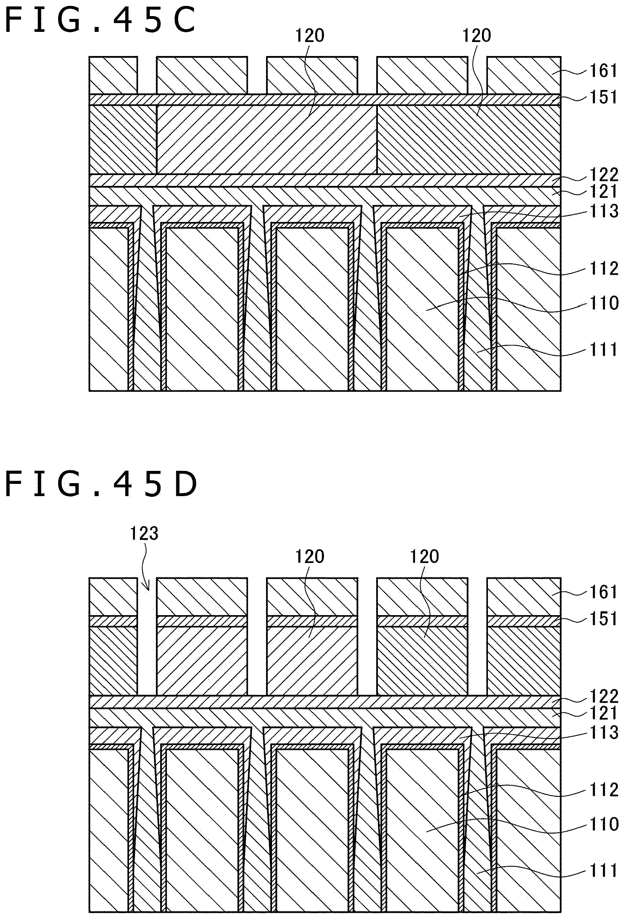

   FIG. 45C is a vertical cross-sectional diagram explaining one step of the manufacturing method of the pixel unit according to the fifth embodiment.
[FIG. 45D]
   FIG. 45D is a vertical cross-sectional diagram explaining one step of the manufacturing method of the pixel unit according to the fifth embodiment.
[FIG. 45E]

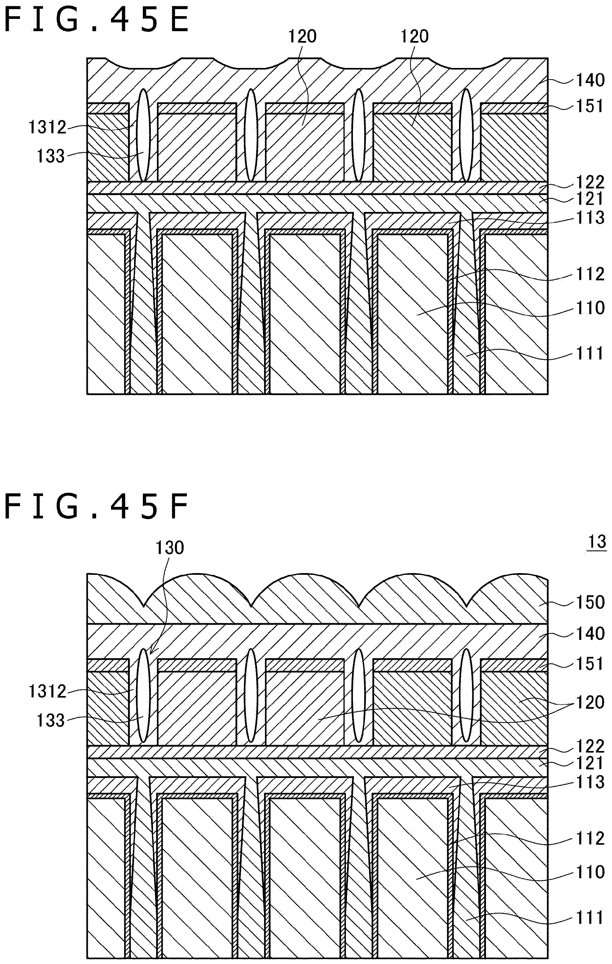

   FIG. 45E is a vertical cross-sectional diagram explaining one step of the manufacturing method of the pixel unit according to the fifth embodiment.
[FIG. 45F]
   FIG. 45F is a vertical cross-sectional diagram explaining one step of the manufacturing method of the pixel unit according to the fifth embodiment.
[FIG. 46]

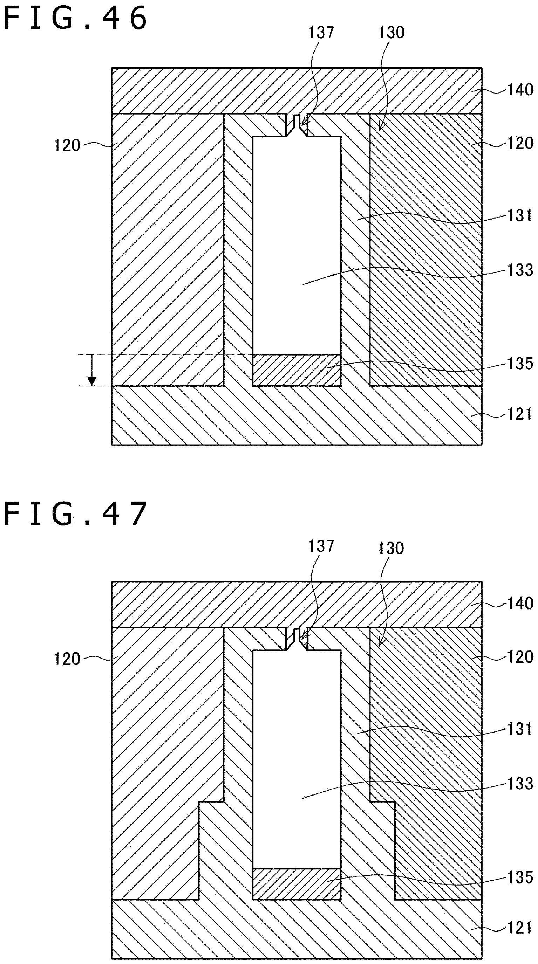

   FIG. 46 is a vertical cross-sectional diagram depicting a cross-sectional configuration of the wall-shaped structure portion included in a pixel unit according to a sixth embodiment.
[FIG. 47]
   FIG. 47 is a vertical cross-sectional diagram depicting a first modification of the wall-shaped structure portion.
[FIG. 48]

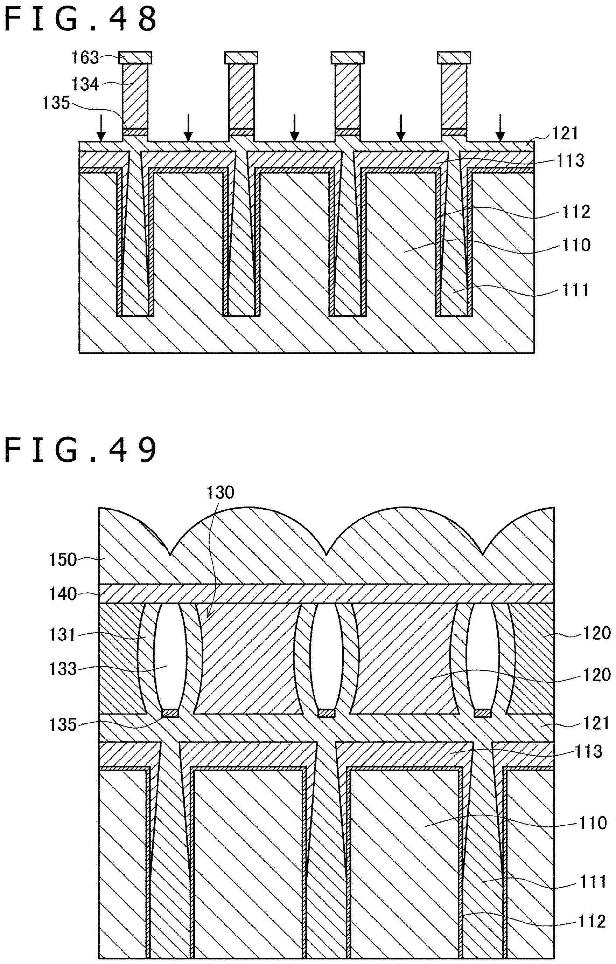

   FIG. 48 is a vertical cross-sectional diagram explaining one step of a manufacturing method of the pixel unit according to the sixth embodiment.
[FIG. 49]
   FIG. 49 is a vertical cross-sectional diagram depicting one example of a cross-sectional configuration of the pixel unit according to the sixth embodiment.
[FIG. 50]

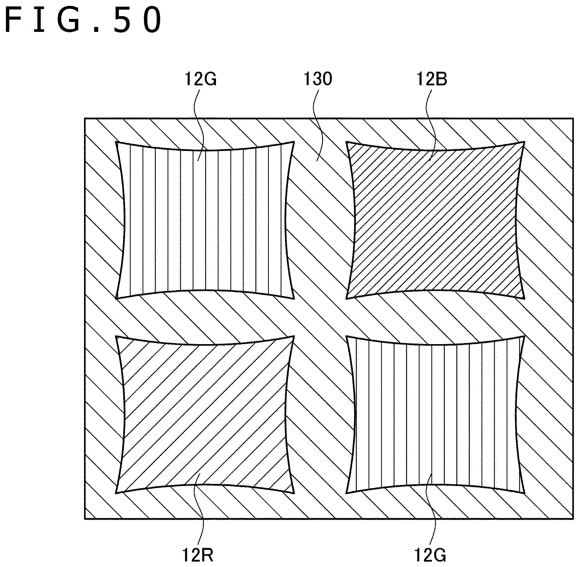

   FIG. 50 is a plan diagram depicting a planar configuration of the pixel unit according to the sixth embodiment.
[FIG. 51]

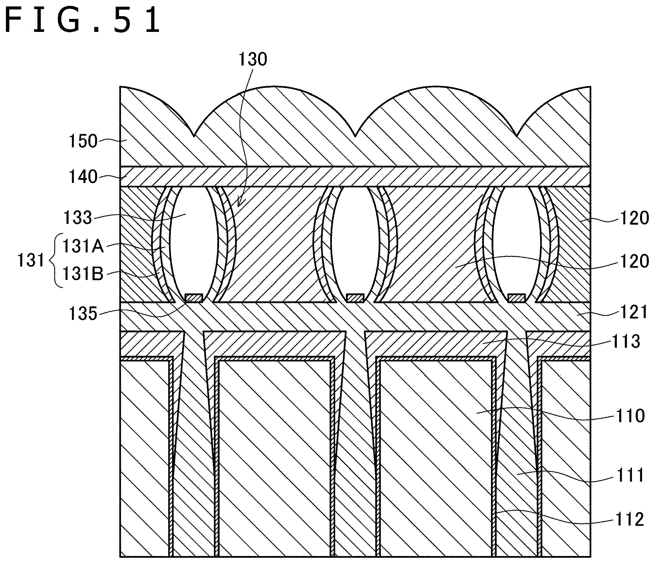

   FIG. 51 is a vertical cross-sectional diagram explaining a first modification of the pixel unit according to the sixth embodiment.
[FIG. 52]

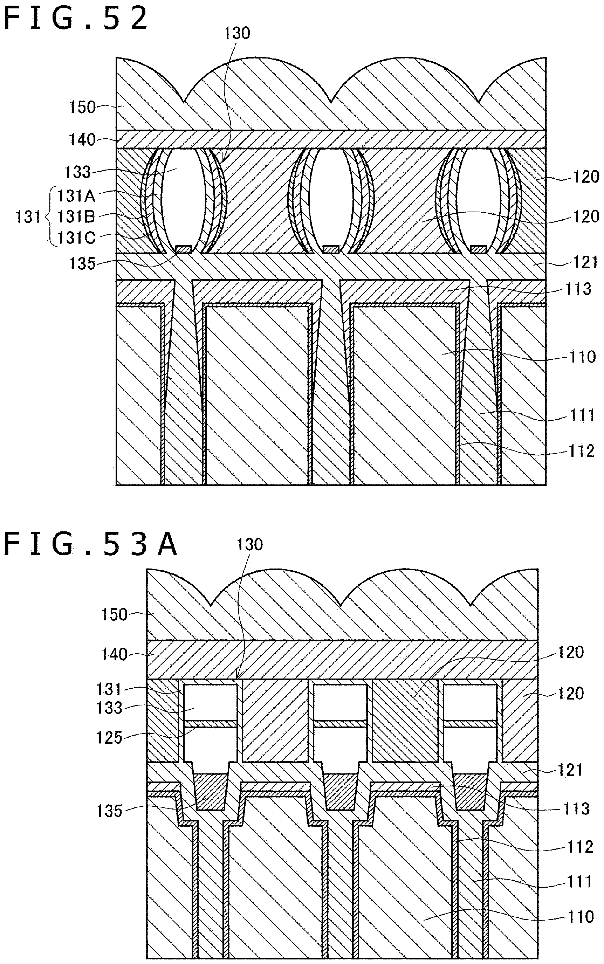

   FIG. 52 is a vertical cross-sectional diagram explaining a second modification of the pixel unit according to the sixth embodiment.
[FIG. 53A]
   FIG. 53A is a vertical cross-sectional diagram depicting a cross section of a first configuration example of a pixel unit according to a seventh embodiment.
[FIG. 53B]

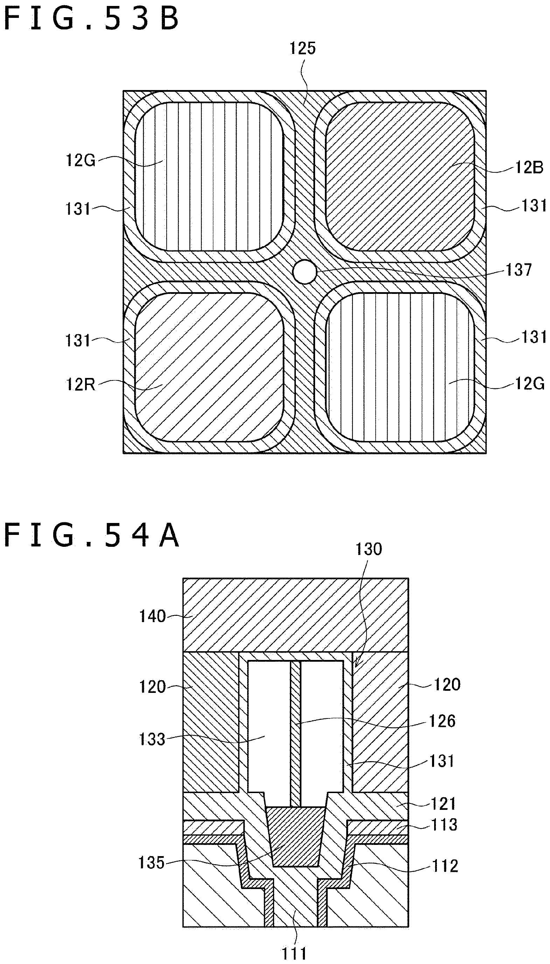

   FIG. 53B is a plan diagram depicting a plane of the first configuration example of the pixel unit according to the seventh embodiment.
[FIG. 54A]
   FIG. 54A is a vertical cross-sectional diagram depicting a cross section of a second configuration example of the pixel unit according to the seventh embodiment.
[FIG. 54B]

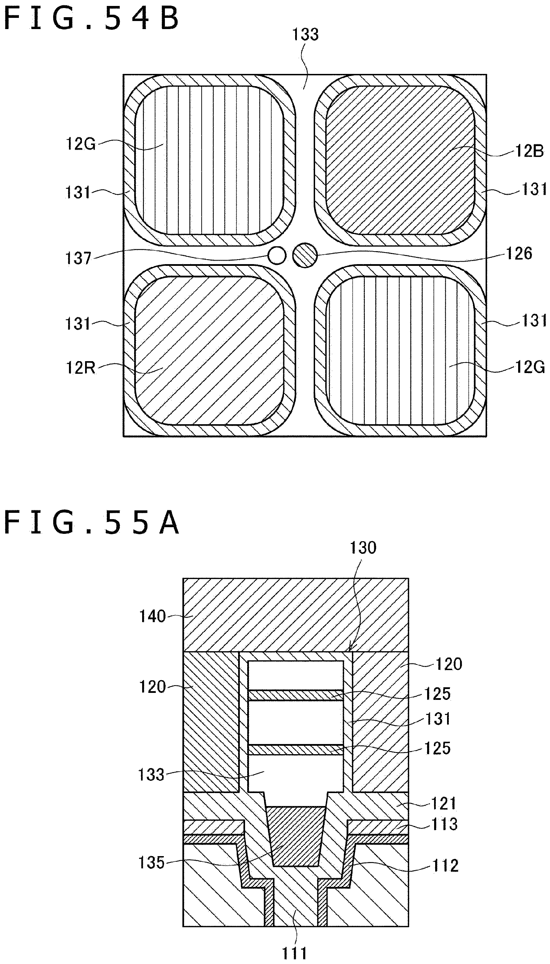

   FIG. 54B is a plan diagram depicting a plane of the second configuration example of the pixel unit according to the seventh embodiment.
[FIG. 55A]
   FIG. 55A is a vertical cross-sectional diagram depicting a cross section of a third configuration example of the pixel unit according to the seventh embodiment.
[FIG. 55B]

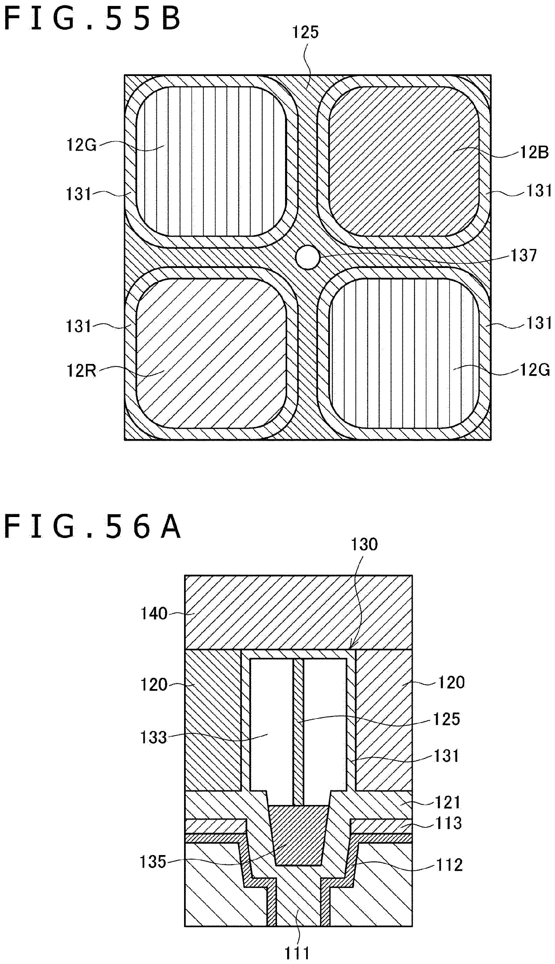

   FIG. 55B is a plan diagram depicting a plane of the third configuration example of the pixel unit according to the seventh embodiment.
[FIG. 56A]
   FIG. 56A is a vertical cross-sectional diagram depicting a cross section of a fourth configuration example of the pixel unit according to the seventh embodiment.
[FIG. 56B]

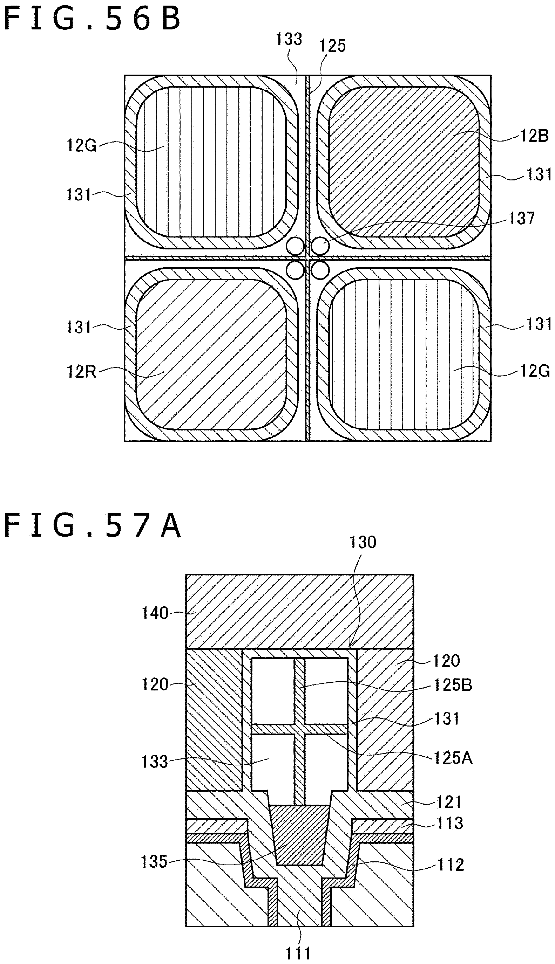

   FIG. 56B is a plan diagram depicting a plane of the fourth configuration example of the pixel unit according to the seventh embodiment.
[FIG. 57A]
   FIG. 57A is a vertical cross-sectional diagram depicting a cross section of a fifth configuration example of the pixel unit according to the seventh embodiment.
[FIG. 57B]

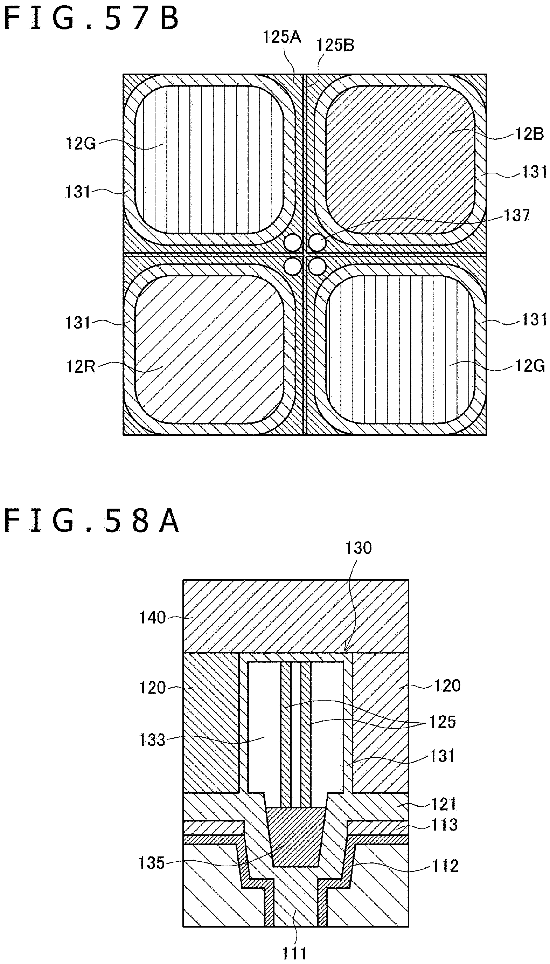

   FIG. 57B is a plan diagram depicting a plane of the fifth configuration example of the pixel unit according to the seventh embodiment.
[FIG. 58A]
   FIG. 58A is a vertical cross-sectional diagram depicting a cross section of a sixth configuration example of the pixel unit according to the seventh embodiment.
[FIG. 58B]

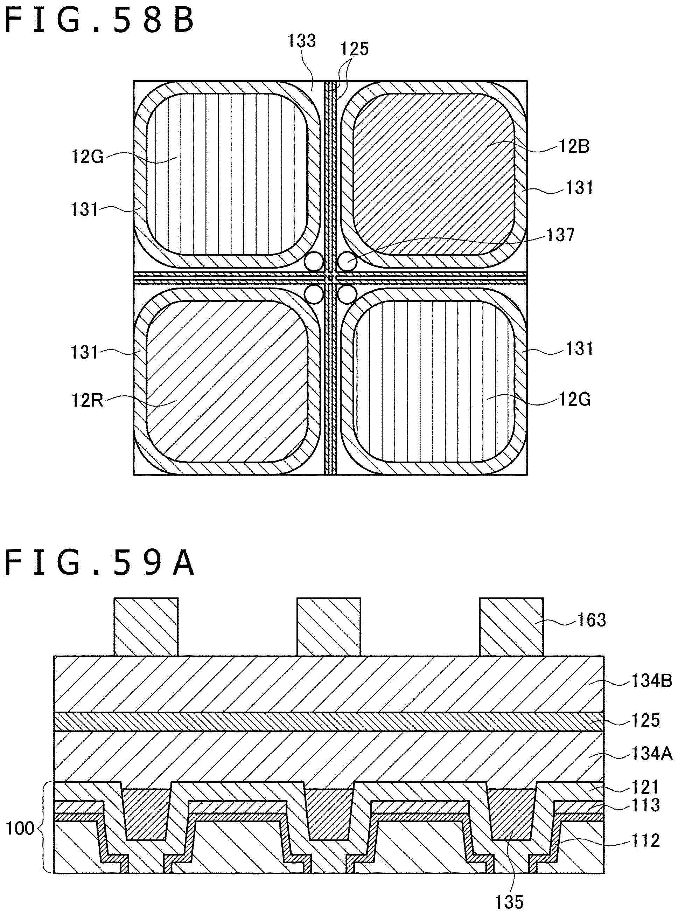

   FIG. 58B is a plan diagram depicting a plane of the sixth configuration example of the pixel unit according to the seventh embodiment.
[FIG. 59A]
   FIG. 59A is a vertical cross-sectional diagram explaining a manufacturing method of the first configuration example of the pixel unit according to the seventh embodiment.
[FIG. 59B]

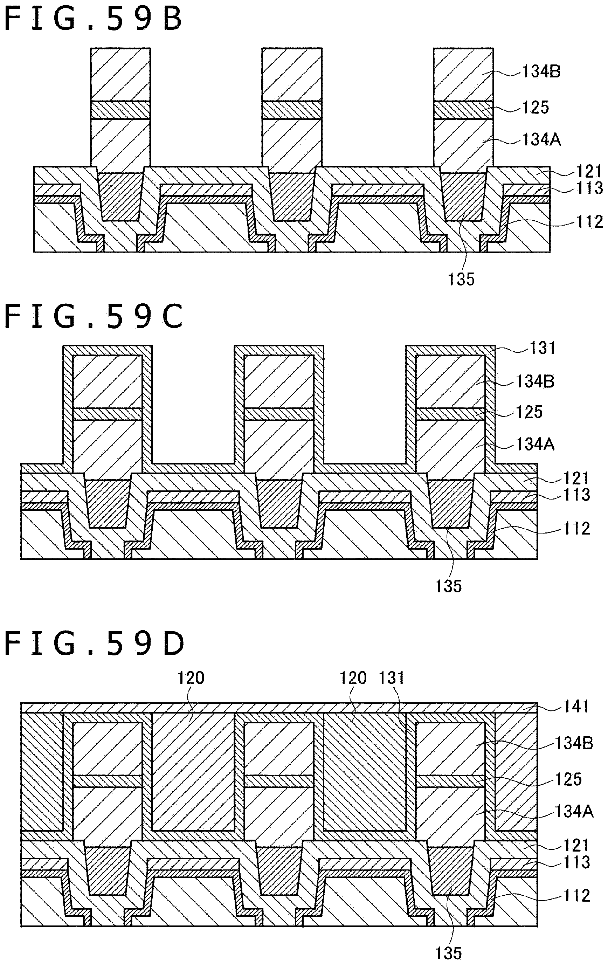

   FIG. 59B is a vertical cross-sectional diagram explaining the manufacturing method of the first configuration example of the pixel unit according to the seventh embodiment.
[FIG. 59C]
   FIG. 59C is a vertical cross-sectional diagram explaining the manufacturing method of the first configuration example of the pixel unit according to the seventh embodiment.
[FIG. 59D]
   FIG. 59D is a vertical cross-sectional diagram explaining the manufacturing method of the first configuration example of the pixel unit according to the seventh embodiment.
[FIG. 59E]

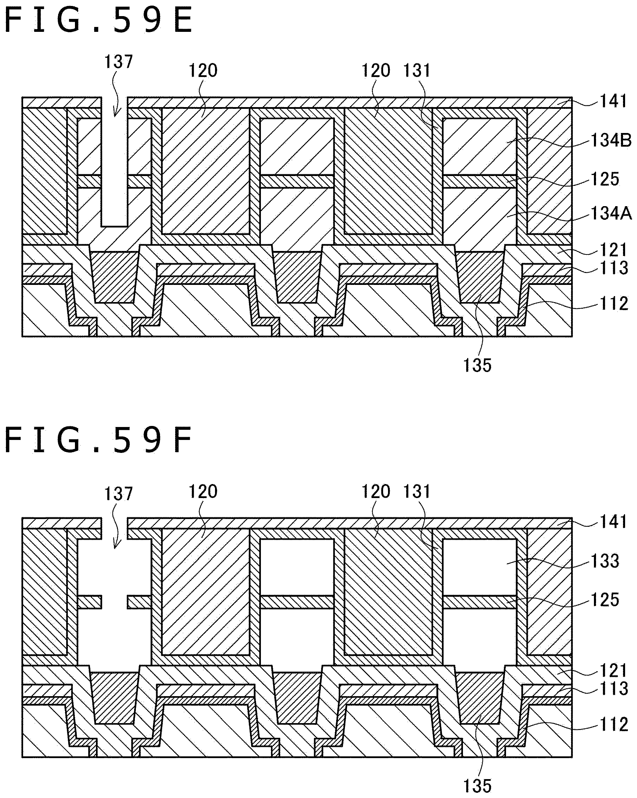

   FIG. 59E is a vertical cross-sectional diagram explaining the manufacturing method of the first configuration example of the pixel unit according to the seventh embodiment.
[FIG. 59F]
   FIG. 59F is a vertical cross-sectional diagram explaining the manufacturing method of the first configuration example of the pixel unit according to the seventh embodiment.
[FIG. 60A]

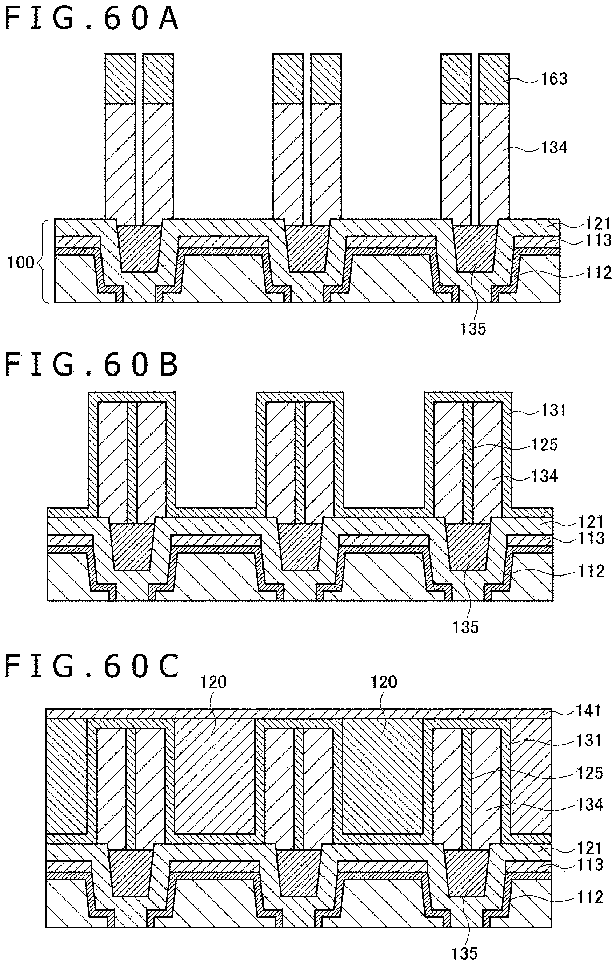

   FIG. 60A is a vertical cross-sectional diagram explaining a manufacturing method of the fourth configuration example of the pixel unit according to the seventh embodiment.
[FIG. 60B]
   FIG. 60B is a vertical cross-sectional diagram explaining the manufacturing method of the fourth configuration example of the pixel unit according to the seventh embodiment.
[FIG. 60C]
   FIG. 60C is a vertical cross-sectional diagram explaining the manufacturing method of the fourth configuration example of the pixel unit according to the seventh embodiment.
[FIG. 60D]

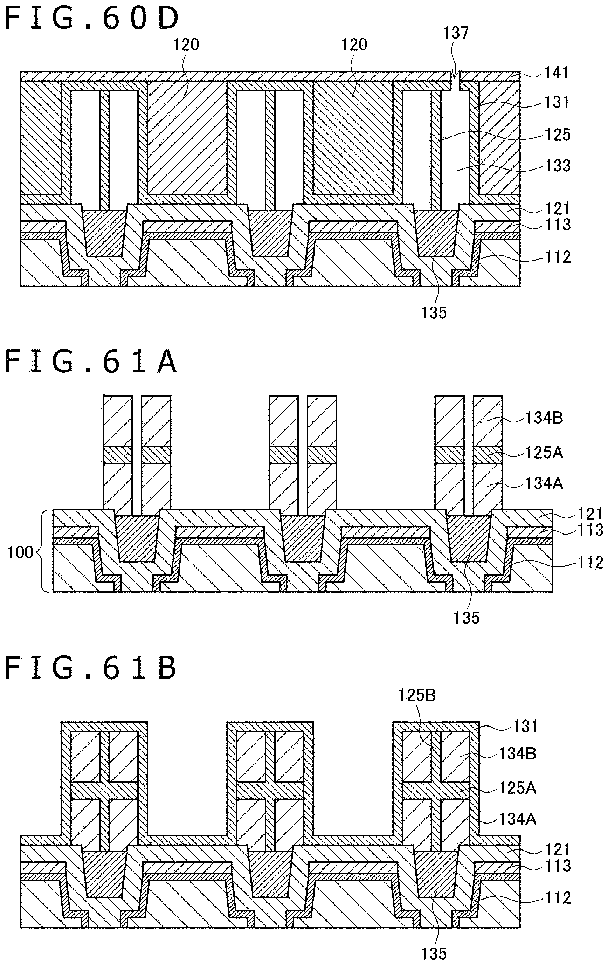

   FIG. 60D is a vertical cross-sectional diagram explaining the manufacturing method of the fourth configuration example of the pixel unit according to the seventh embodiment.
[FIG. 61A]
   FIG. 61A is a vertical cross-sectional diagram explaining a manufacturing method of the fifth configuration example of the pixel unit according to the seventh embodiment.
[FIG. 61B]
   FIG. 61B is a vertical cross-sectional diagram explaining the manufacturing method of the fifth configuration example of the pixel unit according to the seventh embodiment.
[FIG. 61C]

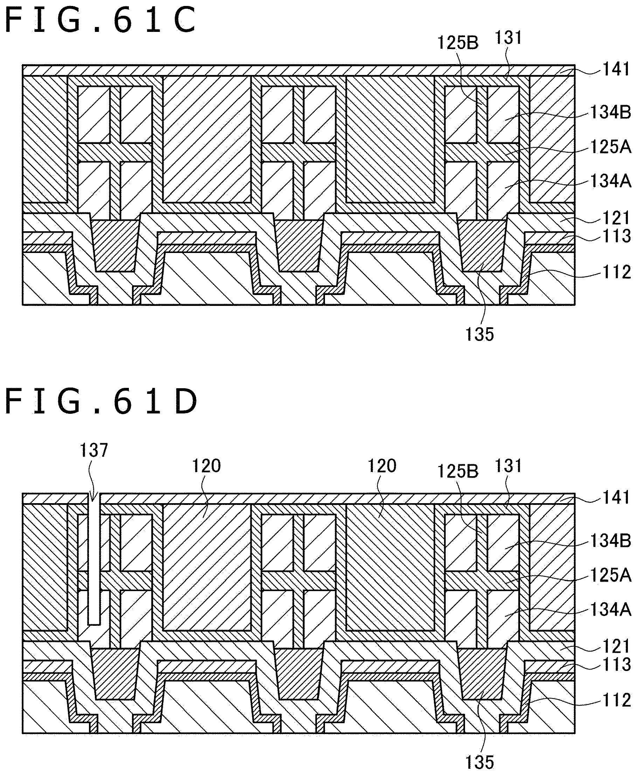

   FIG. 61C is a vertical cross-sectional diagram explaining the manufacturing method of the fifth configuration example of the pixel unit according to the seventh embodiment.
[FIG. 61D]
   FIG. 61D is a vertical cross-sectional diagram explaining the manufacturing method of the fifth configuration example of the pixel unit according to the seventh embodiment.
[FIG. 61E]

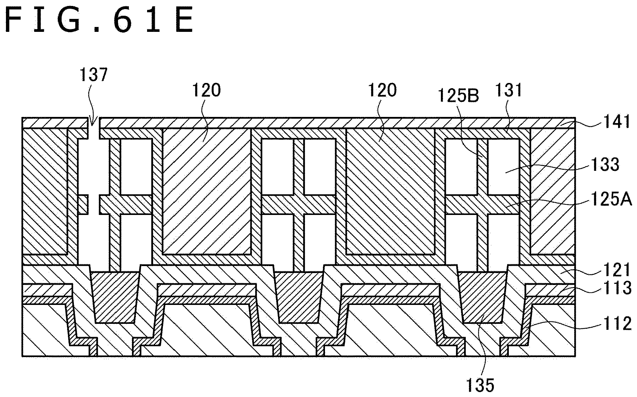

   FIG. 61E is a vertical cross-sectional diagram explaining the manufacturing method of the fifth configuration example of the pixel unit according to the seventh embodiment.
[FIG. 62]

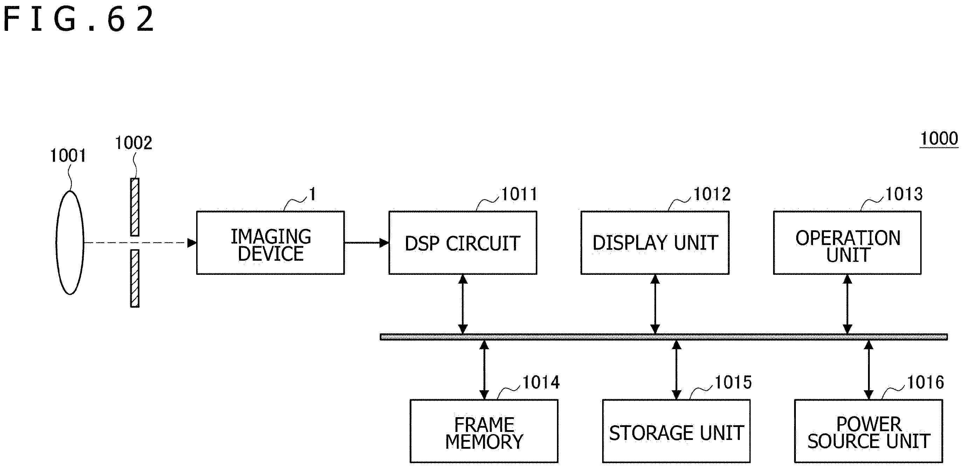

   FIG. 62 is a block diagram depicting a configuration example of an electronic apparatus including an imaging device according to one embodiment of the present disclosure.
[FIG. 63]

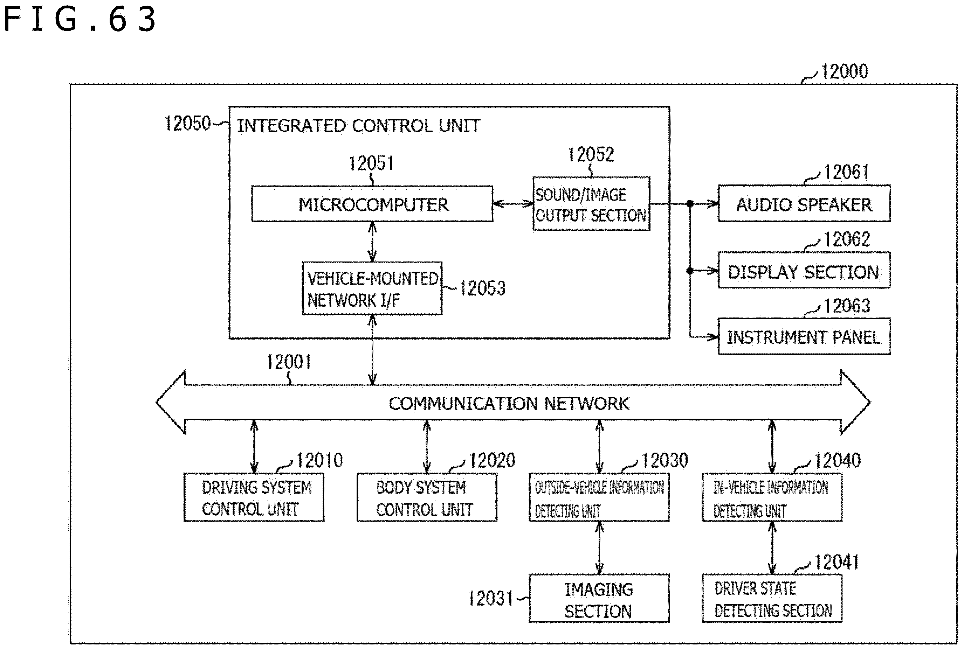

   FIG. 63 is a block diagram depicting an example of schematic configuration of a vehicle control system.
[FIG. 64]

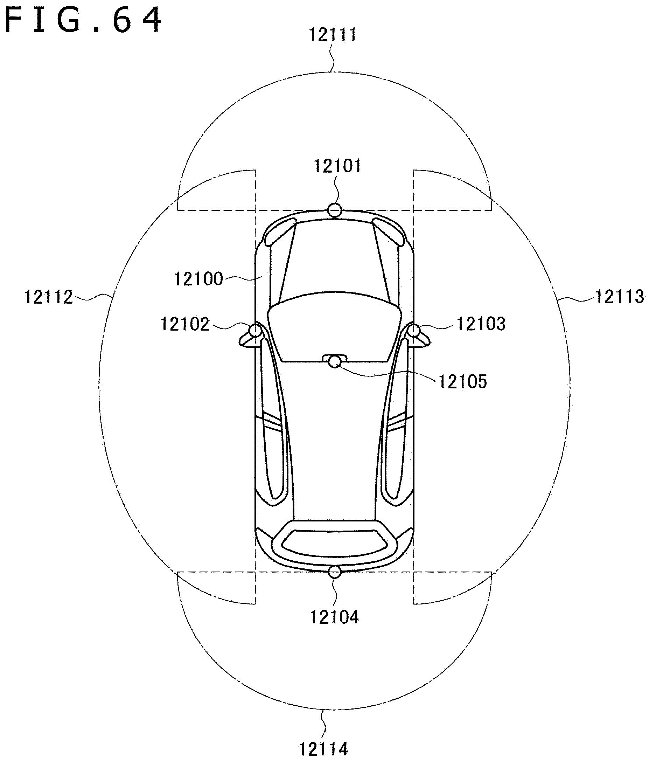

   FIG. 64 is a diagram of assistance in explaining an example of installation positions of an outside-vehicle information detecting section and an imaging section.

### [Description of Embodiments]

Preferred embodiments of the present disclosure will be hereinafter explained in detail with reference to the accompanying drawings. Note that constituent elements having substantially identical functional configurations in the present description and the drawings will be given identical reference signs to omit repetitive explanation.

Note that the explanation will be presented in the following order.
1. First embodiment
   1.1. General configuration of imaging device
   1.2. Configuration of pixel unit
   1.3. Manufacturing method
2. Second embodiment
   2.1. Configuration of pixel unit
   2.2. Manufacturing method
   2.3. Modifications
3. Third embodiment
   3.1. Configuration of pixel unit
   3.2. Modifications
   3.3. Manufacturing method
4. Fourth embodiment
   4.1. Configuration of pixel unit
   4.2. Modifications
   4.3. Manufacturing method
5. Fifth embodiment
   5.1. Configuration of pixel unit
   5.2. Manufacturing method
6. Sixth embodiment
   6.1. Configuration of pixel unit
   6.2. Modifications
   6.3. Manufacturing method
7. Seventh embodiment
   7.1. Configuration of pixel unit
   7.2. Modifications
8. Eighth embodiment
   8.1. Configuration of pixel unit
   8.2. Manufacturing method
9. Electronic apparatus
10. Application example

### <1. First embodiment>

### (1.1. General configuration of imaging device)

A general configuration of an imaging device according to a first embodiment of the present disclosure will be initially described with reference to FIG. 1. FIG. 1 is a schematic diagram depicting a general configuration of an imaging device 1 according to the present embodiment.

As depicted in FIG. 1, the imaging device 1 includes a pixel unit 13 including multiple pixels 12 provided on a semiconductor substrate, a vertical driving circuit 14, column signal processing circuits 15, a horizontal driving circuit 16, an output circuit 17, and a control circuit 18.

The pixel unit 13 includes the multiple pixels 12 planarly arranged on a semiconductor substrate in a matrix shape. For example, each of the pixels 12 includes a photoelectric conversion unit containing a photodiode, and a pixel circuit containing a transfer transistor, an amplification transistor, a selection transistor, and a reset transistor. Note that the pixel circuit is not required to contain the selection transistor. Signal charge output from the photodiode is amplified by the pixel circuit to be converted into a pixel signal.

Moreover, the pixels 12 to be provided may have a shared pixel structure. According to the shared pixel structure, a part or the whole of the pixel circuit is shared by the multiple adjoining pixels 12. For example, each of the multiple adjoining pixels 12 may share a pixel circuit containing an amplification transistor, a selection transistor, and a reset transistor provided in a stage subsequent to a transfer transistor. Specifically, each pixel circuit of the multiple adjoining pixels 12 may include an own photodiode, an own transfer transistor, one shared floating diffusion (floating diffusion region: FD), one shared amplification transistor, one shared selection transistor, and one shared reset transistor.

The control circuit 18 controls operations of the respective units of the imaging device 1. Specifically, the control circuit 18 generates clock signals and control signals as operation references of the vertical driving circuit 14, the column signal processing circuits 15, and the horizontal driving circuit 16 on the basis of vertical synchronized signals, horizontal synchronized signals, and master clocks. The control circuit 18 is capable of controlling the operations of the vertical driving circuit 14, the column signal processing circuits 15, and the horizontal driving circuit 16 on the basis of the generated clock signals and control signals.

For example, the vertical driving circuit 14 includes a shift register. The vertical driving circuit 14 selectively scans the pixels 12 sequentially in the vertical direction for each row to drive the pixels 12 for each row. In this manner, the vertical driving circuit 14 is capable of reading a pixel signal generated according to a received light amount from each of the pixels 12 and supplying the read pixel signal to the corresponding column signal processing circuit 15 via a vertical signal line 19.

The column signal processing circuit 15 is provided for each column of the pixels 12 to perform signal processing such as noise removal for pixel signals output from the pixels 12. For example, each of the column signal processing circuits 15 may perform correlative double sampling (CDS) processing for removing pattern noise unique to each of the pixels 12, AD (Analog-Digital) conversion processing, and the like for pixel signals output from the pixels 12.

For example, the horizontal driving circuit 16 includes a shift register. The horizontal driving circuit 16 sequentially outputs a horizontal scanning pulse and sequentially selects the respective column signal processing circuits 15 to cause the respective column signal processing circuits 15 to output pixel signals to a horizontal signal line 20.

The output circuit 17 outputs, to the outside of the imaging device 1, pixel signals sequentially supplied from the respective column signal processing circuits 15 via the horizontal signal line 20. For example, the output circuit 17 may perform buffering, black level adjustment, various types of digital signal processing such as column variation correction, or the like for pixel signals supplied from the respective column signal processing circuits 15, and then output the signal-processed pixel signals to the outside of the imaging device 1.

The imaging device 1 having the foregoing configuration is what is called a column AD type CMOS (Complementary MOS) image sensor which includes the column signal processing circuit 15 performing CDS processing and AD conversion processing for each column of the pixels 12.

### (1.2. Configuration of pixel unit)

A configuration of the pixel unit 13 of the imaging device 1 according to the present embodiment will be subsequently described with reference to FIGS. 2 to 4. Each of FIGS. 2 and 3 is a vertical cross-sectional diagram depicting one example of a cross-sectional configuration of the pixel unit 13, while FIG. 4 is a plan diagram depicting a planar configuration of the pixel unit 13. The cross-sectional configuration depicted in FIG. 2 corresponds to a cross-sectional configuration taken along a cutting plane A-AA in FIG. 4, while the cross-sectional configuration depicted in FIG. 3 corresponds to a cross-sectional configuration taken along a cutting plane B-BB in FIG. 4.

As depicted in FIGS. 2 and 3, each of the pixels 12 of the pixel unit 13 includes a photoelectric conversion unit 110, a flattening film 121, a color filter 120, a wall-shaped structure portion 130, a closing film 140, and an on-chip lens 150.

The photoelectric conversion unit 110 is provided for each of the pixels 12. The respective photoelectric conversion units 110 are separated from each other by a pixel separation layer 111. Each of the photoelectric conversion units 110 is a photodiode and is produced by joining a first conductivity-type (e.g., p-type) semiconductor region and a second conductivity-type (e.g., n-type) semiconductor region by PN junction. For example, the photoelectric conversion units 110 may be produced by forming a p-type well region in a semiconductor layer including silicon (Si) or the like and providing an n-type region for each of the pixels 12 inside the p-type well region.

Note that a circuit layer which includes a pixel circuit for converting signal charge photoelectrically converted by the photoelectric conversion unit 110 into a pixel signal is provided on a surface of each of the photoelectric conversion units 110 on the side opposite to a light receiving surface (i.e., a surface where the on-chip lens 150 is provided). Accordingly, the imaging device 1 of the present embodiment is what is called a back-illuminated imaging device.

The pixel separation layer 111 includes an insulating material and is provided so as to extend in a normal direction of a plane where the pixels 12 are arrayed to separate the photoelectric conversion units 110 for each of the pixels 12. In other words, the pixel separation layer 111 is provided so as to extend in a thickness direction of a semiconductor layer where the photoelectric conversion units 110 are provided to separate the photoelectric conversion units 110 for each of the pixels 12. The pixel separation layer 111 may include an insulating material such as silicon oxide (SiOₓ), silicon nitride (SiN), or silicon oxynitride (SiON).

A pinning layer 112 is provided on each surface of the photoelectric conversion units 110 and on each interface between the photoelectric conversion units 110 and the pixel separation layer 111. The pinning layer 112 includes a high dielectric material having negative fixed charge, such as hafnium oxide (HfO₂), zirconium oxide (ZrO₂), aluminum oxide (Al₂O₃), tantalum oxide (Ta₂O₅), titanium oxide (TiO₂), magnesium oxide (MgO), yttrium oxide (Y₂O₃), or an oxide of lanthanoid. The pinning layer 112 forms a region where holes are accumulated on the surfaces of the photoelectric conversion units 110 and the interfaces between the photoelectric conversion units 110 and the pixel separation layer 111 to reduce generation of dark current in the photoelectric conversion units 110.

Moreover, an anti-reflection layer 113 is provided on each of the photoelectric conversion units 110 on the light receiving surface side of the pinning layer 112 in such a manner as to cover the photoelectric conversion units 110. The anti-reflection layer 113 thus provided includes an insulating material having a refractive index lower than a refractive index of the high dielectric material constituting the pinning layer 112. The anti-reflection layer 113 thus configured can further reduce reflection of light entering the anti-reflection layer 113 and the pinning layer 112 from the on-chip lens 150 side corresponding to the light receiving surface side. For example, the anti-reflection layer 113 may include tantalum oxide (Ta₂O₅).

The flattening film 121 is uniformly provided on the light receiving surface side of the anti-reflection layer 113 continuously through the multiple pixels 12. For example, the flattening film 121 may include an insulating material having high light transparency (e.g., light transmittance of approximately 70% or higher in a visible light band), such as silicon oxide (SiOₓ), silicon nitride (SiN), or silicon oxynitride (SiON).

The flattening film 121 may be provided continuously with the pixel separation layer 111. Specifically, the flattening film 121 and the pixel separation layer 111 each including an insulating material such as SiOₓ may be continuously formed. In such a case, the flattening film 121 and the pixel separation layer 111 are allowed to be formed by the same step. Accordingly, manufacturing steps of the imaging device 1 can be more simplified.

Provided on the light receiving surface side of the flattening film 121 are the color filters 120 separated from each other by the wall-shaped structure portion 130 for each of the pixels 12. For example, each of the color filters 120 may be formed by applying organic resin containing a pigment presenting red, green, or blue to an area of the corresponding pixel 12.

For example, as depicted in FIG. 4, the pixel unit 13 may have the pixels 12 including red pixels 12R, green pixels 12G, and blue pixels 12B and planarly arranged in a matrix shape. Each of the red pixels 12R is a pixel containing a red color filter and receiving red light. Each of the green pixels 12G is a pixel containing a green color filter and receiving green light. Each of the blue pixels 12B is a pixel containing a blue color filter and receiving blue light. The pixel unit 13 may include sets of the red pixels 12R, the green pixels 12G, and the blue pixel 12B, each set being constituted by the adjoining 2 × 2 pixels 12. Specifically, for example, the pixel unit 13 may have what is called a 2 × 2 Bayer array where each set of the 2 × 2 pixels 12 contains the red pixel 12R, the green pixel 12G, or the blue pixels 12B.

The wall-shaped structure portion 130 is a partition provided between the respective pixels 12 and has an external shape defined by a first wall portion 131 including an insulating material. Specifically, the wall-shaped structure portion 130 is defined by the first wall portion 131 which surrounds a side plane of a grid-shaped space between the pixels 12 planarly arranged in a matrix shape and an upper plane of a light receiving surface side.

In this case, an internal space surrounded by the first wall portion 131 of the wall-shaped structure portion 130 constitutes the void 133 having a refractive index of approximately 1. Because the refractive index of the void 133 is thus considerably low, the wall-shaped structure portion 130 more easily satisfies conditions required for incident light to achieve total reflection on an interface between the void 133 and the first wall portion 131. Accordingly, the wall-shaped structure portion 130 is capable of more efficiently reflecting light entering the wall-shaped structure portion 130 on the interface between the void 133 and the first wall portion 131, and thus achieves more reduction of crosstalk caused by incident light coming over the wall-shaped structure portion 130 into the adjoining pixel 12.

The foregoing structure of the wall-shaped structure portion 130, which will be described in detail below, is formed by the following method, for example. Specifically, a temporary wall portion is initially formed in a grid shape in areas between the pixels 12. The first wall portion 131 is subsequently formed on a side surface and an upper surface of the temporary wall portion to cover the temporary wall portion. Thereafter, the color filter 120 is formed in each area of the pixels 12, and then openings 137 are formed in the upper surface of the first wall portion 131. Subsequently, the temporary wall portion inside the first wall portion 131 is removed by wet etching or dry etching via the openings 137 of the first wall portion 131 to form the void 133 inside the first wall portion 131. In addition, after the void 133 is formed, the openings 137 of the first wall portion 131 are closed by the closing film 140 described below. In this manner, the void 133 inside the wall-shaped structure portion 130 is sealed.

The first wall portion 131 may be formed such that a film thickness of the upper surface of the wall-shaped structure portion 130 becomes larger than a film thickness of the side surface of the wall-shaped structure portion 130. The upper surface of the wall-shaped structure portion 130 is subjected to processing such as etching, CVD (Chemical Vapor Deposition), or CMP (Chemical Mechanical Polishing) in a later stage of the manufacturing steps. Accordingly, the first wall portion 131 constituting the upper surface of the wall-shaped structure portion 130 and having a larger film thickness can further raise processing resistance during the manufacturing steps. For example, the first wall portion 131 constituting the upper surface of the wall-shaped structure portion 130 can prevent collapsing of the first wall portion 131 of the upper surface during a step of flattening upper surfaces of the color filters 120 and the wall-shaped structure portion 130 by CMP after the color filters 120 are formed.

A light shielding portion 135 may be provided in a lower portion of the void 133 inside the wall-shaped structure portion 130. For example, the light shielding portion 135 is provided as a single-layer film including titanium (Ti), titanium nitride (TiN), tantalum (Ta), or tantalum nitride (TaN), each of which is a light shielding material, or a laminated film of these materials. The light shielding portion 135 can achieve further reduction of crosstalk between the pixels 12 by shielding incident light passing between the pixels 12 from a lower portion of the wall-shaped structure portion 130.

The closing film 140 is continuously provided on the light receiving surface side of the color filters 120 and extend through the multiple pixels 12. For example, the closing film 140 includes an insulating material such as silicon oxide (SiOₓ), silicon nitride (SiN), or silicon oxynitride (SiON). The closing film 140 is a film including the insulating material described above and formed on the wall-shaped structure portion 130 and the color filters 120 by using a low coverage film forming method, such as CVD, to close the openings 137 formed in the first wall portion 131 constituting the upper surface of the wall-shaped structure portion 130.

The openings 137 of the pixel unit 13 are formed only in a partial region of the first wall portion 131 constituting the upper surface of the wall-shaped structure portion 130. Accordingly, the closing film 140 is capable of closing the openings 137 formed in the first wall portion 131 constituting the upper surface of the wall-shaped structure portion 130 even if the closing film 140 has a smaller film thickness. According to the imaging device 1 of the present embodiment, therefore, each distance between the photoelectric conversion units 110 and the on-chip lenses 150 is allowed to further decrease. Accordingly, reduction of crosstalk between the pixels 12 is achievable without deteriorating a light collection property achieved by the on-chip lenses 150.

However, the closing film 140 may include an insulating material having a refractive index substantially equal to a refractive index of the on-chip lenses 150 described below or smaller than the refractive index of the on-chip lenses 150. Note that the "substantially equal" refractive index mentioned above may refer to a different refractive index of the closing film 140 from the refractive index of the on-chip lenses 150 by 0.1 or smaller. This configuration can reduce a possibility that light entering the closing film 140 via the on-chip lenses 150 reflects on interfaces between the on-chip lenses 150 and the closing film 140, and therefore can further increase amounts of light entering the photoelectric conversion units 110.

For example, in a case where the on-chip lenses 150 include ordinary organic resin for optical use (refractive index: approximately 1.5 to 1.6), the closing film 140 may include silicon oxynitride (SiON) having a refractive index of 1.58.

For example, as depicted in FIG. 4, each of the openings 137 may be provided between the pixels 12 arrayed in a matrix shape and located in diagonal directions. Each of the openings 137 is provided in the wall-shaped structure portion 130 between the pixels 12. Accordingly, each of the openings 137 formed between the pixels 12 in the diagonal directions is allowed to have a larger radius in comparison with a case where each of the openings 137 is formed between the pixels 12 in row directions or column directions.

Each of the openings 137 is an inlet port through which a chemical solution for wet etching or an etching gas for dry etching is introduced into the inside of the first wall portion 131. Accordingly, the number of the openings 137 may be reduced to such an extent that etching is allowed to progress. For example, as depicted in FIG. 4, the openings 137 may be provided not between all the pixels 12 located in diagonal directions, but only between the pixels located in diagonal directions and adjacent to the three types of the pixels 12 each receiving different color light (red pixel 12R, green pixel 12G, and blue pixel 12B in FIG. 4).

Alternatively, the openings 137 may be formed between a larger number of the pixels located in diagonal directions. In such a case, the chemical solution or the etching gas for etching can be more efficiently introduced into the inside of the first wall portion 131. Accordingly, a processing time required for etching can be more shortened.

Moreover, each of the openings 137 closed by the closing film 140 can function as a waveguide having a waveguide effect for introducing incident light. Accordingly, the openings 137 may be formed between a larger number of the pixels located in diagonal directions in the pixels 12 arrayed in a matrix shape. For example, the opening 137 may be formed between the pixels 12 located in diagonal directions and each adjacent to the pixel receiving light in the same color. In such a case, the opening 137 closed by the closing film 140 is capable of more intensely introducing incident light to the respective pixels 12 provided adjacently to each other to receive light in the same color.

The on-chip lens 150 is provided on the light receiving surface side of the closing film 140 for each of the pixels 12. Specifically, the on-chip lens 150 is provided as a convex lens which collects incident light for each of the pixels 12. In this case, the on-chip lens 150 allows the photoelectric conversion unit 110 provided for each of the pixels 12 to efficiently receive light. For example, the on-chip lens 150 may include transparent organic resin, such as styrene-based resin, acryl-based resin, styrene-acryl copolymerization-based resin, or siloxane-based resin, such that light transparency becomes 70% or higher in a visible light band.

According to the imaging device 1 which includes the pixel unit 13 having the above configuration, each radius of the openings 137 used at the time of formation of the void 133 in the wall-shaped structure portion 130 between the pixels 12 is allowed to become smaller. In this case, the openings 137 can be closed by the closing film 140 having a smaller film thickness. Accordingly, the imaging device 1 can reduce crosstalk caused between the pixels 12 by using the wall-shaped structure portion 130 containing the void 133 without deteriorating the light collection property of the on-chip lenses 150 according to a height increase. As a result, sensitivity of the imaging device 1 is allowed to improve.

Moreover, according to the imaging device 1, the external shape of the wall-shaped structure portion 130 is defined by the first wall portion 131. In this case, the shape of the void 133 formed inside the wall-shaped structure portion 130 can be further stabilized. Accordingly, the imaging device 1 can reduce variations in crosstalk between the pixels 12.

### (1.3. Modifications)

### (Modification examples of wall-shaped structure portion)

First to fifth modifications of the wall-shaped structure portion 130 will be subsequently described with reference to FIGS. 5 to 11.

FIG. 5 is a vertical cross-sectional diagram depicting the first modification of the wall-shaped structure portion 130. As depicted in FIG. 5, a second wall portion 132 may be further provided inside the first wall portion 131 of the wall-shaped structure portion 130. Specifically, the second wall portion 132 includes an insulating material identical to the insulating material constituting the closing film 140 and is provided in a region located inside the wall-shaped structure portion 130 and facing the void 133.

For example, the second wall portion 132 is formed by entrance of a material constituting the closing film 140 into the void 133 inside the wall-shaped structure portion 130 via the openings 137 at the time of formation of the closing film 140 for closing the openings 137. Accordingly, for example, the second wall portion 132 may be provided in the void 133 inside the wall-shaped structure portion 130 located near the openings 137, while the second wall portion 132 may be eliminated from the void 133 inside the wall-shaped structure portion 130 located away from the openings 137.

Each of FIGS. 6A and 6B is a vertical cross-sectional diagram depicting the second modification of the wall-shaped structure portion 130. As depicted in FIG. 6A, the wall-shaped structure portion 130 may have a reverse tapered shape which has a width decreasing toward the photoelectric conversion units 110 on the side opposite to the light receiving surface. Moreover, as depicted in FIG. 6B, the wall-shaped structure portion 130 may have a forward tapered shape which has a width increasing toward the photoelectric conversion units 110 on the side opposite to the light receiving surface.

The external shape of the wall-shaped structure portion 130 is defined by the first wall portion 131 formed on the side surface and the upper surface of the temporary wall portion (which will be removed in the following process and thus is not depicted in the figure) in a manner to cover the temporary wall portion after the temporary wall portion is formed in the region where the wall-shaped structure portion 130 is provided. Accordingly, the wall-shaped structure portion 130 is allowed to have any cross section having a forward tapered shape, a reverse tapered shape, or a non-tapered shape by controlling a cross-sectional shape of the temporary wall. In this case, the wall-shaped structure portion 130 to be provided has a more stabilized cross-sectional shape. Accordingly, variations in crosstalk between the pixels 12 produced by the wall-shaped structure portion 130 can be reduced by the entire pixel unit 13.

FIG. 7 is a vertical cross-sectional diagram depicting the third modification of the wall-shaped structure portion 130. As depicted in FIG. 7, the light shielding portion 135 may be eliminated from the void 133 inside the wall-shaped structure portion 130.

The light shielding portion 135 reduces crosstalk between the pixels 12 by shielding incident light passing between the pixels 12 from a lower portion of the wall-shaped structure portion 130. However, an amount of light entering each of the photoelectric conversion units 110 decreases by the shield of the incident light. Accordingly, in a case where crosstalk between the pixels 12 can be sufficiently reduced by the void 133 inside the wall-shaped structure portion 130, the light shielding portion 135 may be eliminated so as to increase the incident light entering the photoelectric conversion units 110.

Each of FIGS. 8 and 9 is a vertical cross-sectional diagram depicting the fourth modification of the wall-shaped structure portion 130. As depicted in FIG. 8, the light shielding portion 135 provided in the lower part of the void 133 may have a smaller width than that of the lower part of the void 133. Alternatively, as depicted in FIG. 9, the light shielding portion 135 provided in the lower part of the void 133 may have a larger width than that of the lower part of the void 133.

As described in the third modification, the light shielding portion 135 reduces crosstalk between the pixels 12, but decreases the amount of light entering each of the photoelectric conversion units 110. Accordingly, the size of the width of the light shielding portion 135 may be selected in consideration of a balance between reduction of crosstalk between the pixels 12, and the amount of light entering each of the photoelectric conversion units 110.

For example, in a case where crosstalk between the pixels 12 can be sufficiently reduced by the void 133 inside the wall-shaped structure portion 130, the light shielding portion 135 may have a smaller width than that of the lower part of the void 133 so as to increase the incident light entering the photoelectric conversion units 110. On the other hand, in a case where crosstalk between the pixels 12 is difficult to reduce by the void 133 inside the wall-shaped structure portion 130, the light shielding portion 135 may have a larger width than that of the lower part of the void 133 so as to further reduce crosstalk between the pixels 12.

Each of FIGS. 10 and 11 is a vertical cross-sectional diagram depicting the fifth modification of the wall-shaped structure portion 130. As depicted in FIG. 10, the light shielding portion 135 provided in the lower part of the void 133 may be located above a lower surface of a photoelectric conversion unit 110 side of the color filter 120. Moreover, as depicted in FIG. 11, the light shielding portion 135 provided in the lower part of the void 133 may be located below the lower surface of the photoelectric conversion unit 110 side of the color filter 120.

A shielding ability exerted by the light shielding portion 135 to shield incident light coming from the lower part of the wall-shaped structure portion 130 and passing between the pixels 12 is influenced by an incident angle and an incident position of the incident light and the position of the light shielding portion 135. Accordingly, the light shielding portion 135 can more efficiently reduce crosstalk between the pixels 12 by adjustment of the positions of the color filters 120 in a film thickness direction.

### (Modifications of opening arrangement)

First to fourth modifications of arrangement of the openings 137 will be subsequently described with reference to FIGS. 12 to 15.

FIG. 12 is a plan diagram depicting the first modification of the arrangement of the openings 137. As depicted in FIG. 12, the openings 137 may be provided between the pixels included in the pixels 12 arrayed in a matrix shape and located in diagonal directions, and adjacent to the three types of the pixels 12 each receiving different color light (red pixel 12R, green pixel 12G, and blue pixel 12B in FIG. 12), and also between the pixels arranged in the row directions or the column directions including the pixels adjacent to the three types of the pixels 12.

FIG. 13 is a plan diagram depicting the second modification of the arrangement of the openings 137. As depicted in FIG. 13, the openings 137 may be provided between all the pixels 12 arrayed in a matrix shape and located in diagonal directions. Each of the openings 137 closed by the closing film 140 can function as a waveguide having a waveguide effect for introducing incident light. Accordingly, the arrangement of the openings 137 between all the pixels 12 arrayed in a matrix shape and located diagonal directions can introduce a larger amount of incident light into each of the photoelectric conversion units 110. Moreover, in a case where a larger number of the openings 137 are provided, the void 133 inside the wall-shaped structure portion 130 is further enlarged and made uniform within the pixel unit 13. In this manner, the imaging device 1 can further reduce variations in crosstalk between the pixels 12.

FIG. 14 is a plan diagram depicting the third modification of the arrangement of the openings 137. As depicted in FIG. 14, the openings 137 may be provided between the pixels each adjacent to the pixel receiving light in the same color (red pixel 12R in FIG. 14) in the pixels 12 arrayed in a matrix shape and located in diagonal directions. Each of the openings 137 closed by the closing film 140 can function as a waveguide having a waveguide effect for introducing incident light. Accordingly, the arrangement of the openings 137 between the pixels 12 located in diagonal directions and each adjacent to the pixel receiving light in the same color can introduce a larger amount of incident light into each of the photoelectric conversion units 110 of the pixels 12 receiving light in the same color.

FIG. 15 is a plan diagram depicting the fourth modification of the arrangement of the openings 137. As depicted in FIG. 15, the openings 137 may be provided between the pixels included in the pixels 12 arrayed in a matrix shape and located in diagonal directions and each adjacent to the pixel 12 receiving light in the same color (red pixel 12R in FIG. 15), and also between the pixels arranged in the row directions or the column directions including the pixels each adjacent to the pixel 12 receiving light in the same color. Each of the openings 137 closed by the closing film 140 can function as a waveguide having a waveguide effect for introducing incident light. Accordingly, the arrangement of the openings 137 between the pixels 12 including the pixels located in diagonal directions and each adjacent to the pixel receiving light in the same color can introduce a larger amount of incident light into each of the photoelectric conversion units 110 of the pixels 12 receiving light in the same color.

### (Modification of pixel unit)

First and second modifications of the pixel unit 13 will be further described with reference to FIGS. 16A and 16B.

FIG. 16A is a plan diagram depicting the first modification of the pixel unit 13. The pixel unit 13 according to the first modification may include sets of the red pixels 12R, the green pixels 12G, and the blue pixel 12B, each set being constituted by the adjoining 3 × 3 pixels 12. Specifically, for example, the pixel unit 13 may have what is called a 3 × 3 Bayer array where each set of the 3 × 3 pixels 12 contains the red pixel 12R, the green pixel 12G, or the blue pixels 12B. The arrangement of the openings 137 of the pixel unit 13 according to the first modification is not limited to the example depicted in FIG. 16A. Each of the arrangements depicted in FIGS. 12 to 15 may be similarly applied.

FIG. 16B is a plan diagram depicting the second modification of the pixel unit 13. The pixel unit 13 according to the second modification may include sets of the red pixels 12R, the green pixels 12G, and the blue pixel 12B, each set being constituted by the adjoining 4 × 4 pixels 12. Specifically, for example, the pixel unit 13 may have what is called a 4 × 4 Bayer array where each set of the 4 × 4 pixels 12 contains the red pixel 12R, the green pixel 12G, or the blue pixels 12B. The arrangement of the openings 137 of the pixel unit 13 according to the second modification is not limited to the example depicted in FIG. 16B. Each of the arrangements depicted in FIGS. 12 to 15 may be similarly applied.

### (1.4. Manufacturing method)

A manufacturing method of the pixel unit 13 according to the present embodiment will be subsequently described with reference to FIGS. 17 to 26. Each of FIGS. 17 to 26 is a vertical cross-sectional diagram explaining one step of the manufacturing method of the pixel unit 13.

Initially, as depicted in FIG. 17, the flattening film 121 is formed on a semiconductor layer 100 where the photoelectric conversion unit 110 is provided for each of the pixels 12. Thereafter, the light shielding portion 135 and a temporary wall portion 134 are sequentially formed on the flattening film 121.

Specifically, conductivity-type impurities are initially introduced into the semiconductor layer 100 including silicon (Si) or the like to form the photoelectric conversion units 110. Next, the semiconductor layer 100 in a region other than regions corresponding to the pixels 12 is removed by etching, and then the pinning layer 112 and the anti-reflection layer 113 are formed along external shapes of the photoelectric conversion units 110. Subsequently, spaces produced between the photoelectric conversion units 110 after the removal by etching is filled with SiOₓ to form the pixel separation layer 111. Moreover, SiOₓ constituting the pixel separation layer 111 is further deposited up to an area above the anti-reflection layer 113 to form the flattening film 121. For example, the flattening film 121 may be flattened using CMP or other methods.

Thereafter, TiN is deposited on the flattening film 121 to form the light shielding portion 135. Moreover, aluminum containing copper (AlCu) or amorphous silicon (a-Si) is deposited on the light shielding portion 135 to form the temporary wall portion 134. The temporary wall portion 134 will be removed by wet etching or dry etching in the following step to produce the void 133.

Next, as depicted in FIG. 18, the light shielding portion 135 and the temporary wall portion 134 in the areas corresponding to the pixels 12 are removed by photolithography or other methods. As a result, areas where the color filters 120 will be formed in the following step are opened, and the light shielding portion 135 and the temporary wall portion 134 in a region other than a grid-shaped region between the pixels 12 are removed from the upper part of the flattening film 121.

Subsequently, as depicted in FIG. 19, SiOₓ is deposited on the flattening film 121 and the temporary wall portion 134 by a high coverage film forming method to form the first wall portion 131 on an upper surface and a side surface of the temporary wall portion 134.

Next, as depicted in FIG. 20, the color filters 120 are formed in the areas corresponding to the pixels 12. Specifically, an ultraviolet curing resin containing a pigment of red, green, or blue is applied to each of areas from which the temporary wall portion 134 has been removed by photolithography or other methods. Thereafter, the ultraviolet curing resin is cured by ultraviolet light to form the color filters 120. The areas where the color filters 120 are formed are separated for each of the pixels 12 via the temporary wall portion 134. Accordingly, each of the color filters 120 can be formed in a more stable shape.

Note that a color arrangement of the color filters 120 provided for each of the pixels 12 may be a 2 × 2 Bayer array, a 3 × 3 Bayer array, or a 4 × 4 Bayer array as described above.

Subsequently, as depicted in FIG. 21, SiON is deposited on the color filters 120 and the first wall portion 131 to form a cap layer 141. Specifically, upper surfaces of the first wall portion 131 and the color filters 120 are flattened by etching back, CMP, or other methods, and then the cap layer 141 is formed on the color filters 120 and the first wall portion 131.

Next, as depicted in FIG. 22, a lower layer anti-reflection film 162 and a resist layer 161 are sequentially formed on the cap layer 141. The resist layer 161 includes an ordinary photoresist material and is patterned by photolithography such that areas constituting the openings 137 are opened in the following step. The lower layer anti-reflection film 162 is what is called a BARC film and reduces reflection on a bottom surface of the resist layer 161 during exposure of the resist layer 161 so as to prevent interference between incident light for exposure and reflection light.

Subsequently, as depicted in FIG. 23, the openings 137 are formed by etching the lower layer anti-reflection film 162, the cap layer 141, and the first wall portion 131 with use of the resist layer 161 as a mask. The temporary wall portion 134 is exposed via the openings 137. Note that the resist layer 161 and the lower layer anti-reflection film 162 are removed after the openings 137 are formed.

Thereafter, as depicted in FIG. 24, the temporary wall portion 134 is removed by wet etching or dry etching to form the void 133. Specifically, in a case where the temporary wall portion 134 includes a-Si, a tetramethylammonium hydroxide (TMAH) solution or the like is introduced into the first wall portion 131 via the openings 137 to remove the temporary wall portion 134 and form the void 133. Alternatively, in a case where the temporary wall portion 134 includes AlCu, a mixed solution of phosphoric acid, hydrogen peroxide solution, and water is introduced into the inside of the first wall portion 131 via the openings 137 to remove the temporary wall portion 134 and form the void 133.

Subsequently, as depicted in FIG. 25, SiON is deposited on the cap layer 141 by a low coverage film forming method, such as CVD, to form the closing film 140. The void 133 is shielded by closing the openings 137 with the closing film 140. According to the present embodiment, the openings 137 are formed between the pixels included in the array of the pixels 12 in a matrix shape and located in diagonal directions and each have a smaller radius than a width between the pixels. Accordingly, the openings 137 can be easily closed by the closing film 140 even with a small thickness.

Further, as depicted in FIG. 26, the on-chip lens 150 is formed on the closing film 140 for each of the pixels 12.

According to the steps described above, the temporary wall portion 134, and the first wall portion 131 covering the upper surface and the side surface of the temporary wall portion 134 are formed, and then only the temporary wall portion 134 is removed via the openings 137 formed in the first wall portion 131 to form the wall-shaped structure portion 130. This configuration allows the imaging device 1 to have a more reduced film thickness of the closing film 140 for closing the openings 137. Accordingly, more reduction of crosstalk between the pixels 12 is achievable by using the wall-shaped structure portion 130 without deteriorating the light collection property.

### <2. Second embodiment>

### (2.1. Configuration of pixel unit)

A configuration of the pixel unit 13 according to a second embodiment of the present disclosure will be subsequently described with reference to FIG. 27. FIG. 27 is a vertical cross-sectional diagram depicting one example of a cross-sectional configuration of the pixel unit 13 according to the present embodiment.

As depicted in FIG. 27, each of the pixels 12 of the pixel unit 13 includes the photoelectric conversion unit 110, the flattening film 121, the color filter 120, the wall-shaped structure portion 130, and the on-chip lens 150. Configurations of the photoelectric conversion unit 110, the flattening film 121, the color filter 120, and the on-chip lens 150 are substantially similar to the corresponding configurations described in the first embodiment, and therefore will not be repeatedly explained herein.

The wall-shaped structure portion 130 is a partition provided between the respective pixels 12 and has an external shape defined by a first wall portion 136 including an insulating material. Specifically, the wall-shaped structure portion 130 is defined by the first wall portion 136 which surrounds a side plane of a grid-shaped space between the pixels 12 planarly arranged in a matrix shape and an upper plane of a light receiving surface side .

An internal space surrounded by the first wall portion 136 of the wall-shaped structure portion 130 constitutes the void 133 having a refractive index of approximately 1. Because the refractive index of the void 133 is considerably lower than the refractive index of the first wall portion 136, the wall-shaped structure portion 130 more easily satisfies conditions required for incident light to achieve total reflection on an interface between the void 133 and the first wall portion 136. Accordingly, the wall-shaped structure portion 130 is capable of more efficiently reflecting light entering the wall-shaped structure portion 130 on the interface between the void 133 and the first wall portion 136, and thus achieves more reduction of crosstalk caused by incident light coming over the wall-shaped structure portion 130 into the adjoining pixel 12.

The foregoing structure of the wall-shaped structure portion 130, which will be described in detail below, is formed by the following method, for example. Initially, a temporary wall portion is formed in a grid shape in areas between the pixels 12 by using resin decomposable in the following stage. Thereafter, the first wall portion 136 is formed on a side surface and an upper surface of the temporary wall portion to cover the temporary wall portion. According to the second embodiment, the first wall portion 136 to be provided has a porous structure. In this case, the temporary wall portion inside the first wall portion 136 is easily decomposed and removed by a chemical solution penetrating the first wall portion 136, ultraviolet light passing through the first wall portion 136, or the like. Accordingly, the void 133 can be formed inside the first wall portion 136 of the wall-shaped structure portion 130 without forming openings in the upper surface of the first wall portion 136.

For example, the first wall portion 136 having the porous structure can be formed by depositing a mixture of an organic material and an inorganic insulating material constituting the first wall portion 136 with use of CVD or other methods, and then selectively removing the organic material. In the first wall portion 136 after the deposition, the inorganic insulating material forms a firm mutual network, while the organic material is present dispersedly within the network of the inorganic insulating material. Accordingly, the first wall portion 136 thus formed has a structure containing a large number of holes corresponding to the organic material in the network of the inorganic insulating material (i.e., porous structure) after selective removal of the organic material.

Examples of this type of organic material include α-terpinen (ATRP) which is volatilized by exposure to ultraviolet light or the like. Examples of the inorganic insulating material include diethoxymethylsilane (DEMS) which is a precursor of SiOₓ. In addition, a precursor of an inorganic insulating material such as Si, SiO₂, SiN, SiC, SiCO, SiON, SiCN, SiH, SiOH, SiNH, SiCH, SiCOH, SiONH, or SiCNH may be used as the inorganic insulating material.

Note that the first wall portion 136 may include a known porous low-k material other than the materials presented above as long as a porous structure is provided.

The light shielding portion 135 may be provided in a lower portion of the void 133 inside the wall-shaped structure portion 130. For example, the light shielding portion 135 is provided as a single-layer film including titanium (Ti), titanium nitride (TiN), tantalum (Ta), or tantalum nitride (TaN), each of which is a light shielding material, or a laminated film of these materials. The light shielding portion 135 can achieve further reduction of crosstalk between the pixels 12 by shielding incident light passing between the pixels 12 from a lower portion of the wall-shaped structure portion 130.

According to the second embodiment, openings are not formed in the upper surface of the first wall portion 136. In this case, a closing film for closing the openings is not provided on the light receiving surface side of the color filters 120. Accordingly, each height of the pixels 12 in the pixel unit 13 of the second embodiment can be further reduced.

### (2.2. Manufacturing method)

A manufacturing method of the pixel unit 13 according to the present embodiment will be subsequently described with reference to FIGS. 28A to 28D. Each of FIGS. 28A to 28D is a vertical cross-sectional diagram explaining one step of the manufacturing method of the pixel unit 13 according to the present embodiment.

Initially, similarly to the first embodiment, the flattening film 121 is formed on the semiconductor layer 100 where the photoelectric conversion unit 110 is provided for each of the pixels 12 by the step depicted in FIG. 17. Thereafter, the light shielding portion 135 and the temporary wall portion 134 are sequentially formed on the flattening film 121. Thereafter, the light shielding portion 135 and the temporary wall portion 134 in the areas corresponding to the pixels 12 are removed by the step depicted in FIG. 18. Note that the temporary wall portion 134 includes organic resin volatilized by exposure to ultraviolet light (e.g., ATRP).

Subsequently, as depicted in FIG. 28A, inorganic insulating material and organic material as mixed material constituting the first wall portion 136 is deposited on the flattening film 121 and the temporary wall portion 134 by CVD or other methods to form the first wall portion 136 on the upper surface and the side surface of the temporary wall portion 134. The organic material contained in the first wall portion 136 may be organic resin volatilized by exposure to ultraviolet light (e.g., ATRP).

Next, as depicted in FIG. 28B, the organic material contained in the first wall portion 136 is selectively removed, and the temporary wall portion 134 is removed by exposure to ultraviolet light and heating. In this manner, the void 133 having a refractive index of approximately 1 is formed inside the first wall portion 136.

Thereafter, as depicted in FIG. 28C, the color filters 120 are formed in the areas corresponding to the pixels 12. Specifically, an ultraviolet curing resin containing a pigment of red, green, or blue is applied to each side area of the first wall portion 136 where the void 133 is formed inside. Then, the ultraviolet curing resin is cured by ultraviolet light to form the color filters 120. The areas where the color filters 120 are formed are separated for each of the pixels 12 via the first wall portion 136. Accordingly, each of the color filters 120 can be formed in a more stable shape. The color arrangement of the color filters 120 provided for each of the pixels 12 may be a 2 × 2 Bayer array, a 3 × 3 Bayer array, or a 4 × 4 Bayer array.

Further, as depicted in FIG. 28D, the on-chip lens 150 is formed on the color filter 120 and the first wall portion 136 for each of the pixels 12. In the manner described above, the pixel unit 13 according to the second embodiment is manufactured.

According to the steps described above, the temporary wall portion 134 in the pixel unit 13 of the second embodiment can be removed without forming openings in the first wall portion 136. Accordingly, the steps for forming the wall-shaped structure portion 130 can be simplified. Moreover, the height of the pixel unit 13 of the second embodiment is further reduced by eliminating a closing film formed on the color filters 120. Accordingly, crosstalk between the pixels 12 can be reduced by the wall-shaped structure portion 130 without deteriorating the light collection property.

### (2.3. Modifications)

Modifications of the pixel unit 13 according to the present embodiment will be subsequently described with reference to FIGS. 29A to 30B. Each of FIGS. 29A to 29C is a vertical cross-sectional diagram explaining one step of a manufacturing method of the pixel unit 13 according to a first modification. Each of FIGS. 30A to 30B is a vertical cross-sectional diagram explaining one step of a manufacturing method of the pixel unit 13 according to a second modification.

### (First modification)

For example, as depicted in FIG. 29A, a wall portion protection film 138 may be further provided on the first wall portion 136 and the flattening film 121 after the step depicted in FIG. 28B. The wall portion protection film 138 includes an inorganic insulating material such as silicon oxide (SiOₓ), silicon nitride (SiN), or silicon oxynitride (SiON) and is provided along shapes of the first wall portion 136 and the flattening film 121. The wall portion protection film 138 can protect the first wall portion 136 which has strength lowered by the porous structure from a manufacturing process in the following stage.

Thereafter, as depicted in FIG. 29B, the color filters 120 are formed in the areas corresponding to the pixels 12. Specifically, an ultraviolet curing resin containing a pigment of red, green, or blue is applied to each of areas sandwiched by the wall portion protection film 138. Then, the ultraviolet curing resin is cured by ultraviolet light to form the color filters 120. The areas where the color filters 120 are formed are separated for each of the pixels 12 via the first wall portion 136 and the wall portion protection film 138. Accordingly, each of the color filters 120 can be formed in a more stable shape. The color arrangement of the color filters 120 provided for each of the pixels 12 may be a 2 × 2 Bayer array, a 3 × 3 Bayer array, or a 4 × 4 Bayer array. Further, as depicted in FIG. 29C, the on-chip lens 150 is formed on the color filter 120 and the wall portion protection film 138 for each of the pixels 12.

### (Second modification)

For example, as depicted in FIG. 30A, a filter protection film 151 may be further provided on the color filters 120 and the wall portion protection film 138 after the step depicted in FIG. 29B. The filter protection film 151 includes an inorganic insulating material such as silicon oxide (SiOₓ), silicon nitride (SiN), or silicon oxynitride (SiON) and is provided on the color filters 120 and the wall portion protection film 138. The filter protection film 151 can protect the color filters 120 from the manufacturing process in the following stage and flatten unevenness of the color filters 120 and the wall portion protection film 138. Thereafter, as depicted in FIG. 30B, the on-chip lens 150 is formed on the filter protection film 151 for each of the pixels 12.

<3. Third embodiment>

### (3.1. Configuration of pixel unit)

A configuration of the pixel unit 13 according to a third embodiment of the present disclosure will be further described with reference to FIG. 31. FIG. 31 is a vertical cross-sectional diagram depicting one example of a cross-sectional configuration of the pixel unit 13 according to the present embodiment.

As depicted in FIG. 31, each of the pixels 12 of the pixel unit 13 includes the photoelectric conversion unit 110, the flattening film 121, the color filter 120, the wall-shaped structure portion 130, the closing film 140, and the on-chip lens 150. Configurations of the photoelectric conversion unit 110, the flattening film 121, the color filter 120, and the on-chip lens 150 are substantially similar to the corresponding configurations described in the first embodiment, and therefore will not be repeatedly explained herein.

The wall-shaped structure portion 130 is a partition provided between the respective pixels 12 and has an external shape defined by the first wall portion 131 including an insulating material. Specifically, the wall-shaped structure portion 130 is defined by the first wall portion 131 which surrounds a side plane of a grid-shaped space between the pixels 12 planarly arranged in a matrix shape. Moreover, the first wall portion 131 is not provided on the upper plane of the wall-shaped structure portion 130 on the light receiving surface side. The opened upper plane of the first wall portion 131 is closed by the closing film 140 provided on the wall-shaped structure portion 130.

An internal space whose side plane and upper plane are surrounded respectively by the first wall portion 131 of the wall-shaped structure portion 130 and the closing film 140 constitutes the void 133 having a refractive index of approximately 1. Because the refractive index of the void 133 is considerably lower than the refractive index of the first wall portion 131, the wall-shaped structure portion 130 more easily satisfies conditions required for incident light to achieve total reflection on the interface between the void 133 and the first wall portion 131. Accordingly, the wall-shaped structure portion 130 is capable of more efficiently reflecting light entering the wall-shaped structure portion 130 on the interface between the void 133 and the first wall portion 131, and thus achieves more reduction of crosstalk caused by incident light coming over the wall-shaped structure portion 130 into the adjoining pixel 12.

The light shielding portion 135 may be provided in a lower portion of the void 133 inside the wall-shaped structure portion 130. For example, the light shielding portion 135 is provided as a single-layer film including titanium (Ti), titanium nitride (TiN), tantalum (Ta), or tantalum nitride (TaN), each of which is a light shielding material, or a laminated film of these materials. The light shielding portion 135 can achieve further reduction of crosstalk between the pixels 12 by shielding incident light passing between the pixels 12 from a lower portion of the wall-shaped structure portion 130.

The closing film 140 is continuously provided on the light receiving surface side of the color filters 120 and extends through the multiple pixels 12. For example, the closing film 140 includes an insulating material such as silicon oxide (SiOₓ), silicon nitride (SiN), or silicon oxynitride (SiON). The closing film 140 having a large film thickness and formed on the wall-shaped structure portion 130 and the color filters 120 by using a low coverage film forming method, such as CVD, is capable of closing the upper plane of the wall-shaped structure portion 130 (i.e., the opened upper plane of the first wall portion 131).

For example, the second wall portion 132 is formed by entrance of a material constituting the closing film 140 into an inner side surface of the first wall portion 131 at the time of formation of the closing film 140 closing the upper plane of the wall-shaped structure portion 130. The second wall portion 132 having a uniform thickness may be formed on the inner surface of the first wall portion 131 and on the upper surface of the light shielding portion 135.

According to the third embodiment, the upper plane of the first wall portion 131 is uniformly opened, and the opened upper plane of the first wall portion 131 is closed by the closing film 140. In this case, the void 133 can be more reliably formed between the color filters 120 without using openings (through holes) in the pixel unit 13 of the third embodiment. Accordingly, crosstalk caused between the pixels 12 in the pixel unit 13 of the third embodiment can be more reliably reduced by the wall-shaped structure portion 130.

### (3.2. Modifications)

Modifications of the pixel unit 13 according to the present embodiment will be described with reference to FIGS. 32 to 35. Each of FIGS. 32 to 35 is a vertical cross-sectional diagram explaining a modification of the pixel unit 13 according to the present embodiment.

As depicted in FIG. 32, the closing film 140 may have a smaller thickness than that in the case of the pixel unit 13 depicted in FIG. 31. For example, the closing film 140 has a large thickness to close the opened upper plane of the first wall portion 131. However, in a case where the closing film 140 has a larger thickness, the height of the pixel unit 13 increases. In this case, crosstalk between the pixels 12 is difficult to reduce. Accordingly, the thickness of the closing film 140 may be reduced by CMP.

Moreover, as depicted in FIG. 33, the first wall portion 131 may have a larger height than the color filters 120. Conversely, as depicted in FIG. 34, the first wall portion 131 may have a smaller height than the color filters 120.

As will be described below, the first wall portion 131 and the color filters 120 are simultaneously etched back when the upper surface of the first wall portion 131 is opened. Accordingly, heights of the first wall portion 131 and the color filters 120 may differ from each other depending on a difference between respective etching volumes during etching back. According to the pixel unit 13 of the present embodiment, the closing film 140 provided on the first wall portion 131 and the color filters 120 can absorb the height difference between the first wall portion 131 and the color filters 120. Accordingly, even in the foregoing case, the void 133 can be appropriately formed between the color filters 120 in the pixel unit 13 of the present embodiment.

In addition, as depicted in FIG. 35, widths of the respective color filters 120 (i.e., distances between the respective pixels 12) may differ from each other. Each distance between the pixels 12 is variable according to the arrangement of the pixels 12. For example, in a case where the pixels 12 are uniformly disposed in a matrix shape in an up-down direction and a left-right direction crossing each other at right angles, distances between the pixels 12 in each of the up-down direction and the left-right direction may be different from distances between the pixels in diagonal directions. Even in such a case, the void 133 can be formed between the color filters 120 in the pixel unit 13 of the present embodiment by appropriately controlling the formed film thickness of the closing film 140 provided on the first wall portion 131 and the color filters 120.

### (3.3. Manufacturing method)

A manufacturing method of the pixel unit 13 according to the present embodiment will be subsequently described with reference to FIGS. 36A to 36E. Each of FIGS. 36A to 36E is a vertical cross-sectional diagram explaining one step of the manufacturing method of the pixel unit 13 according to the present embodiment.

Initially, similarly to the first embodiment, the flattening film 121, the light shielding portion 135, the temporary wall portion 134, the first wall portion 131, and the color filters 120 are sequentially formed on the semiconductor layer 100 where the photoelectric conversion unit 110 is provided for each of the pixels 12 by the steps depicted in FIGS. 17 to 20.

Subsequently, as depicted in FIG. 36A, the first wall portion 131 and the color filters 120 are uniformly etched back by using dry etching, wet etching, CMP, or other methods. In this manner, the first wall portion 131 provided on the upper surface of the temporary wall portion 134 is removed to open the upper plane of the first wall portion 131 and thus expose the temporary wall portion 134.

Next, as depicted in FIG. 36B, the exposed temporary wall portion 134 is selectively removed. In a case where the temporary wall portion 134 includes AlCu, for example, the temporary wall portion 134 can be removed by wet etching using a mixed solution of phosphoric acid, hydrogen peroxide solution, and water. Alternatively, in a case where the temporary wall portion 134 includes a-Si, the temporary wall portion 134 can be removed by dry etching using SF₆ without bias.

Subsequently, as depicted in FIG. 36C, SiON having a large thickness is deposited on the first wall portion 131 and the color filters 120 by a low coverage film forming method, such as CVD, to form the closing film 140. The closing film 140 closes the opened upper plane of the first wall portion 131 to form the void 133.

Thereafter, as depicted in FIG. 36D, the thickness of the closing film 140 is reduced by CMP to such an extent that closure of the void 133 by the closing film 140 is not destroyed. Note that the thickness of the closing film 140 is not required to be reduced.

Further, as depicted in FIG. 36E, the on-chip lens 150 is formed on the closing film 140 for each of the pixels 12. In the manner described above, the pixel unit 13 according to the third embodiment is manufactured.

According to the steps described above, the forming step of the wall-shaped structure portion 130 including the void 133 in the pixel unit 13 of the third embodiment can be more simplified. Accordingly, crosstalk caused between the pixels 12 in the pixel unit 13 of the third embodiment can be reduced by the wall-shaped structure portion 130 produced at lower cost.

### <4. Fourth embodiment>

### (4.1. Configuration of pixel unit)

A configuration of the pixel unit 13 according to a fourth embodiment of the present disclosure will be subsequently described with reference to FIG. 37. FIG. 37 is a vertical cross-sectional diagram depicting one example of a cross-sectional configuration of the pixel unit 13 according to the present embodiment.

As depicted in FIG. 37, each of the pixels 12 of the pixel unit 13 includes the photoelectric conversion unit 110, the flattening film 121, the color filter 120, the wall-shaped structure portion 130, the closing film 140, and the on-chip lens 150. Configurations of the photoelectric conversion unit 110, the flattening film 121, the color filter 120, and the on-chip lens 150 are substantially similar to the corresponding configurations described in the first embodiment, and therefore will not be repeatedly explained herein.

The wall-shaped structure portion 130 is a partition provided between the respective pixels 12 and has an external shape defined by a first wall portion 139 including an insulating material. Specifically, the wall-shaped structure portion 130 is defined by the first wall portion 139 which surrounds a side plane of a grid-shaped space between the pixels 12 planarly arranged in a matrix shape. Moreover, the first wall portion 139 is not provided on the upper plane of the wall-shaped structure portion 130 on the light receiving surface side. The opened upper plane of the first wall portion 139 is closed by the closing film 140 provided on the wall-shaped structure portion 130.

An internal space whose side plane and upper plane are surrounded respectively by the first wall portion 139 of the wall-shaped structure portion 130 and the closing film 140 constitutes the void 133 having a refractive index of approximately 1. Because the refractive index of the void 133 is thus considerably lower than the refractive index of the first wall portion 139, the wall-shaped structure portion 130 more easily satisfies conditions required for incident light to achieve total reflection on an interface between the void 133 and the first wall portion 139. Accordingly, the wall-shaped structure portion 130 is capable of more efficiently reflecting light entering the wall-shaped structure portion 130 on the interface between the void 133 and the first wall portion 139, and thus achieves more reduction of crosstalk caused by incident light coming over the wall-shaped structure portion 130 into the adjoining pixel 12.

The first wall portion 139 includes an inorganic insulating material such as silicon oxide (SiOₓ), silicon nitride (SiN), or silicon oxynitride (SiON) and is provided on the side surfaces of the color filters 120. For example, the first wall portion 139 may include an insulating material either identical to or different from the insulating material of the flattening film 121.

The light shielding portion 135 may be provided in a lower portion of the void 133 inside the wall-shaped structure portion 130. For example, the light shielding portion 135 is provided as a single-layer film including titanium (Ti), titanium nitride (TiN), tantalum (Ta), or tantalum nitride (TaN), each of which is a light shielding material, or a laminated film of these materials. The light shielding portion 135 can achieve further reduction of crosstalk between the pixels 12 by shielding incident light passing between the pixels 12 from a lower portion of the wall-shaped structure portion 130.

The closing film 140 is continuously provided on the light receiving surface side of the color filters 120 and extends through the multiple pixels 12. For example, the closing film 140 includes an insulating material such as silicon oxide (SiOₓ), silicon nitride (SiN), or silicon oxynitride (SiON). The closing film 140 having a large film thickness and formed on the wall-shaped structure portion 130 and the color filters 120 by using a low coverage film forming method, such as CVD, is capable of closing the upper plane of the wall-shaped structure portion 130 (i.e., the opened upper plane of the first wall portion 139).

For example, the second wall portion 132 is formed by entrance of a material constituting the closing film 140 into an inner side surface of the first wall portion 139 at the time of formation of the closing film 140 closing the upper plane of the wall-shaped structure portion 130. The second wall portion 132 having a uniform thickness may be formed on the inner surface of the first wall portion 139 and on the upper surface of the light shielding portion 135.

According to the fourth embodiment, the upper plane of the first wall portion 139 is uniformly opened, and the opened upper plane of the first wall portion 139 is closed by the closing film 140. In this case, the void 133 can be more reliably formed between the color filters 120 without using openings (through holes) in the pixel unit 13 of the fourth embodiment. Accordingly, crosstalk caused between the pixels 12 in the pixel unit 13 of the fourth embodiment can be more reliably reduced by the wall-shaped structure portion 130.

### (4.2. Modifications)

Modifications of the pixel unit 13 according to the present embodiment will be described with reference to FIGS. 38 to 40. Each of FIGS. 38 to 40 is a vertical cross-sectional diagram explaining a modification of the pixel unit 13 according to the present embodiment.

As depicted in FIG. 38, the closing film 140 may have a smaller thickness than that in the case depicted in FIG. 37. For example, the closing film 140 has a large thickness to close the opened upper plane of the first wall portion 139. However, in a case where the closing film 140 has a large thickness, the height of the pixel unit 13 increases. In this case, crosstalk between the pixels 12 is difficult to reduce. Accordingly, the thickness of the closing film 140 may be reduced by CMP.

As depicted in FIG. 39, widths of the respective color filters 120 (i.e., distances between the respective pixels 12) may differ from each other. Each distance between the pixels 12 is variable according to the arrangement of the pixels 12. For example, in a case where the pixels 12 are uniformly disposed in a matrix shape in an up-down direction and a left-right direction crossing each other at right angles, distances between the pixels 12 in each of the up-down direction and the left-right direction can be mutually different from distances between the pixels in diagonal directions. Even in such a case, the void 133 can be formed between the color filters 120 in the pixel unit 13 of the present embodiment by appropriately controlling the formed film thickness of the closing film 140 provided on the first wall portion 139 and the color filters 120.

As depicted in FIG. 40, a configuration above the flattening film 121 (i.e., a light entering surface side) may be shifted in a light entering direction with respect to a configuration below the flattening film 121 (i.e., the side opposite to the light entering surface side). Such a shift is called pupil correction and applied to the pixels 12 provided in a region corresponding to a larger incident angle of light, such as a periphery of a pixel region.

Specifically, the centers of the on-chip lens 150, the closing film 140, the wall-shaped structure portion 130, and the color filter 120 may be shifted in the light entering direction with respect to the centers of the photoelectric conversion unit 110 and the flattening film 121. In such a case, the pixel unit 13 according to the present embodiment is capable of more efficiently introducing light entering at a larger incident angle into the photoelectric conversion units 110. Accordingly, the pixel unit 13 according to the present embodiment is capable of more efficiently introducing light into the photoelectric conversion units 110 even with the pixels 12 provided in the periphery of the pixel region.

The pupil correction described above can be performed not only for the pixel unit 13 of the fourth embodiment, but also for the pixel units 13 of the first to third embodiments, and the pixel unit 13 of a fifth embodiment described below in a similar manner. Specifically, in each of the pixel units 13 according to the first to third embodiments, and the fifth embodiment, the configuration above the flattening film 121 may be similarly shifted in the light entering direction with respect to the configuration below the flattening film 121.

### (4.3. Manufacturing method)

A manufacturing method of the pixel unit 13 according to the present embodiment will be subsequently described with reference to FIGS. 41A to 41G. Each of FIGS. 41A to 41G is a vertical cross-sectional diagram explaining one step of the manufacturing method of the pixel unit 13 according to the present embodiment.

Initially, similarly to the first embodiment, the flattening film 121, the light shielding portion 135, and the temporary wall portion 134 are sequentially formed on the semiconductor layer 100 where the photoelectric conversion unit 110 is provided for each of the pixels 12 by the steps depicted in FIGS. 17 and 18.

Next, as depicted in FIG. 41A, SiOₓ, SiN, SiON, or the like is deposited on the flattening film 121 and the temporary wall portion 134 by a high coverage film forming method to form the first wall portion 139 on the upper surface and the side surface of the temporary wall portion 134.

Subsequently, as depicted in FIG. 41B, the first wall portion 139 is uniformly etched back by using dry etching, wet etching, CMP, or other methods. Specifically, the first wall portion 139 provided on the flattening film 121, and the first wall portion 139 provided on the temporary wall portion 134 are removed by dry etching, wet etching, CMP, or other methods. In this manner, the first wall portion 139 provided on the upper surface of the temporary wall portion 134 is removed to open the upper surface of the first wall portion 139 and thus expose the temporary wall portion 134.

Next, as depicted in FIG. 41C, the exposed temporary wall portion 134 is selectively removed. In a case where the temporary wall portion 134 includes AlCu, for example, the temporary wall portion 134 can be removed by wet etching using a mixed solution of phosphoric acid, hydrogen peroxide solution, and water. Alternatively, in a case where the temporary wall portion 134 includes a-Si, the temporary wall portion 134 can be removed by dry etching using SF₆ without bias. In this manner, only the light shielding portion 135, and the first wall portion 139 extending in the normal direction of the surface of the flattening film 121 from both sides of the light shielding portion 135 are provided on the flattening film 121.

Subsequently, as depicted in FIG. 41D, the color filters 120 are formed in areas corresponding to the pixels 12. Specifically, an ultraviolet curing resin containing a pigment of red, green, or blue is applied to each of areas where the light shielding portion 135 and the first wall portion 139 are not provided. Then, the ultraviolet curing resin is cured by ultraviolet light to form the color filters 120. Each of the color filters 120 is formed in an area having a side surface defined by the temporary wall portion 134, and therefore is allowed to have a more stable shape. The color arrangement of the color filters 120 provided for each of the pixels 12 may be a 2 × 2 Bayer array, a 3 × 3 Bayer array, or a 4 × 4 Bayer array.

Subsequently, as depicted in FIG. 41E, SiON having a large thickness is deposited on the first wall portion 139 and the color filters 120 by a low coverage film forming method, such as CVD, to form the closing film 140. The closing film 140 thus formed closes the opened upper plane of the first wall portion 139 to form the void 133.

Thereafter, as depicted in FIG. 41F, the thickness of the closing film 140 is reduced by CMP to such an extent that closure of the void 133 by the closing film 140 is not destroyed. Note that the thickness of the closing film 140 is not required to be reduced.

Further, as depicted in FIG. 41G, the on-chip lens 150 is formed on the closing film 140 for each of the pixels 12. In the manner described above, the pixel unit 13 according to the fourth embodiment is manufactured.

According to the steps described above, the forming step of the wall-shaped structure portion 130 including the void 133 in the pixel unit 13 of the fourth embodiment can be more simplified. Accordingly, crosstalk caused between the pixels 12 in the pixel unit 13 of the fourth embodiment can be reduced by the wall-shaped structure portion 130 produced at lower cost.

### <5. Fifth embodiment>

### (5.1. Configuration of pixel unit)

A configuration of the pixel unit 13 according to the fifth embodiment of the present disclosure will be subsequently described with reference to FIG. 42. FIG. 42 is a vertical cross-sectional diagram depicting one example of a cross-sectional configuration of the pixel unit 13 according to the present embodiment.

As depicted in FIG. 42, each of the pixels 12 of the pixel unit 13 includes the photoelectric conversion unit 110, the flattening film 121, a stopper layer 122, the color filter 120, the wall-shaped structure portion 130, the filter protection film 151, the closing film 140, and the on-chip lens 150. Configurations of the photoelectric conversion unit 110, the flattening film 121, the color filter 120, and the on-chip lens 150 are substantially similar to the corresponding configurations described in the first embodiment, and therefore will not be repeatedly explained herein.

The stopper layer 122 includes an insulating material having an etching rate different from that of the color filters 120 and is provided on the flattening film 121. The stopper layer 122 reduces progress of etching up to a lower layer of the stopper layer 122 at the time of etching for separating the color filters 120 for each of the pixels 12.

The wall-shaped structure portion 130 includes a first wall portion 1312 and the void 133 and is provided in a space between the color filters 120 separated by etching.

For example, the first wall portion 1312 is formed by entrance of a material constituting the closing film 140 into the space between the color filters 120 at the time of formation of the closing film 140 for closing an upper plane of the space between the color filters 120. For example, the first wall portion 1312 can be provided on the side surfaces of the color filters 120 and on an upper surface of the stopper layer 122. The void 133 is formed by closure of the upper plane of the space between the color filters 120 with use of the closing film 140.

The void 133 has a refractive index of approximately 1, which is considerably lower than a refractive index of the first wall portion 1312. In this case, the wall-shaped structure portion 130 more easily satisfies conditions required for incident light to achieve total reflection on an interface between the void 133 and the first wall portion 1312. Accordingly, the wall-shaped structure portion 130 is capable of more efficiently reflecting light entering the wall-shaped structure portion 130 on the interface between the void 133 and the first wall portion 1312, and thus achieves more reduction of crosstalk caused by incident light coming over the wall-shaped structure portion 130 into the adjoining pixel 12.

The filter protection film 151 includes an inorganic insulating material such as silicon oxide (SiOₓ), silicon nitride (SiN), or silicon oxynitride (SiON) and is provided on the color filters 120. The filter protection film 151 is provided to protect the color filters 120 from a manufacturing process performed in the following stage. For example, the filter protection film 151 can protect the color filters 120 from a process for separating resist used in an etching step for the color filters 120.

The closing film 140 is continuously provided on the light receiving surface side of the filter protection film 151 and extends through the multiple pixels 12. For example, the closing film 140 includes an insulating material such as silicon oxide (SiOₓ), silicon nitride (SiN), or silicon oxynitride (SiON). The closing film 140 having a large thickness is formed on the filter protection film 151 by a low coverage film forming method, such as CVD, and therefore can close the upper plane of the space between the respective color filters 120.

Note that the void 133 provided between the color filters 120 may have various sizes for each of the pixels 12. The size of the void 133 between the color filters 120 is described with reference to FIGS. 43, 44A, and 44B. FIG. 43 is a plan diagram depicting a planar configuration of the pixel unit 13 according to the fifth embodiment. FIG. 44A is a vertical cross-sectional diagram depicting a cross-sectional configuration taken along a cutting plane A-AA in FIG. 43, while FIG. 44B is a vertical cross-sectional diagram depicting a cross-sectional configuration taken along a cutting plane B-BB in FIG. 43.

For example, as depicted in FIG. 43, the pixel unit 13 may have the pixels 12 including red pixels 12R, green pixels 12G, and blue pixels 12B and planarly arranged in a matrix shape.

As depicted in FIG. 44A, spaces between the color filters 120 included in the pixels 12 arrayed in a matrix shape and located in diagonal directions are relatively wide. In this case, the closing film 140 is easily embedded in these spaces, and the first wall portion 1312 to be formed easily has a large thickness. On the other hand, as depicted in FIG. 44B, spaces between the color filters 120 included in the pixels 12 arrayed in a matrix shape and located in row directions or column directions are relatively narrow. In this case, these spaces are easily closed by the closing film 140, and the first wall portion 1312 to be formed easily has a smaller thickness. Accordingly, a void 133A included in the pixels 12 and formed in a space between the color filters 120 located in a diagonal direction can be made smaller than a void 133B included in the pixels 12 and formed in a space between the color filters 120 located in a row direction or a column direction.

According to the fifth embodiment, the closing film 140 closes the upper plane of the space between the color filters 120 separated from each other for each of the pixels 12 by etching. Accordingly, the pixel unit 13 of the fifth embodiment is capable of stabilizing the shape of the color filters 120 by a more simplified method. Moreover, crosstalk caused between the pixels 12 in the pixel unit 13 of the fifth embodiment can be reduced by the void 133 formed between the color filters 120.

### (5.2. Manufacturing method)

A manufacturing method of the pixel unit 13 according to the present embodiment will be subsequently described with reference to FIGS. 45A to 45F. Each of FIGS. 45A to 45F is a vertical cross-sectional diagram explaining one step of the manufacturing method of the pixel unit 13 according to the present embodiment.

Initially, as depicted in FIG. 45A, the flattening film 121 is formed on the semiconductor layer 100 where the photoelectric conversion unit 110 is provided for each of the pixels 12. Thereafter, the stopper layer 122 is sequentially formed on the flattening film 121. For example, the stopper layer 122 may include SiN or SiON having an etching rate different from that of the color filters 120 and is provided on the flattening film 121 with a film thickness in a range of 10 to 15 nm.

Next, as depicted in FIG. 45B, the color filters 120 are formed in areas corresponding to the pixels 12. Specifically, an ultraviolet curing resin containing a pigment of red, green, or blue is applied to each of the areas corresponding to the pixels 12. Then, the ultraviolet curing resin is cured by ultraviolet light to form the color filters 120. The color filters 120 are patterned for each of the pixels 12 by an etching process in the following stage. Accordingly, the areas where the color filters 120 are provided are only required to roughly coincide with the areas corresponding to the pixels 12.

Subsequently, as depicted in FIG. 45C, the filter protection film 151 and the resist layer 161 are formed on the color filters 120. Specifically, SiON is initially deposited on the color filters 120 to form the filter protection film 151. Thereafter, the resist layer 161 is formed on the filter protection film 151. The resist layer 161 includes an ordinary photoresist material and is patterned by photolithography such that areas forming openings 123 are opened in the following step.

Subsequently, as depicted in FIG. 45D, the openings 123 are formed in areas corresponding to the areas between the pixels 12 by etching the filter protection film 151 and the color filters 120 with use of the resist layer 161 as a mask. Note that the stopper layer 122 having an etching rate different from that of the color filters 120 is provided below the color filters 120. Accordingly, etching of the color filters 120 is stopped at the surface of the stopper layer 122.

Subsequently, as depicted in FIG. 45E, the resist layer 161 is removed, and then SiON having a large thickness is deposited on the filter protection film 151 by a low coverage film forming method, such as CVD, to form the closing film 140. In this manner, the upper plane of the space between the color filters 120 is closed by the closing film 140. As a result, the void 133 is formed in the space between the color filters 120.

Thereafter, as depicted in FIG. 45F, the closing film 140 is thinned and flattened by CMP, and then the on-chip lens 150 is formed on the closing film 140 for each of the pixels 12. In this manner, the pixel unit 13 according to the fifth embodiment is manufactured.

According to the steps described above, the respective color filters 120 of the pixel unit 13 according to the fifth embodiment can be separated for each of the pixels 12 by etching. Accordingly, the shape of the color filters 120 can be more easily stabilized. Moreover, crosstalk caused between the pixels 12 in the pixel unit 13 of the fifth embodiment can be reduced by the void 133 formed between the respective color filters 120.

### <6. Sixth embodiment>

### (6.1. Configuration of pixel unit)

A configuration of the pixel unit 13 according to a sixth embodiment of the present disclosure will be subsequently described with reference to FIG. 46. FIG. 46 is a vertical cross-sectional diagram depicting a cross-sectional configuration of the wall-shaped structure portion 130 included in the pixel unit 13 according to the present embodiment.

As depicted in FIG. 46, the wall-shaped structure portion 130 provided between the color filters 120 is produced by the first wall portion 131 including an insulating material and surrounding the side plane of the space between the color filters 120 and the upper plane of the light receiving surface side. An inner space surrounded by the first wall portion 131 corresponds to the void 133 in a vacuum state and having a refractive index of approximately 1 by closing the openings 137 provided in a partial region of the upper surface of the first wall portion 131 with use of the closing film 140.

Moreover, the light shielding portion 135 is provided in the inner space surrounded by the first wall portion 131. For example, the light shielding portion 135 is provided as a single-layer film including titanium (Ti), titanium nitride (TiN), tantalum (Ta), or tantalum nitride (TaN), each of which is a light shielding material, or a laminated film of these materials. The light shielding portion 135 can achieve reduction of crosstalk between the pixels 12 by shielding incident light passing between the pixels 12 from a lower portion of the wall-shaped structure portion 130.

According to the wall-shaped structure portion 130 of the present embodiment herein, a lower end of the color filter 120 is provided so as to be located below a lower end of the void 133. Note that the lower end of the void 133 is a lower end of a space in a vacuum state in the inner space surrounded by the first wall portion 131 and corresponds to an upper surface of the light shielding portion 135 in FIG. 46. Meanwhile, in a case where the light shielding portion 135 is not provided, the lower end of the void 133 corresponds to an upper surface of the flattening film 121 in the inner space surrounded by the first wall portion 131.

A positional relation between each lower end of the color filters 120 and the lower end of the void 133 influences stress applied to the first wall portion 131 on the side plane of the void 133. Specifically, in a case where each lower end of the color filters 120 is located above the lower end of the void 133, structurally large tensile stress acts on an area around an interface between each lower end of the color filters 120 and the flattening film 121 in the side surface of the first wall portion 131. In such a case, a possibility of crack generation increases in the first wall portion 131 on the side surface side.

According to the wall-shaped structure portion 130 of the present embodiment, each lower end of the color filters 120 is located below the lower end of the void 133. This configuration can reduce the influence imposed on the first wall portion 131 by the tensile stress applied to the interface between each lower end of the color filters 120 and the flattening film 121. In this case, the wall-shaped structure portion 130 can lower the magnitude of the tensile stress acting on the first wall portion 131 on the side surface of the void 133. Accordingly, the possibility of crack generation in the first wall portion 131 on the side surface side can be lowered.

### (6.2. Modifications)

First to third modifications of the wall-shaped structure portion 130 will be described with reference to FIG. 47 and other figures. Each of the first to third modifications of the wall-shaped structure portion 130 is a modification for further reducing the possibility of crack generation in the first wall portion 131 on the side surface side.

FIG. 47 is a vertical cross-sectional diagram depicting the first modification of the wall-shaped structure portion 130. As depicted in FIG. 47, a lower part of the side surface of the first wall portion 131 may have a larger width than that of an upper part of the side surface of the first wall portion 131. The tensile stress acting on the first wall portion 131 on the side surface side is higher chiefly for the lower part. Accordingly, by providing a larger width for the lower part of the side surface of the first wall portion 131 than that for the upper part, stress tolerance of the first wall portion 131 on the side surface side can be more efficiently raised. As a result, the wall-shaped structure portion 130 thus configured can further lower the possibility of crack generation in the structure including the void 133.

According to the second modification of the wall-shaped structure portion 130, the light shielding portion 135 may include a light shielding material having lower rigidity than that of Ti, TiN, Ta, or TaN described above. Specifically, the light shielding portion 135 of the wall-shaped structure portion 130 may include a metal material having a light shielding property, such as copper (Cu) and aluminum (Al). The light shielding portion 135 including a metal material having low rigidity is deformable by itself, and therefore can prevent excessive tensile stress acting on the first wall portion 131 on the side surface side. Accordingly, the wall-shaped structure portion 130 thus configured can further lower the possibility of crack generation in the first wall portion 131 on the side surface side.

According to the third modification of the wall-shaped structure portion 130, each of the color filters 120 may include a light curing resin containing a pigment presenting red, green, or blue. Each of the color filters 120 including a light curing resin less subjected to an influence of heat expansion or heat shrink than a thermosetting resin can reduce stress generated by heat expansion or heat shrink. In this case, the wall-shaped structure portion 130 can lower the magnitude of the tensile stress acting on the first wall portion 131 on the side surface side. Accordingly, the wall-shaped structure portion 130 can further lower the possibility of crack generation in the first wall portion 131 on the side surface side.

### (6.3. Manufacturing method)

A manufacturing method of the pixel unit 13 according to the present embodiment will be subsequently described with reference to FIG. 48. FIG. 48 is a vertical cross-sectional diagram explaining one step of the manufacturing method of the pixel unit 13 according to the present embodiment.

Initially, similarly to the first embodiment, the flattening film 121, the light shielding portion 135, and the temporary wall portion 134 are sequentially formed on the semiconductor layer 100 where the photoelectric conversion unit 110 is provided for each of the pixels 12 by the steps depicted in FIGS. 17 to 18.

Subsequently, as depicted in FIG. 48, a mask 163 including SiOₓ or the like is provided on the upper surface of the temporary wall portion 134, and then the entire surface of the flattening film 121 is etched. As a result, an upper surface of the flattening film 121 in areas where the color filters 120 will be provided in the following stage comes to be located lower than the upper surface of the light shielding portion 135 covered with the temporary wall portion 134.

Thereafter, similarly to the first embodiment, the first wall portion 131 and the color filters 120 are formed by the steps depicted in FIGS. 19 to 26, and then the temporary wall portion 134 is removed by etching performed via the openings 137. Moreover, the closing film 140 and the on-chip lenses 150 are provided on the color filters 120 and the wall-shaped structure portion 130 to manufacture the pixel unit 13 according to the sixth embodiment.

According to the steps described above, the pixel unit 13 of the sixth embodiment can lower the magnitude of the tensile stress acting on the first wall portion 131 on the side surface side by controlling the respective positions of the lower ends of the color filters 120 and the void 133. Accordingly, the pixel unit 13 of the sixth embodiment can further lower the possibility of crack generation in the first wall portion 131 on the side surface side.

### <7. Seventh embodiment>

### (7.1. Configuration of pixel unit)

A configuration of the pixel unit 13 according to a seventh embodiment of the present disclosure will be subsequently described with reference to FIGS. 49 and 50. FIG. 49 is a vertical cross-sectional diagram depicting one example of a cross-sectional configuration of the pixel unit 13 of the present embodiment, while FIG. 50 is a plan diagram depicting a planar configuration of the pixel unit 13 of the present embodiment. For example, FIG. 49 corresponds to a cross section of FIG. 50 in a diagonal direction.

As depicted in FIG. 49, each of the pixels 12 of the pixel unit 13 includes the photoelectric conversion unit 110, the flattening film 121, the color filter 120, the wall-shaped structure portion 130, the closing film 140, and the on-chip lens 150. Configurations of the photoelectric conversion unit 110, the flattening film 121, the color filter 120, the closing film 140, and the on-chip lens 150 are substantially similar to the configurations described in the first embodiment, and therefore will not be repeated herein.

The wall-shaped structure portion 130 is a partition provided between the respective pixels 12 and has an external shape defined by a first wall portion 131 including an insulating material. The light shielding portion 135 having a light shielding property is provided in a lower part of the void 133 inside the wall-shaped structure portion 130, while the upper plane of the wall-shaped structure portion 130 (i.e., the opened upper plane of the first wall portion 131) is closed by the closing film 140. An internal space whose side plane is surrounded by the first wall portion 131 of the wall-shaped structure portion 130 constitutes the void 133 having a refractive index of approximately 1.

According to the seventh embodiment, the wall-shaped structure portion 130 is configured such that a vertically central portion of the void 133 has a larger width than that of an upper portion and a lower portion of the void 133. Specifically, the wall-shaped structure portion 130 is provided such that the void 133 has a barrel-shaped vertical cross-sectional shape. The wall-shaped structure portion 130 thus configured can be formed by the first wall portion 131 configured to have tensile stress. For example, the first wall portion 131 may include silicon oxide (SiOₓ) formed by multiple cycles of ALD (Atomic Layer Deposition). In this case, the first wall portion 131 constituting a film having tensile stress can be formed by changing a film forming condition (e.g., RF output or pressure) for each cycle.

Moreover, as depicted in FIG. 50, tensile stress acts also in an in-plane direction of the film of the first wall portion 131 thus configured. In this case, the first wall portion 131 constitutes a film having tensile stress also in a planar direction. Accordingly, the wall-shaped structure portion 130 including the void 133 can also have a barrel shape in a plane. In such a case, each of the pixels 12 (red pixel 12R, green pixel 12G, and blue pixel 12B) may have a quadrangular planar shape having sides each curved toward the inside.

According to the seventh embodiment, the wall-shaped structure portion 130 which includes the barrel-shaped void 133 formed by the first wall portion 131 having tensile stress can further increase structural strength of the void 133. Accordingly, the pixel unit 13 of the seventh embodiment can reduce an increase in crosstalk caused between the pixels 12 by reducing crush of the void 133.

### (7.2. Modifications)

First and second modifications of the pixel unit 13 according to the present embodiment will be subsequently described with reference to FIGS. 51 and 52.

FIG. 51 is a vertical cross-sectional diagram explaining the first modification of the pixel unit 13 according to the present embodiment. As depicted in FIG. 51, the first wall portion 131 may include a laminated film formed by laminating two different films. Specifically, the first wall portion 131 may include a laminated film formed by sequentially laminating an SiOₓ film 131A and an SiN film 131B from the void 133 side. The SiOₓ film 131A is a silicon oxide film formed by ALD, while the SiN film 131B is a silicon nitride film formed by plasma CVD. The first wall portion 131 can be formed such that the two layers of the SiOₓ film 131A and the SiN film 131B have tensile stress as a whole.

FIG. 52 is a vertical cross-sectional diagram explaining the second modification of the pixel unit 13 according to the present embodiment. As depicted in FIG. 52, the first wall portion 131 may include a laminated film formed by laminating three different films. Specifically, the first wall portion 131 may include a laminated film formed by sequentially laminating the SiOₓ film 131A, the SiN film 131B, and a TiN film 131C from the void 133 side. The SiOₓ film 131A is a silicon oxide film formed by ALD, the SiN film 131B is a silicon nitride film formed by plasma CVD, and the TiN film 131C is a titanium nitride film formed by sputtering. The first wall portion 131 can be formed such that the three layers of the SiOₓ film 131A, the SiN film 131B, and the TiN film 131C have tensile stress as a whole.

As described in the first and second modifications, the first wall portion 131 as a laminated film can also constitute a film having tensile stress. In this case, the void 133 surrounded by the first wall portion 131 has a barrel shape formed such that the vertically central part has a larger width than that of the upper part and the lower part. Accordingly, the wall-shaped structure portion 130 can further raise structural strength of the void 133. As a result, the pixel unit 13 can reduce an increase in crosstalk caused between the pixels 12 by reducing crush of the void 133.

### <8. Eighth embodiment>

### (8.1. Configuration of pixel unit)

First to sixth configuration examples of the pixel unit 13 according to an eighth embodiment of the present disclosure will be subsequently described with reference to FIG. 53A to 58B. The pixel unit 13 according to the present embodiment further includes a support or a partition inside the void 133 for supporting the first wall portion 131. According to this configuration, the pixel unit 13 of the present embodiment can increase strength of the wall-shaped structure portion 130, and therefore can reduce an increase in crosstalk caused between the pixels 12 by reducing crush of the void 133.

FIG. 53A is a vertical cross-sectional diagram depicting a cross section of the first configuration example of the pixel unit 13, while FIG. 53B is a plan diagram depicting a plane of the first configuration example of the pixel unit 13. According to the first configuration example, a partition 125 is provided inside the void 133 to divide the void 133 into two spaces as depicted in FIGS. 53A and 53B.

Specifically, the partition 125 is provided so as to extend in the horizontal direction and divide the void 133 into two upper and lower spaces. For example, the partition 125 may include an insulating material such as silicon oxide (SiOₓ), silicon nitride (SiN), or silicon oxynitride (SiON).

Note that each of the openings 137 provided in the first wall portion 131 of the upper surface of the wall-shaped structure portion 130 penetrates the partition 125 to connect the upper space and the lower space of the void 133 divided by the partition 125. According to this configuration, even in a case where the inside of the wall-shaped structure portion 130 is divided into multiple spaces, the void 133 can be formed in all of the multiple spaces.

FIG. 54A is a vertical cross-sectional diagram depicting a cross section of the second configuration example of the pixel unit 13, while FIG. 54B is a plan diagram depicting a plane of the second configuration example of the pixel unit 13. According to the second configuration example, a support 126 is provided inside the void 133 to support the first wall portion 131 of the upper surface as depicted in FIGS. 54A and 54B.

Specifically, the support 126 is provided so as to extend in the up-down direction between the first wall portion 131 of the upper surface and the light shielding portion 135 to support the first wall portion 131 of the upper surface. For example, the support 126 may include an insulating material such as silicon oxide (SiOₓ), silicon nitride (SiN), or silicon oxynitride (SiON). Moreover, a cross section of the support 126 in the in-plane direction may have a circular shape, or a polygonal shape such as a triangular shape and a quadrangular shape.

Note that each of the openings 137 formed in the first wall portion 131 of the upper surface of the wall-shaped structure portion 130 may be located at a planar position shifted from the support 126. In this manner, the wall-shaped structure portion 130 can be configured to prevent interference between the openings 137 and the support 126.

FIG. 55A is a vertical cross-sectional diagram depicting a cross section of the third configuration example of the pixel unit 13, while FIG. 55B is a plan diagram depicting a plane of the third configuration example of the pixel unit 13. According to the third configuration example, the multiple partitions 125 are provided inside the void 133 to divide the void 133 into three spaces as depicted in FIGS. 55A and 55B.

Specifically, the multiple partitions 125 are provided so as to extend in the horizontal direction and divide the void 133 into three spaces separated in the up-down direction. For example, each of the multiple partitions 125 may include an insulating material such as silicon oxide (SiOₓ), silicon nitride (SiN), or silicon oxynitride (SiON). The multiple partitions 125 thus provided can further increase the strength of the wall-shaped structure portion 130.

Note that each of the openings 137 provided in the first wall portion 131 of the upper surface of the wall-shaped structure portion 130 penetrates the respective two partitions 125 to connect the three spaces of the void 133 divided by the multiple partitions 125. According to this configuration, even in a case where the inside of the wall-shaped structure portion 130 is divided into multiple spaces, the void 133 can be formed in all of the multiple spaces of the wall-shaped structure portion 130.

FIG. 56A is a vertical cross-sectional diagram depicting a cross section of the fourth configuration example of the pixel unit 13, while FIG. 56B is a plan diagram depicting a plane of the fourth configuration example of the pixel unit 13. According to the fourth configuration example, the partition 125 is provided inside the void 133 to support the first wall portion 131 of the upper surface and divide the void 133 into multiple spaces in a planar direction as depicted in FIGS. 56A and 56B.

Specifically, the partition 125 is provided so as to extend in the up-down direction between the first wall portion 131 of the upper surface and the light shielding portion 135 and divide the wall-shaped structure portion 130 between the pixels 12 into two parts in the left-right direction. For example, the partition 125 may include an insulating material such as silicon oxide (SiOₓ), silicon nitride (SiN), or silicon oxynitride (SiON).

Note that the opening 137 formed in the first wall portion 131 of the upper surface of the wall-shaped structure portion 130 is provided for each of the multiple spaces of the void 133 divided by the partition 125. According to this configuration, even in a case where the inside of the wall-shaped structure portion 130 is divided into multiple spaces, the void 133 can be formed in all of the multiple spaces of the wall-shaped structure portion 130.

FIG. 57A is a vertical cross-sectional diagram depicting a cross section of the fifth configuration example of the pixel unit 13, while FIG. 57B is a plan diagram depicting a plane of the fifth configuration example of the pixel unit 13. According to the fifth configuration example, two partitions 125A and 125B are provided inside the void 133 to divide the void 133 into four spaces as depicted in FIGS. 57A and 57B.

Specifically, the partition 125A is provided so as to extend in the horizontal direction and divide the void 133 into two upper and lower spaces. The partition 125B is provided so as to extend in the up-down direction between the first wall portion 131 of the upper surface and the light shielding portion 135 and divide the wall-shaped structure portion 130 between the pixels 12 into two parts in the left-right direction. For example, each of the partitions 125A and 125B may include an insulating material such as silicon oxide (SiOₓ), silicon nitride (SiN), or silicon oxynitride (SiON). The partitions 125A and 125B thus provided can further increase the strength of the wall-shaped structure portion 130.

Note that each of the openings 137 provided in the first wall portion 131 of the upper surface of the wall-shaped structure portion 130 penetrates the partition 125A to connect the two spaces of the void 133 divided by the partition 125A. The opening 137 provided in the first wall portion 131 of the upper surface of the wall-shaped structure portion 130 is provided for each of the multiple spaces of the void 133 separated by the partition 125B. According to this configuration, even in a case where the inside of the wall-shaped structure portion 130 is divided into multiple spaces, the void 133 can be formed in all of the multiple spaces of the wall-shaped structure portion 130.

FIG. 58A is a vertical cross-sectional diagram depicting a cross section of the sixth configuration example of the pixel unit 13, while FIG. 58B is a plan diagram depicting a plane of the sixth configuration example of the pixel unit 13. According to the sixth configuration example, the multiple partitions 125 are provided inside the void 133 to support the first wall portion 131 of the upper surface and divide the void 133 into multiple spaces in an in-plane direction as depicted in FIGS. 58A and 58B.

Specifically, the multiple partitions 125 are provided so as to extend in the up-down direction between the first wall portion 131 of the upper surface and the light shielding portion 135 and divide the wall-shaped structure portion 130 between the pixels 12 into three parts in the left-right direction. For example, each of the multiple partitions 125 may include an insulating material such as silicon oxide (SiOₓ), silicon nitride (SiN), or silicon oxynitride (SiON). The multiple partitions 125 thus provided can further increase the strength of the wall-shaped structure portion 130.

Note that the opening 137 formed in the first wall portion 131 of the upper surface of the wall-shaped structure portion 130 is provided for each of the multiple spaces of the void 133 separated by the multiple partitions 125. According to this configuration, even in a case where the inside of the wall-shaped structure portion 130 is divided into multiple spaces, the void 133 can be formed in all of the multiple spaces of the wall-shaped structure portion 130.

According to the eighth embodiment, the wall-shaped structure portion 130 which includes the partition 125 or the support 126 inside the void 133 can further increase the strength of the first wall portion 131 constituting the void 133. Accordingly, the pixel unit 13 of the eighth embodiment can reduce an increase in crosstalk caused between the pixels 12 by reducing crush of the void 133.

### (8.2. Manufacturing method)

A manufacturing method of the first configuration example of the pixel unit 13 according to the present embodiment will be described with reference to FIGS. 59A to 59F. Each of FIGS. 59A to 59F is a vertical cross-sectional diagram explaining the manufacturing method of the first configuration example of the pixel unit 13 according to the present embodiment.

Initially, as depicted in FIG. 59A, the flattening film 121 is formed on the semiconductor layer 100 where the photoelectric conversion unit 110 is provided for each of the pixels 12. Thereafter, the light shielding portion 135, a first temporary wall portion 134A, the partition 125, and a second temporary wall portion 134B are sequentially formed on the flattening film 121. The mask 163 opened in areas corresponding to the pixels 12 is formed on the second temporary wall portion 134B. Each of the first temporary wall portion 134A and the second temporary wall portion 134B is a layer which will be removed by wet etching or dry etching to form the void 133 in the following step and includes aluminum containing copper (AlCu) or amorphous silicon (a-Si).

Subsequently, as depicted in FIG. 59B, the first temporary wall portion 134A, the partition 125, and the second temporary wall portion 134B in the areas corresponding to the pixels 12 are removed by photolithography or other methods. As a result, areas where the color filters 120 will be formed in the following step are opened, and the first temporary wall portion 134A, the partition 125, and the second temporary wall portion 134B in a region other than the grid-shaped region between the pixels 12 are removed from the upper part of the flattening film 121.

Next, as depicted in FIG. 59C, SiOₓ is deposited on the flattening film 121 and the second temporary wall portion 134B by a high coverage film forming method to form the first wall portion 131 on an upper surface and a side surface of each of the first temporary wall portion 134A, the partition 125, and the second temporary wall portion 134B.

Subsequently, as depicted in FIG. 59D, the color filters 120 are formed in the areas from which the first temporary wall portion 134A, the partition 125, and the second temporary wall portion 134B have been removed. Thereafter, SiON is deposited on the color filters 120 and the first wall portion 131 to form the cap layer 141.

Next, as depicted in FIG. 59E, a part of the cap layer 141 is etched to form the openings 137. Each of the openings 137 is provided so as to penetrate the partition 125 to expose the first temporary wall portion 134A and the second temporary wall portion B.

Subsequently, as depicted in FIG. 59F, the first temporary wall portion 134A and the second temporary wall portion 134B are removed by wet etching or dry etching performed via the openings 137 to form the void 133. In a case where each of the first temporary wall portion 134A and the second temporary wall portion 134B includes a-Si, for example, a tetramethylammonium hydroxide (TMAH) solution or the like is introduced into the first wall portion 131 to selectively remove the first temporary wall portion 134A and the second temporary wall portion 134B. Alternatively, in a case where each of the first temporary wall portion 134A and the second temporary wall portion 134B includes AlCu, a mixed solution of phosphoric acid, hydrogen peroxide solution, and water is introduced into the first wall portion 131 to selectively remove the first temporary wall portion 134A and the second temporary wall portion 134B.

Thereafter, similarly to the first embodiment, the closing film 140 and the on-chip lenses 150 are formed by the steps depicted in FIGS. 25 and 26 to manufacture the first configuration example of the pixel unit 13 according to the eighth embodiment.

Further, a manufacturing method of the fourth configuration example of the pixel unit 13 according to the present embodiment will be described with reference to FIGS. 60A to 60D. Each of FIGS. 60A to 60D is a vertical cross-sectional diagram explaining the manufacturing method of the fourth configuration example of the pixel unit 13 according to the present embodiment.

Initially, as depicted in FIG. 60A, the flattening film 121 is formed on the semiconductor layer 100 where the photoelectric conversion unit 110 is provided for each of the pixels 12. Thereafter, the light shielding portion 135 and the temporary wall portion 134 are sequentially formed on the flattening film 121. The temporary wall portion 134 is a layer which will be removed by wet etching or dry etching to form the void 133 in the following step and includes aluminum containing copper (AlCu) or amorphous silicon (a-Si).

Moreover, photolithography or the like is performed with use of the mask 163 opened in areas corresponding to the pixels 12 and a region where the partition 125 is formed to remove the temporary wall portion 134 in a region corresponding to the openings of the mask 163. As a result, the temporary wall portion 134 in a region other than the grid-shaped region between the pixels 12 is removed from the upper part of the flattening film 121. Moreover, a slit for forming the partition 125 is formed in the temporary wall portion 134 so as to divide the temporary wall portion 134 into two parts.

Subsequently, as depicted in FIG. 60B, SiOₓ is deposited on the flattening film 121 and the temporary wall portion 134 by a high coverage film forming method to form the first wall portion 131 on an upper surface and a side surface. Further, SiOₓ is embedded in the slit formed in the temporary wall portion 134 to provide the partition 125.

Next, as depicted in FIG. 60C, the color filters 120 are formed in the areas corresponding to the pixels 12 by photolithography or other methods. Thereafter, SiON is deposited on the color filters 120 and the first wall portion 131 to form the cap layer 141.

Subsequently, as depicted in FIG. 60D, a part of the cap layer 141 is etched to form the openings 137. The temporary wall portion 134 is removed by wet etching or dry etching performed via the openings 137 to form the void 133. In a case where the temporary wall portion 134 includes a-Si, for example, a tetramethylammonium hydroxide (TMAH) solution or the like is introduced into the first wall portion 131 to selectively remove the temporary wall portion 134. Alternatively, in a case where the temporary wall portion 134 includes AlCu, a mixed solution of phosphoric acid, hydrogen peroxide solution, and water is introduced into the first wall portion 131 to selectively remove the temporary wall portion 134.

Thereafter, similarly to the first embodiment, the closing film 140 and the on-chip lenses 150 are formed by the steps depicted in FIGS. 25 and 26 to manufacture the second configuration example of the pixel unit 13 according to the eighth embodiment.

Further, a manufacturing method of the fifth configuration example of the pixel unit 13 according to the present embodiment will be described with reference to FIGS. 61A to 61E. Each of FIGS. 61A to 61E is a vertical cross-sectional diagram explaining the manufacturing method of the fifth configuration example of the pixel unit 13 according to the present embodiment.

Initially, as depicted in FIG. 61A, the flattening film 121 is formed on the semiconductor layer 100 where the photoelectric conversion unit 110 is provided for each of the pixels 12. Thereafter, the light shielding portion 135, the first temporary wall portion 134A, the partition 125A, and the second temporary wall portion 134B are sequentially formed on the flattening film 121. Each of the first temporary wall portion 134A and the second temporary wall portion 134B is a layer which will be removed by wet etching or dry etching to form the void 133 in the following step and includes aluminum containing copper (AlCu) or amorphous silicon (a-Si).

Moreover, photolithography or the like is performed with use of the mask 163 opened in areas corresponding to the pixels 12 and a region where the partition 125B is formed to remove the first temporary wall portion 134A, the partition 125A, and the second temporary wall portion 134B in a region corresponding to the openings of the mask 163. As a result, the first temporary wall portion 134A, the partition 125A, and the second temporary wall portion 134B in a region other than the grid-shaped region between the pixels 12 are removed from the upper part of the flattening film 121. Moreover, a slit for forming the partition 125B is formed in each of the first temporary wall portion 134A and the second temporary wall portion 134B so as to divide each of the first temporary wall portion 134A and the second temporary wall portion 134B into two parts.

Subsequently, as depicted in FIG. 61B, SiOₓ is deposited on the flattening film 121 and the temporary wall portion 134 by a high coverage film forming method to form the first wall portion 131 on an upper surface and a side surface of each of the first temporary wall portion 134A, the partition 125A, and the second temporary wall portion 134B. Further, SiOₓ is embedded in the slits formed in the first temporary wall portion 134A and the second temporary wall portion 134B to form the partition 125B.

Next, as depicted in FIG. 61C, the color filters 120 are formed in the areas from which the first temporary wall portion 134A, the partition 125A, and the second temporary wall portion 134B have been removed. Thereafter, SiON is deposited on the color filters 120 and the first wall portion 131 to form the cap layer 141.

Subsequently, as depicted in FIG. 61D, a part of the cap layer 141 is etched to form the openings 137. Each of the openings 137 is provided so as to penetrate the partition 125A to expose the first temporary wall portion 134A and the second temporary wall portion B.

Next, as depicted in FIG. 61E, the first temporary wall portion 134A and the second temporary wall portion 134B are removed by wet etching or dry etching performed via the openings 137 to form the void 133. In a case where each of the first temporary wall portion 134A and the second temporary wall portion 134B includes a-Si, for example, a tetramethylammonium hydroxide (TMAH) solution or the like is introduced into the first wall portion 131 to selectively remove the first temporary wall portion 134A and the second temporary wall portion 134B. Alternatively, in a case where each of the first temporary wall portion 134A and the second temporary wall portion 134B includes AlCu, a mixed solution of phosphoric acid, hydrogen peroxide solution, and water is introduced into the first wall portion 131 to selectively remove the first temporary wall portion 134A and the second temporary wall portion 134B.

Thereafter, similarly to the first embodiment, the closing film 140 and the on-chip lenses 150 are formed by the steps depicted in FIGS. 25 and 26 to manufacture the third configuration example of the pixel unit 13 according to the eighth embodiment.

According to the steps described above, the partition 125 or the support 126 is can be formed inside the void 133 surrounded by the first wall portion 131 in the pixel unit 13 of the eighth embodiment. Accordingly, the pixel unit 13 of the eighth embodiment can further increase strength of the wall-shaped structure portion 130, and therefore can reduce an increase in crosstalk caused between the pixels 12 by reducing crush of the void 133.

### <9. Electronic apparatus>

An electronic apparatus including the imaging device 1 according to the present embodiment will be subsequently described with reference to FIG. 62. FIG. 62 is a block diagram depicting a configuration example of an electronic apparatus 1000 including the imaging device 1 according to the present embodiment. For example, the electronic apparatus 1000 is an electronic apparatus in general, which includes an imaging device as an image pickup unit (photoelectric conversion unit), such as an imaging apparatus like a digital camera or a video camera, a portable terminal device having an imaging function, and a copying machine equipped with an imaging device as an image reading unit. The imaging device may be mounted on the electronic apparatus 1000 either in a chip form, or in a module form as a package collectively including an imaging unit and a signal processing unit or an optical system.

As depicted in FIG. 62, the electronic apparatus 1000 includes an optical lens 1001, a shutter device 1002, the imaging device 1, a DSP (Digital Signal Processor) circuit 1011, a frame memory 1014, a display unit 1012, a storage unit 1015, an operation unit 1013, and a power source unit 1016. The DSP circuit 1011, the frame memory 1014, the display unit 1012, the storage unit 1015, the operation unit 1013, and the power source unit 1016 are connected to one another via a bus line 1017.

The optical lens 1001 forms an image of incident light coming from a subject on an imaging surface of the imaging device 1. The shutter device 1002 controls irradiation or shielding of the incident light to and from the imaging device 1.

The imaging device 1 converts light quantities of the incident light formed on the imaging surface by the optical lens 1001 into electric signals for each pixel, and outputs the electric signals as pixel signals.

The DSP circuit 1011 is a signal processing circuit which performs ordinary camera signal processing for the pixel signals output from the imaging device 1. For example, the DSP circuit 1011 may perform white balance processing, demosaic processing, gamma correction processing, or the like.

The frame memory 1014 is a storage unit for temporary data. The frame memory 1014 is used for data storage as appropriate in a process of signal processing performed by the DSP circuit 1011.

For example, the display unit 1012 includes a panel-type display device such as a liquid crystal panel and an organic EL (Electro Luminescence) panel. The display unit 1012 is capable of displaying moving images or still images captured by the imaging device 1.

The storage unit 1015 includes a storage medium such as a hard disk drive, an optical disk, and a semiconductor memory, and records the moving images or the still images captured by the imaging device 1 in this storage medium.

The operation unit 1013 outputs operation commands associated with various functions of the electronic apparatus 1000 on the basis of operation by a user.

The power source unit 1016 provides operation power sources for the DSP circuit 1011, the frame memory 1014, the display unit 1012, the storage unit 1015, and the operation unit 1013. The power source unit 1016 is capable of supplying power to these components as appropriate.

### <10. Application examples>

The technology according to the present disclosure (present technology) is applicable to various products. For example, the technology according to the present disclosure may be implemented as a device mounted on a mobile body of any type, such as a car, an electric car, a hybrid electric car, a motorcycle, a bicycle, a personal mobility, an airplane, a drone, a vessel, and a robot.

FIG. 63 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 63, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 63, an audio speaker 12061, a display section 12062, and an instrument panel 12063 are illustrated as the output device. The display section 12062 may, for example, include at least one of an on-board display and a head-up display.

FIG. 64 is a diagram depicting an example of the installation position of the imaging section 12031.

In FIG. 64, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 64 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

One example of the vehicle control system to which the technology according to the present disclosure is applicable has been described above. The technology according to the present disclosure is applicable to the imaging section 12031 in the configuration described above. A higher-sensitivity captured image is acquirable by applying the technology of the present disclosure to the imaging section 12031. Accordingly, recognition of an obstacle or a pedestrian on the basis of a captured image is achievable with higher sensitivity, for example. Moreover, a higher-sensitivity captured image is presentable by applying the technology of the present disclosure to the imaging section 12031, for example. Accordingly, a driver is allowed to achieve observation around the driver with higher sensitivity.

Preferred embodiments of the present disclosure have been described above in detail with reference to the accompanying drawings. However, the technical scope of the present disclosure is not limited to these examples. It is apparent that various modification examples or correction examples within the range of technical ideas included in the claims can occur to those who have ordinary knowledge in the technical field of the present disclosure. It is understood that these modifications and corrections also obviously belong to the technical scope of the present disclosure.

Moreover, offerable advantageous effects are not limited to the advantageous effects presented in the present description only for purposes of explanation or exemplification. In other words, the technology according to the present disclosure may offer other advantageous effects obvious for those skilled in the art in the light of the explanation of the present description in addition to or in place of the advantageous effects described above.

It is to be noted that the following configurations also belong to the technical scope of the present disclosure.
(1) An imaging device including:
   multiple pixels each including a photoelectric conversion unit and planarly arranged in a matrix shape;
   a color filter provided on the photoelectric conversion unit for each of the pixels; and
   a wall-shaped structure portion that is formed between the adjoining color filters with an external shape of the wall-shaped structure portion defined by a first wall portion and is configured to separate the color filters from each other.
(2) The imaging device according to (1) above, in which the first wall portion defines the external shape of the wall-shaped structure portion by surrounding a side plane and an upper plane of a space between the color filters.
(3) The imaging device according to (2) above, in which the first wall portion on the upper plane has a larger thickness than the first wall portion on the side plane.
(4) The imaging device according to (2) or (3) above, in which the space surrounded by the first wall portion is a void.
(5) The imaging device according to (4) above, in which at least one opening is formed in the first wall portion on the upper plane.
(6) The imaging device according to (5) above, in which
   the wall-shaped structure portion is formed in a grid shape between the pixels, and
   the opening is formed in some or all of intersections of a grid of the wall-shaped structure portion.
(7) The imaging device according to (6) above, in which the opening is closed by a closing film provided on the wall-shaped structure portion.
(8) The imaging device according to (7) above, in which the wall-shaped structure portion further includes a second wall portion provided inside the first wall portion.
(9) The imaging device according to (8) above, in which the second wall portion includes an insulating material identical to an insulating material of the closing film.
(10) The imaging device according to any one of (7) to (9) above, in which an on-chip lens is further provided, on the closing film, for each of the pixels.
(11) The imaging device according to (10) above, in which the closing film has a refractive index substantially equal to or lower than a refractive index of the on-chip lens.
(12) The imaging device according to any one of (4) to (11) above, in which a light shielding portion is further provided in a lower part of the void.
(13) The imaging device according to (12) above, in which the light shielding portion has a smaller width than that of the lower part of the void.
(14) The imaging device according to any one of (1) to (13) above, in which the color filters are provided such that an identical color is designated for each set of the adjoining 2 × 2 pixels, 3 × 3 pixels, or 4 × 4 pixels.
(15) The imaging device according to (4) above, in which the first wall portion includes Si, SiO₂, SiN, SiC, SiCO, SiON, SiCN, SiH, SiOH, SiNH, SiCH, SiCOH, SiONH, or SiCNH.
(16) The imaging device according to (15) above, in which no opening is formed in the first wall portion.
(17) The imaging device according to (15) above, in which a protection film including an insulating material is further provided on the first wall portion.
(18) The imaging device according to (17) above, in which the protection film is formed along a shape of the first wall portion.
(19) The imaging device according to (1) above, in which the first wall portion is opened to an upper plane of a space between the color filters and defines the external shape of the wall-shaped structure portion by surrounding a side plane of the space between the color filters.
(20) The imaging device according to (19) above, in which the opened upper plane is closed by a closing film provided on the wall-shaped structure portion.
(21) The imaging device according to (20) above, in which the wall-shaped structure portion further includes a second wall portion including an insulating material identical to an insulating material of the closing film and provided inside the first wall portion.
(22) The imaging device according to any one of (19) to (21) above, in which the first wall portion has a larger height than the color filters.
(23) The imaging device according to any one of (19) to (21) above, in which the first wall portion has a smaller height than the color filters.
(24) The imaging device according to any one of (19) to (23) above, in which the first wall portion includes an insulating material identical to an insulating material of a flattening film provided below the color filters.
(25) The imaging device according to any one of (19) to (23) above, in which the first wall portion includes an insulating material different from an insulating material of a flattening film provided below the color filters.
(26) The imaging device according to (1) above, in which the first wall portion is a closing film that closes a space between the color filters.
(27) The imaging device according to (26) above, in which a void surrounded by the first wall portion is provided in the space between the color filters.
(28) The imaging device according to (26) or (27) above, in which a stopper layer including an insulating material that has an etching rate different from an etching rate of the color filters is provided below the color filters.
(29) The imaging device according to any one of (4) to (13) above, in which lower ends of the color filters are located below a lower end of the void.
(30) The imaging device according to any one of (4) to (13) above, in which a vertically central part of the void has a larger width than that of each of an upper part and a lower part of the void.
(31) The imaging device according to any one of (4) to (13) above, in which a support or a partition is provided inside the void.
(32) An electronic apparatus including:
   an imaging device, in which
   the imaging device includes
      multiple pixels each including a photoelectric conversion unit and planarly arranged in a matrix shape,
      a color filter provided on the photoelectric conversion unit for each of the pixels, and
      a wall-shaped structure portion that is formed between the adjoining color filters with an external shape of the wall-shaped structure portion defined by a first wall portion and is configured to separate the color filters from each other.

### [Reference Signs List]

1: Imaging device
12: Pixel
12B: Blue pixel
12G: Green pixel
12R: Red pixel
13: Pixel unit
110: Photoelectric conversion unit
111: Pixel separation layer
112: Pinning layer
113: Anti-reflection layer
120: Color filter
121: Flattening film
130: Wall-shaped structure portion
131: First wall portion
132: Second wall portion
133: Void
134: Temporary wall portion
135: Light shielding portion
137: Opening
140: Closing film
141: Cap layer
150: On-chip lens
161: Resist layer
162: Lower layer anti-reflection film

## Claims

1. An imaging device comprising:
multiple pixels each including a photoelectric conversion unit and planarly arranged in a matrix shape;
a color filter provided on the photoelectric conversion unit for each of the pixels; and
a wall-shaped structure portion that is formed between the adjoining color filters with an external shape of the wall-shaped structure portion defined by a first wall portion and is configured to separate the color filters from each other.

2. The imaging device according to claim 1, wherein the first wall portion defines the external shape of the wall-shaped structure portion by surrounding a side plane and an upper plane of a space between the color filters.

3. The imaging device according to claim 2, wherein the first wall portion on the upper plane has a larger thickness than the first wall portion on the side plane.

4. The imaging device according to claim 2, wherein the space surrounded by the first wall portion is a void.

5. The imaging device according to claim 4, wherein at least one opening is formed in the first wall portion on the upper plane.

6. The imaging device according to claim 5, wherein
the wall-shaped structure portion is formed in a grid shape between the pixels, and
the opening is formed in some or all of intersections of a grid of the wall-shaped structure portion.

7. The imaging device according to claim 6, wherein the opening is closed by a closing film provided on the wall-shaped structure portion.

8. The imaging device according to claim 7, wherein the wall-shaped structure portion further includes a second wall portion provided inside the first wall portion.

9. The imaging device according to claim 8, wherein the second wall portion includes an insulating material identical to an insulating material of the closing film.

10. The imaging device according to claim 7, wherein an on-chip lens is further provided, on the closing film, for each of the pixels.

11. The imaging device according to claim 10, wherein the closing film has a refractive index substantially equal to or lower than a refractive index of the on-chip lens.

12. The imaging device according to claim 4, wherein a light shielding portion is further provided in a lower part of the void.

13. The imaging device according to claim 12, wherein the light shielding portion has a smaller width than that of the lower part of the void.

14. The imaging device according to claim 1, wherein the color filters are provided such that an identical color is designated for each set of the adjoining 2 × 2 pixels, 3 × 3 pixels, or 4 × 4 pixels.

15. The imaging device according to claim 4, wherein the first wall portion includes Si, SiO₂, SiN, SiC, SiCO, SiON, SiCN, SiH, SiOH, SiNH, SiCH, SiCOH, SiONH, or SiCNH.

16. The imaging device according to claim 15, wherein no opening is formed in the first wall portion.

17. The imaging device according to claim 15, wherein a protection film including an insulating material is further provided on the first wall portion.

18. The imaging device according to claim 17, wherein the protection film is formed along a shape of the first wall portion.

19. The imaging device according to claim 1, wherein the first wall portion is opened to an upper plane of a space between the color filters and defines the external shape of the wall-shaped structure portion by surrounding a side plane of the space between the color filters.

20. The imaging device according to claim 19, wherein the opened upper plane is closed by a closing film provided on the wall-shaped structure portion.

21. The imaging device according to claim 20, wherein the wall-shaped structure portion further includes a second wall portion including an insulating material identical to an insulating material of the closing film and provided inside the first wall portion.

22. The imaging device according to claim 19, wherein the first wall portion has a larger height than the color filters.

23. The imaging device according to claim 19, wherein the first wall portion has a smaller height than the color filters.

24. The imaging device according to claim 19, wherein the first wall portion includes an insulating material identical to an insulating material of a flattening film provided below the color filters.

25. The imaging device according to claim 19, wherein the first wall portion includes an insulating material different from an insulating material of a flattening film provided below the color filters.

26. The imaging device according to claim 1, wherein the first wall portion is a closing film that closes a space between the color filters.

27. The imaging device according to claim 26, wherein a void surrounded by the first wall portion is provided in the space between the color filters.

28. The imaging device according to claim 26, wherein a stopper layer including an insulating material that has an etching rate different from an etching rate of the color filters is provided below the color filters.

29. The imaging device according to claim 4, wherein lower ends of the color filters are located below a lower end of the void.

30. The imaging device according to claim 4, wherein a vertically central part of the void has a larger width than that of each of an upper part and a lower part of the void.

31. The imaging device according to claim 4, wherein a support or a partition is provided inside the void.

32. An electronic apparatus comprising:
an imaging device, wherein
the imaging device includes
multiple pixels each including a photoelectric conversion unit and planarly arranged in a matrix shape,
a color filter provided on the photoelectric conversion unit for each of the pixels, and
a wall-shaped structure portion that is formed between the adjoining color filters with an external shape of the wall-shaped structure portion defined by a first wall portion and is configured to separate the color filters from each other.
